# EUROPEAN PATENT APPLICATION

(11) **EP 4 748 845 A1**
(43) Date of publication of application: **27.05.2026**
(21) Application number: 26166057.5
(22) Date of filing: 23.03.2021
(51) Int. Cl.: C07F 5/02, C09K 11/06, H10K 50/12, C07F 5/06, H10K 85/60, C07B 59/00, C07F 7/08, C07F 9/6584

(54) **POLYCYCLIC AROMATIC COMPOUND AND ORGANOELECTROLUMINESCENT DEVICE USING SAME**

(30) Priority: 23.03.2020 KR 20200035198
(62) Divisional of application: 21776365.5
(71) Applicant: SFC Co., Ltd., Cheongju-si, Chungcheongbuk-do 28122 (KR)
(72) Inventor: SHIN, Bong-ki, 28122 Cheongju-si, Chungcheongbuk-do (KR); JOO, Sung-hoon, 28122 Cheongju-si, Chungcheongbuk-do (KR); YANG, Byung-sun, 28122 Cheongju-si, Chungcheongbuk-do (KR); KIM, Ji-hwan, 28122 Cheongju-si, Chungcheongbuk-do (KR); JO, Hyeon-jun, 28122 Cheongju-si, Chungcheongbuk-do (KR); CHOI, Sung-eun, 28122 Cheongju-si, Chungcheongbuk-do (KR)
(74) Representative: Grosse, Felix Christopher

(57) **Abstract**

A polycyclic aromatic compound or a condensed multimer thereof, according to the present invention, is employed in an organic layer in an organoelectroluminescent device, thereby enabling the implementation of an organoelectroluminescent device having high efficiency and a long lifespan, and thus the present invention may be industrially useful in various display devices such as a flat panel display device, a flexible display device, a monochromatic or white flat panel lighting device, and a monochromatic or white flexible lighting device.

## Description

### Technical Field

The present invention relates to a polycyclic aromatic derivative compound or a fused multimer thereof, and a highly efficient and long-lasting organic light-emitting device that exhibits remarkably improved luminous efficacy using the same.

### Background Art

An organic light-emitting device is a self-luminous device that emits light when energy is released from excitons which are formed by recombination of electrons injected from an electron injection electrode (cathode) and holes injected from a hole injection electrode (anode) in a light-emitting layer. Such an organic light-emitting device attracts a great deal of attention as a next-generation light source due to applicability to full-color flat panel light-emitting displays based on advantages such as low driving voltage, high luminance, wide viewing angle, and rapid response speed thereof.

In order for the organic light-emitting device to exhibit the characteristics, the structure of the organic layer in the organic light-emitting device should be optimized, and the material constituting each organic layer, namely, a hole injection material, a hole transport material, a light-emitting material, an electron transport material, an electron injection material, or an electron blocking material should be based on stable and efficient ingredients. However, there is a continuing need to develop organic layer structures and respective materials thereof for stable and efficient organic light-emitting devices.

As such, there is a continuing need for the development of the structure of an organic light-emitting device capable of improving the luminous characteristics thereof and the development of novel materials supporting the structure.

### Technical Problem

Therefore, the present invention has been made in view of the above problems, and it is one object of the present invention to provide a polycyclic aromatic derivative compound or a fused multimer thereof that can be used in an organic layer of a device to realize a highly efficient organic light-emitting device and an organic light-emitting device including the same.

### Technical Solution

In accordance with the present invention, the above and other objects can be accomplished by the provision of a compound having a polycyclic aromatic derivative compound represented by the following [Formula A-1] or [Formula A-2] or a fused multimer thereof.

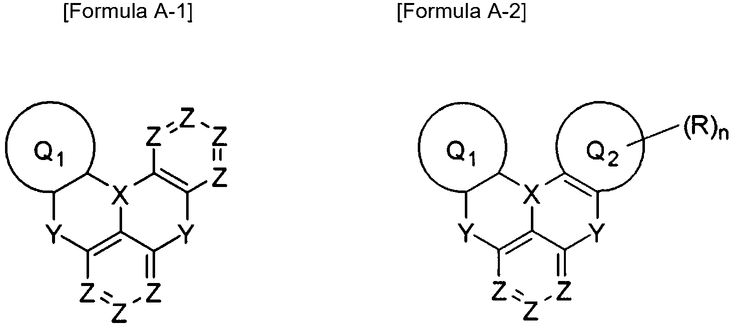

The structures of polycyclic aromatic derivative compounds represented by [Formula A-1] to [Formula A-2] and fused multimers thereof, the definitions of substituents, and the specific polycyclic aromatic derivative compounds and the fused multimers thereof according to the present invention implemented thereby will be given later.

In accordance with another aspect of the present invention, provided is an organic light-emitting device including a first electrode, a second electrode facing the first electrode, and an organic layer interposed between the first electrode and the second electrode, wherein the organic layer includes at least one of the polycyclic aromatic derivative compound or fused multimer thereof.

### Advantageous Effects

The polycyclic aromatic compound or fused multimer thereof according to the present invention can be used for an organic layer in a device to realize a highly efficient and long-lasting organic light-emitting device.

Hereinafter, the present invention will be described in detail with reference to the annexed drawings.

The present invention is directed to a polycyclic aromatic derivative compound or fused multimer thereof that is included in an organic light-emitting device and is represented by the following [Formula A-1] or [Formula A-2] and is capable of realizing a highly efficient organic light-emitting device with greatly improved lifespan, 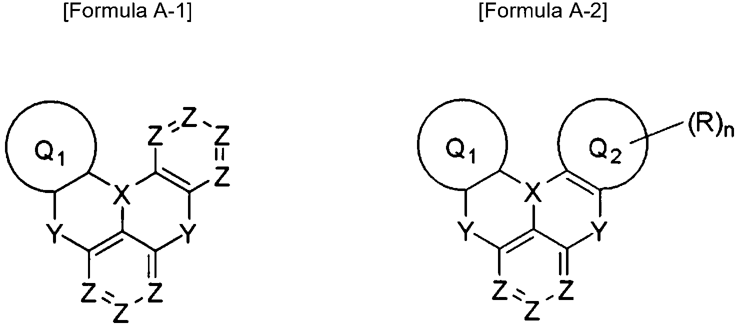 wherein
X is B, P, P=O, P=S or Al, in a preferred embodiment of the present invention, X is B, and a highly efficient and long lasting organic light-emitting device can be realized based on the structure of the polycyclic aromatic derivative compound containing boron (B),
Y is selected from N-R₁, CR₂R₃, O, S, Se, and SiR₄R₅, with the proviso that Y's are identical to or different from each other,
Z is CR₆ or N, with the proviso that Z's and R₆'s are identical to or different from each other,
R and R₁ to R₆ are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring,
R and R₁ to R₆ may be bonded to each other or may be each linked to an adjacent substituent to form an alicyclic or aromatic monocyclic or polycyclic ring, and the carbon atom of the formed alicyclic or aromatic monocyclic or polycyclic ring may be substituted with at least one heteroatom selected from N, S and O, and
Q₁ and Q₂ are identical to or different from each other, and are each independently a substituted or unsubstituted C6-C50 aromatic hydrocarbon ring or a substituted or unsubstituted C2-C50 aromatic heterocyclic group.

In an embodiment of the present invention, Q₁ may be represented by the following [Structural formula 1]: 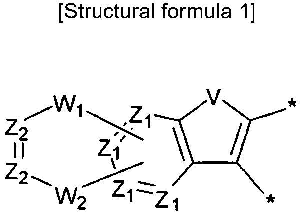
V is selected from NR₁, CR₂R₃, O, S, Se, and SiR₄R₅,
W₁ and W₂ are identical to or different from each other and are each independently selected from a single bond, NR₁, CR₂R₃, O, S, and SiR₄R₅, with the exception that both W₁ and W₂ are single bonds,
R₁ to R₅ are defined in [Formula A-1] or [Formula A-2] above,
two adjacent ones selected from a plurality of Z₁'s are respectively linked to W₁ and W₂, the others are N or CR₇, and Z₁'s are identical to or different from each other and R₇'s are identical to or different from each other,
R₇'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring,
Z₂ is each independently N or CR₈, with the proviso that Z₂'s and R₈'s are identical to or different from each other,
R₈'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring.

In addition, R₈'s may be bonded to each other or each thereof may be linked to an adjacent substituent to form an alicyclic or aromatic monocyclic or polycyclic ring, and the carbon atom of the formed alicyclic or aromatic monocyclic or polycyclic ring may be substituted with at least one heteroatom selected from N, S and O.

Based on such definition, [Structural Formula 1] may have various structures, and in a specific embodiment, for example, Z₂'s may be linked to each other to form the following structure, which can be clearly identified from specific compounds described later.

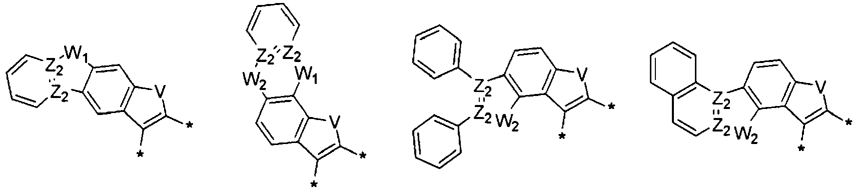

According to an embodiment of the present invention, Q₂ may be represented by any one of the following [Structural Formula 1] to [Structural Formula 5]. 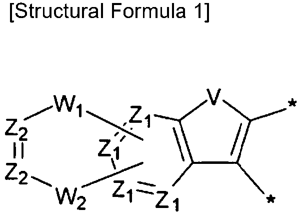 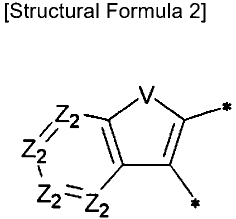 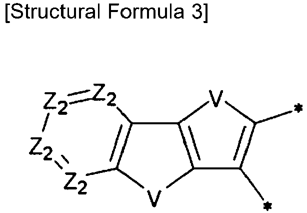 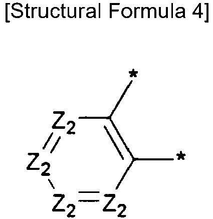 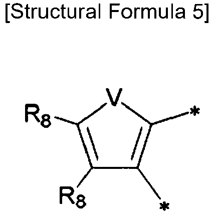 wherein
V is selected from NR₁, CR₂R₃, O, S, Se, and SiR₄R₅, with the proviso that V's in [Structural Formula 3] are identical to or different from each other,
W₁ and W₂ are identical to or different from each other, and are each independently a single bond, or are selected from NR₁, CR₂R₃, O, S, and SiR₄R₅, with the exception that both W₁ and W₂ are single bonds,
R₁ to R₅ are defined in [Formula A-1] or [Formula A-2],
two adjacent ones selected from Z₁'s are respectively linked to W₁ and W₂, the others are N or CR₇, and Z₁'s and R₇'s are identical to or different from each other,
R₇'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring,
Z₂'s are each independently N or CR₈, with the proviso that Z₂'s and R₈'s are identical to or different from each other,
R₈'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, a substituted or unsubstituted C3-C30 mixed aliphatic- aromatic ring,
R₈'s may be bonded to each other or each thereof may be linked to an adjacent substituent to form an alicyclic or aromatic monocyclic or polycyclic ring, and the carbon atom of the formed alicyclic, aromatic monocyclic or polycyclic ring may be substituted with at least one heteroatom selected from N, S and O, and
'*' in [Structural Formula 1] to [Structural Formula 5] means a site of each structural formula bonded to Q₁ and Q₂ of [Formula A-1] or [Formula A-2].

The fused multimer according to the present invention is a dimer or trimer having two or three structures represented by [Formula A-1] or [Formula A-2], and in one embodiment of the present invention, the fused multimer may be a dimer.

In the present invention, the multimer may be any form having a plurality of unit structures of [Formula A-1] or [Formula A-2], for example, the unit structures of [Formula A-1] or [Formula A-2] are bonded to each other through a linker such as a single bond, an alkylene group, a phenylene group, or a naphthylene group, the unit structures are bonded to each other while sharing any ring included in the structure of [Formula A-1] or [Formula A-2], or the unit structures are bonded to each other while benzene rings including Q₁, Q₂, and Z included in the unit structures are fused to each other.

The structure of the fused multimer according to the present invention can be clearly identified from specific compounds (Compounds 257 to 264) described later.

As such, [Formula A-1] or [Formula A-2] according to the present invention can form various polycyclic skeleton structures based on the definitions of respective substituents and highly efficient and long-lasting organic light-emitting devices can be realized by satisfying the various requirements for organic layers of organic light-emitting devices using various polycyclic aromatic skeleton structures formed based thereon.

Meanwhile, as used herein, the term "substituted" indicates substitution of various substituents defined above with one or more substituents selected from deuterium, a cyano group, a halogen group, a hydroxyl group, a nitro group, an alkyl group, a halogenated alkyl group, a cycloalkyl group, an alkenyl group, an alkynyl group, a heteroalkyl group, an aryl group, an arylalkyl group, an alkylaryl group, a heteroaryl group, a heteroarylalkyl group, an alkoxy group, an amine group, a silyl group, an aryloxy group and a mixed aliphatic-aromatic ring group, or substitution with a substituent including two or more of the substituents linked to each other. The term "unsubstituted" in the same definition indicates having no substituent.

In addition, the range of the number of the carbon atoms of the alkyl group or aryl group in the term "substituted or unsubstituted C1-C30 alkyl group", "substituted or unsubstituted C6-C50 aryl group" or the like refers to the total number of carbon atoms constituting the alkyl or aryl moiety when the corresponding group is not substituted without considering the number of carbon atoms in the substituent(s). For example, a phenyl group substituted at the para position with a butyl group corresponds to an aryl group having 6 carbon atoms substituted with a butyl group having 4 carbon atoms.

In addition, as used herein, the expression "a substituent is bonded to an adjacent substituent to form a ring" means that the corresponding substituent is bonded to the adjacent substituent to form a substituted or unsubstituted alicyclic or aromatic ring, and the term "adjacent substituent" may mean a substituent substituted for an atom which is directly attached to an atom substituted with the corresponding substituent, a substituent sterically disposed at the nearest position to the corresponding substituent, or another substituent substituted for an atom which is substituted with the corresponding substituent. For example, two substituents substituted at the ortho position in a benzene ring and two substituents substituted at the same carbon in the aliphatic ring may be considered "adjacent" to each other.

As used herein, the alkyl group may be a linear or branched alkyl group. Examples of the alkyl group include, but are not limited to, a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethylbutyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like.

As used herein, the alkenyl group may include a linear or branched alkenyl group and may be further substituted with another substituent. Specifically, examples of the alkenyl group include, but are not limited to, a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like.

As used herein, the alkynyl group may also include a linear or branched alkynyl group, and may be further substituted with another substituent, and examples of the substituent may include, but are not limited to, ethynyl, 2-propynyl, and the like.

In the present invention, the cycloalkyl group is not particularly limited and specific examples thereof include, but are not limited to, cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl group, 3,4,5-trimethylcyclohexyl, 4-tert-butylcyclohexyl, cycloheptyl, cyclooctyl, spirodecyl, spiroundecyl and adamantyl groups and the like, the cycloalkyl group may be further substituted with another substituent, the polycyclic group means a cycloalkyl group directly bonded to or fused with another cyclic group, and the other cyclic group may be a cycloalkyl group or other types of cyclic group such as heterocycloalkyl, aryl, or heteroaryl groups.

As used herein, the term "heterocycloalkyl group" refers to an aromatic and non-aromatic cyclic radical containing one or more heteroatoms, wherein one or more heteroatoms are selected from O, S, N, P, B, Si, and Se, preferably selected from O, N and S. Specifically, the heterocycloalkyl group containing N may be aziridine, pyrrolidine, piperidine, azepane, azocane, or the like, which also includes a monocyclic or polycyclic group and may be further substituted with another substituent. The polycyclic group means a heterocycloalkyl group directly bonded to or fused with another cyclic group and the other cyclic group may be a heterocycloalkyl group or other types of cyclic group such as cycloalkyl, aryl, or heteroaryl groups.

As used herein, the term "cycloalkenyl group" refers to a cyclic unsaturated hydrocarbon group that has at least one carbon double bond and is not an aromatic ring, and examples thereof include, but are not limited to, cyclopropenyl, cyclobutenyl, cyclopentenyl, cyclohexenyl, cycloheptenyl, 1,3-cyclohexadienyl, 1,4-cyclohexadienyl, 2,4-cycloheptadienyl, and 1,5-cyclooctadienyl groups and the like.

As used herein, the aromatic hydrocarbon ring or the aryl group may be monocyclic or polycyclic, examples of the monocyclic aryl group include a phenyl group, a biphenyl group, a terphenyl group, a stilbene group, and the like, and examples of the polycyclic aryl group include, but are not limited to, a naphthyl group, an anthracenyl group, a phenanthrenyl group, a pyrenyl group, a perylenyl group, a tetracenyl group, a chrysenyl group, a fluorenyl group, an acenaphthcenyl group, a triphenylene group, a fluoranthene group, and the like, but the scope of the present invention is not limited thereto.

As used herein, the aromatic heterocyclic or heteroaryl group is an aromatic ring containing at least one heteroatom and examples thereof include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups and the like.

As used herein, the aliphatic hydrocarbon ring refers to a non-aromatic ring that contains only carbon and hydrogen atoms, for example, includes a monocyclic or polycyclic ring, and may be further substituted with another substituent. The term "polycyclic" means that the polycyclic group may be directly attached to or fused with at least one other cyclic group, the other cyclic group may be an aliphatic hydrocarbon ring, or a different type of ring group, for example, an aliphatic heterocyclic group, an aryl group, a heteroaryl group, and the like. Specifically, examples thereof include, but are not limited to, cycloalkyls such as a cyclopropyl group, a cyclobutyl group, a cyclopentyl group, an adamantyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, and a cyclooctyl group, cycloalkanes such as cyclohexane and cyclopentane, and cycloalkenes such as cyclohexene and cyclobutene.

As used herein, the aliphatic heterocyclic ring refers to an aliphatic ring that contains at least one of heteroatoms such as O, S, Se, N and Si, also includes a monocyclic or polycyclic ring, and may be further substituted with another substituent. The term "polycyclic" means that the polycyclic group may be directly attached to or fused with at least one other cyclic group, and the other cyclic group may be an aliphatic hydrocarbon ring, or a different type of ring group, for example, an aliphatic heterocyclic group, an aryl group, a heteroaryl group, or the like.

As used herein, the mixed aliphatic-aromatic ring group refers to a ring in which two or more rings are attached to and fused with each other, and aliphatic and aromatic rings are fused together to be overall non-aromatic, and a polycyclic mixed aliphatic-aromatic ring may contain a heteroatom selected from N, O, P and S, in addition to C.

As used herein, specifically, the alkoxy group may be methoxy, ethoxy, propoxy, isobutyloxy, sec-butyloxy, pentyloxy, iso-amyloxy, hexyloxy, or the like, but is not limited thereto.

As used herein, the term "silyl group" refers to an unsubstituted silyl group (-SiH₃) or a substituted silyl group (-SiH₂R, -SiHR₂, -SiR₃), wherein R is an alkyl group, an aryl group, a heteroaryl group, or the like and thus the substituted silyl group may be an alkylsilyl group, an arylsilyl group, a heteroarylsilyl group, an arylheteroarylsilyl group, or the like, the alkylsilyl group means a silyl group substituted with alkyl, and the aryl (heteroaryl)silyl group means a silyl group substituted with an aryl and/or heteroaryl group. Examples of the arylsilyl group include a substituted or unsubstituted monoarylsilyl group, a substituted or unsubstituted diarylsilyl group, and a substituted or unsubstituted triarylsilyl group, and the aryl group and the heteroaryl group in the arylsilyl group, the heteroarylsilyl group and the arylheteroarylsilyl group may be a monocyclic aryl group or a monocyclic heteroaryl group, and may be a polycyclic aryl group or a polycyclic heteroaryl group, and the arylsilyl group, the heteroarylsilyl group and the arylheteroarylsilyl group including two or more aryl groups and heteroaryl groups include both a monocyclic aryl group (heteroaryl group), a polycyclic aryl group (heteroaryl group), or a monocyclic aryl group (heteroaryl group), and a polycyclic aryl group (heteroaryl group). In addition, the aryl group and the heteroaryl group in the arylsilyl group, the heteroarylsilyl group and the arylheteroarylsilyl group may be selected from the examples of the aryl group and heteroaryl group described above. Specific examples of the silyl group include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl, and the like.

As used herein, the silyl group is represented by -SiH₃, and may be an alkylsilyl group, an arylsilyl group, an alkylarylsilyl group, an arylheteroarylsilyl group, or the like, and specific examples of the silyl group include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl, and the like.

As used herein, the amine group is represented by -NH₂, or may be an alkylamine group, an arylamine group, an arylheteroarylamine group, or the like. The arylamine group refers to amine substituted with aryl, the alkylamine group refers to amine substituted with alkyl, and the arylheteroarylamine group refers to an amine substituted with aryl and heteroaryl. For example, the arylamine group includes a substituted or unsubstituted monoarylamine group, a substituted or unsubstituted diarylamine group, or a substituted or unsubstituted triarylamine group. The aryl group and the heteroaryl group in the arylamine group and the arylheteroarylamine group may be a monocyclic aryl group or a monocyclic heteroaryl group, or a polycyclic aryl group or a polycyclic heteroaryl group. The arylamine group and the arylheteroarylamine group that contain two or more aryl groups and two or more heteroaryl groups, respectively, include a monocyclic aryl group (heteroaryl group), a polycyclic aryl group (heteroaryl group), or both of the monocyclic aryl group (heteroaryl group) and the polycyclic aryl group (heteroaryl group). In addition, the aryl group and the heteroaryl group in the arylamine group and the arylheteroarylamine group may be selected from examples of aryl groups and heteroaryl groups described above.

As used herein, examples of the aryl group in the aryloxy group and the arylthioxy group are identical to examples of the aryl group described above and specifically, examples of the aryloxy group include a phenoxy group, a p-tolyloxy group, an m-tolyloxy group, a 3,5-dimethylphenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group, and the like, and examples of the arylthioxy group include, but are not limited to, a phenylthioxy group, a 2-methylphenylthioxy group, a 4-tert-butylphenylthioxy group, and the like.

In the present invention, examples of the halogen group include fluorine, chlorine, bromine, and iodine.

More specifically, the polycyclic aromatic derivative compound and fused multimer thereof represented by [Formula A-1] or [Formula A-2] according to the present invention are selected from compounds represented by the following [Compound 1] to [Compound 477], which clearly show specific substituents, but these compounds should not be construed as limiting the scope of [Formula A-1] to [Formula A-2] and the fused multimer according to the present invention.

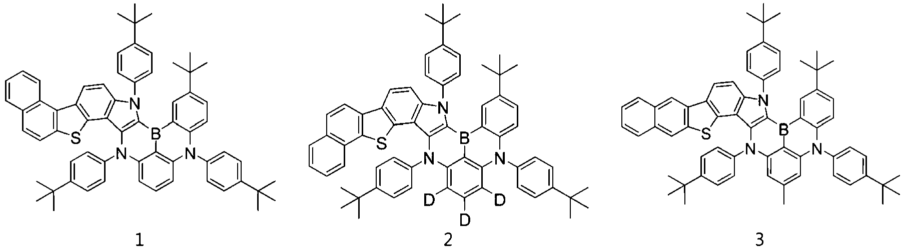

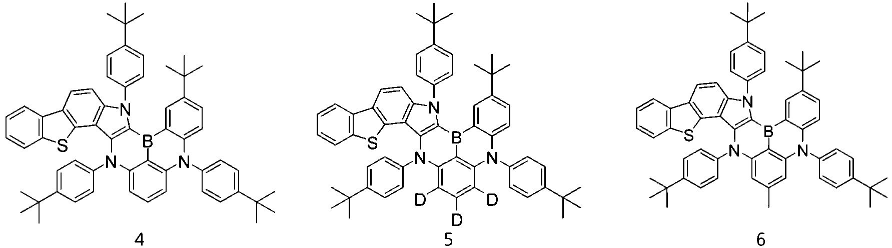

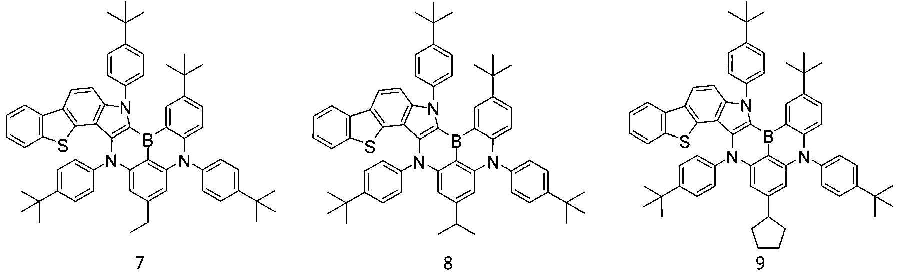

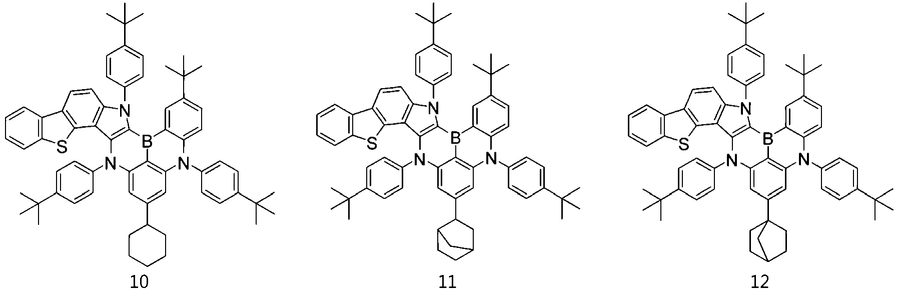

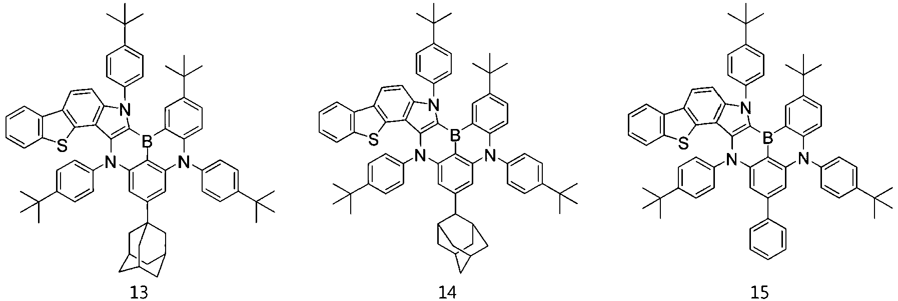

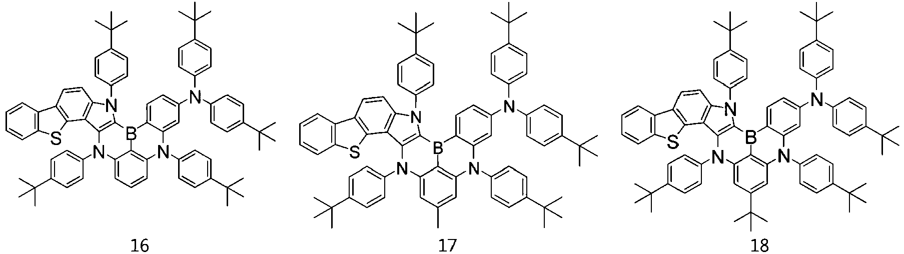

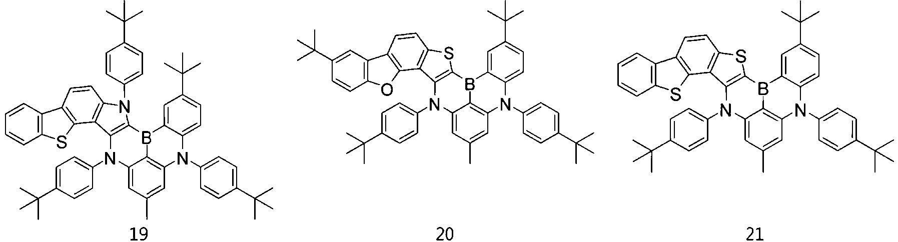

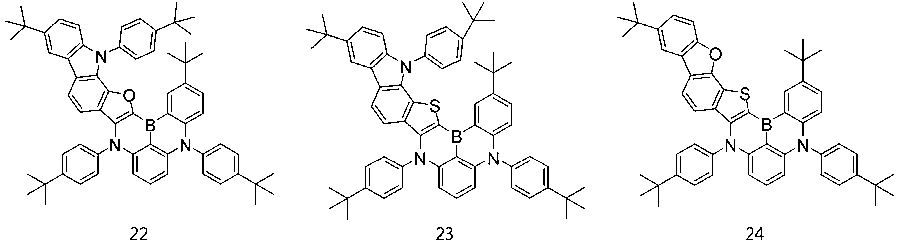

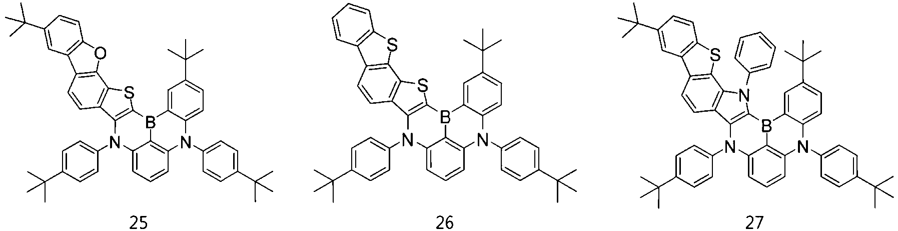

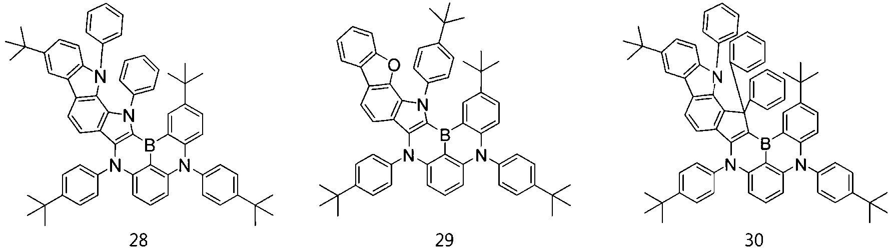

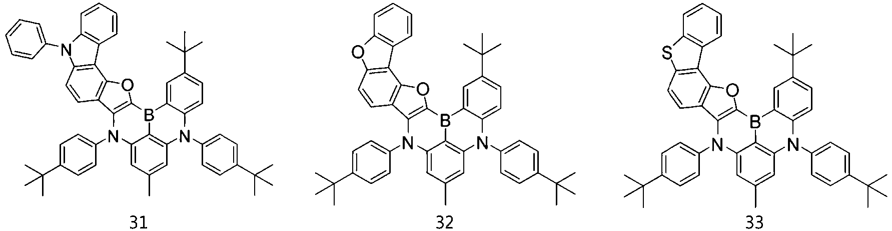

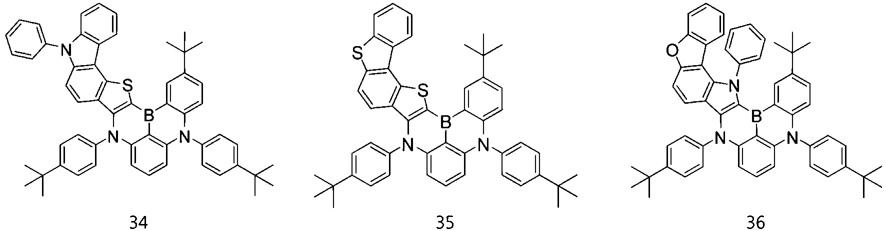

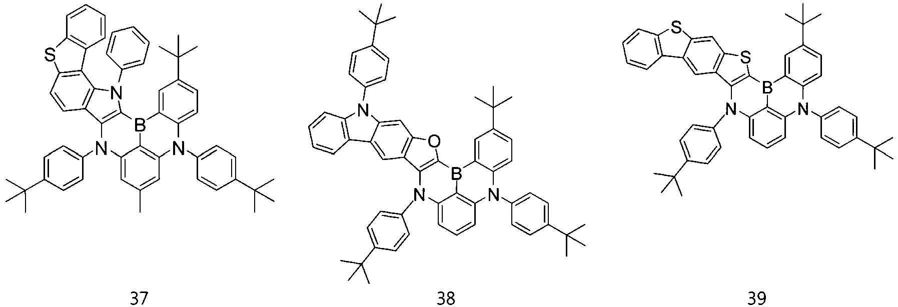

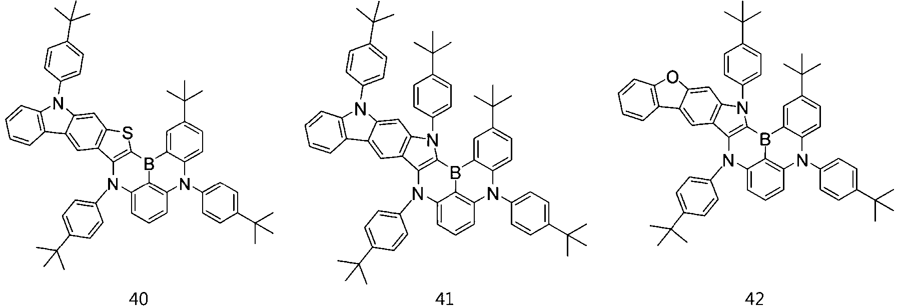

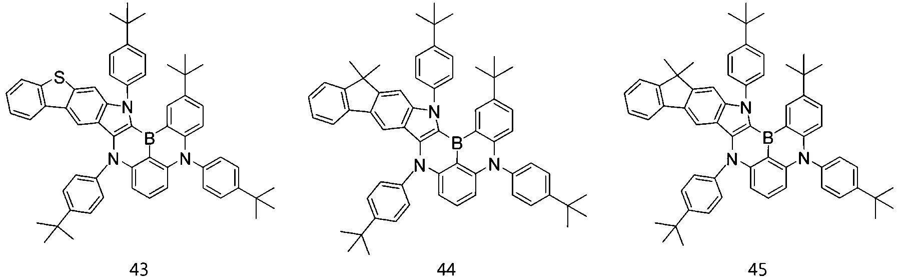

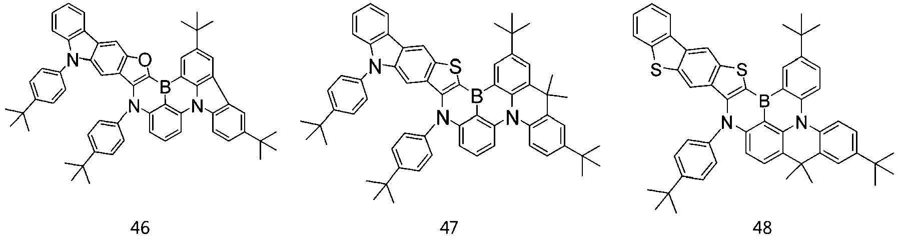

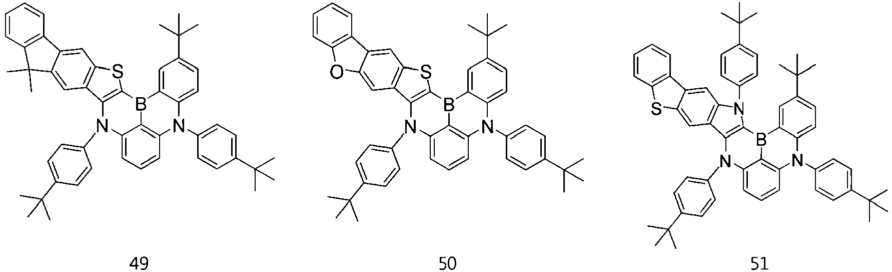

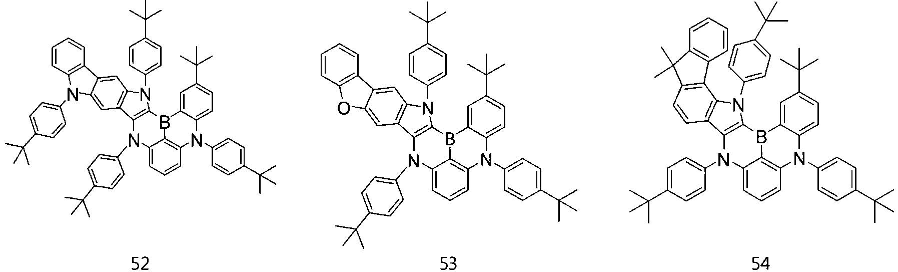

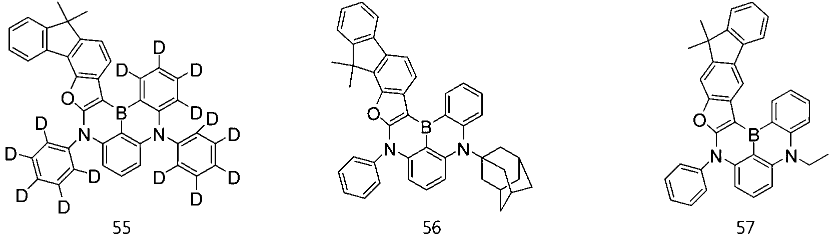

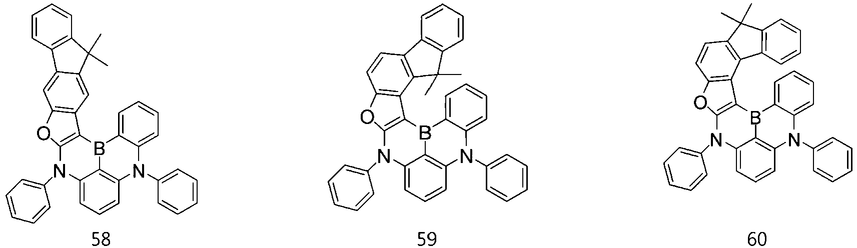

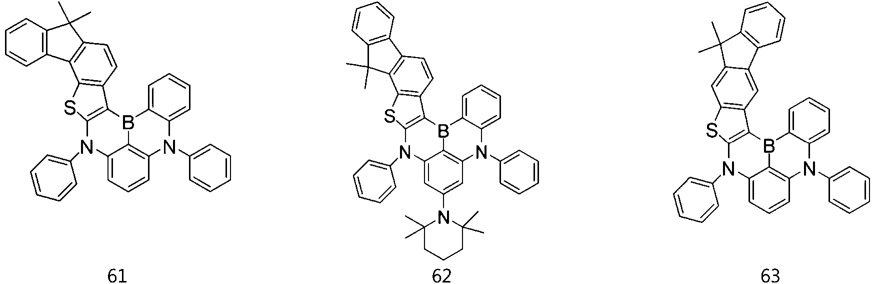

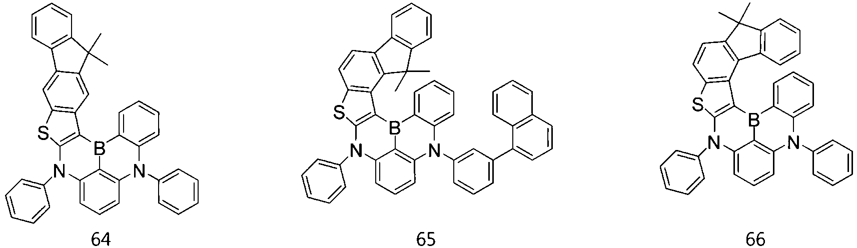

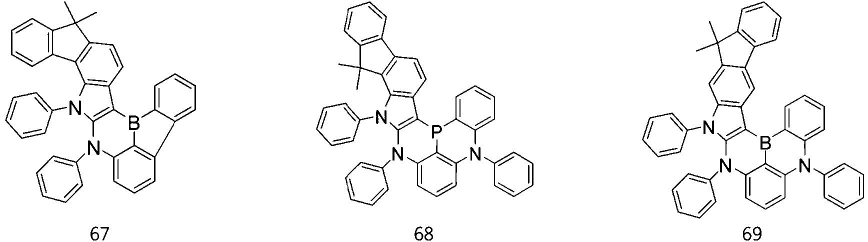

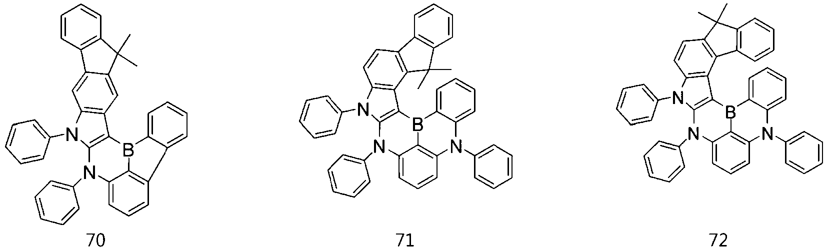

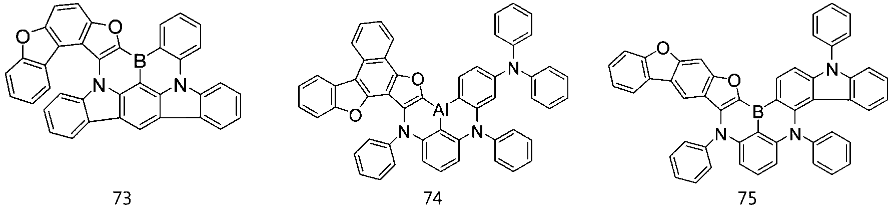

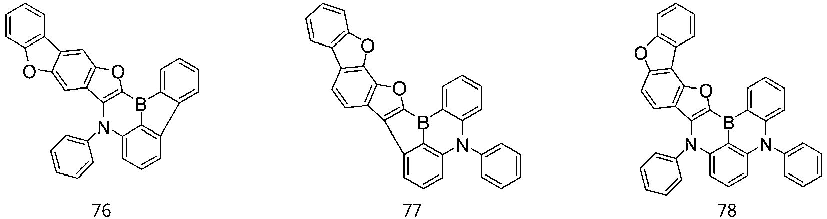

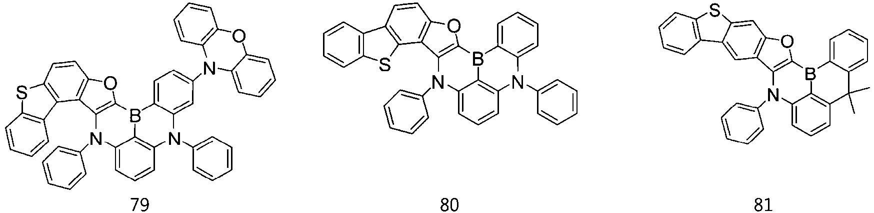

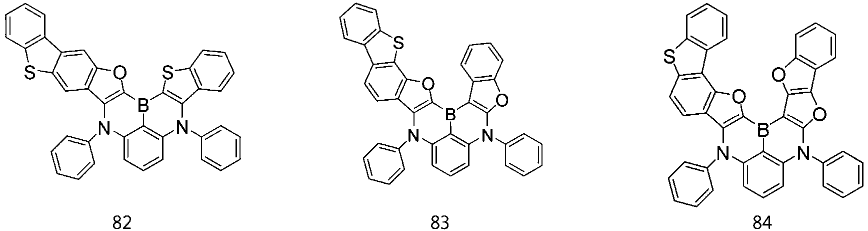

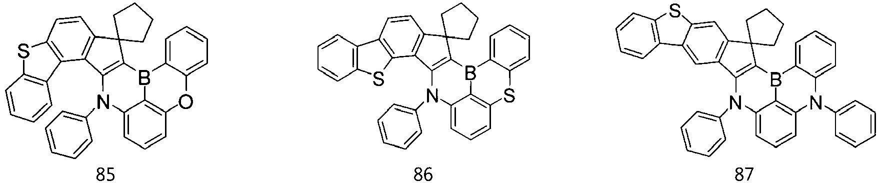

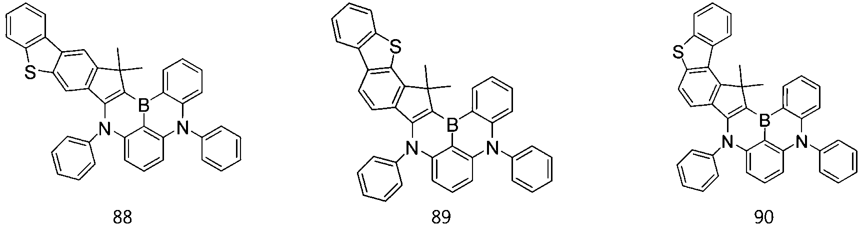

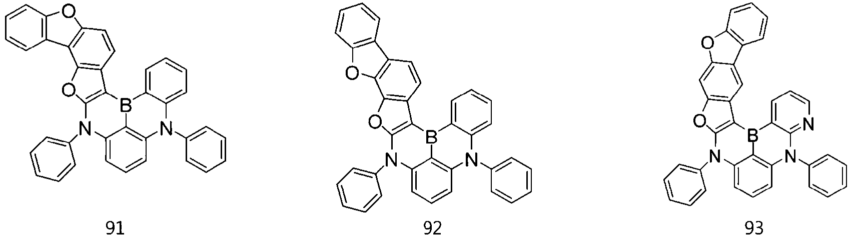

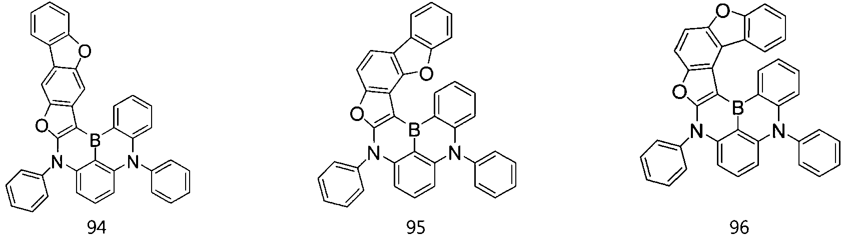

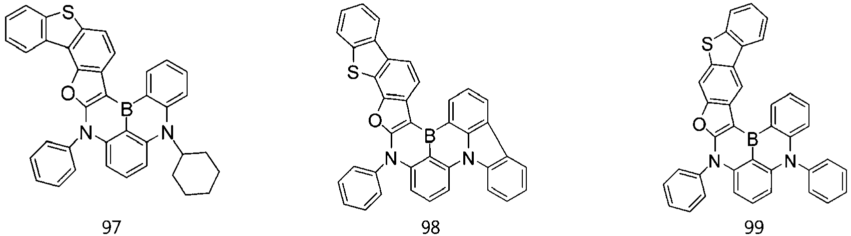

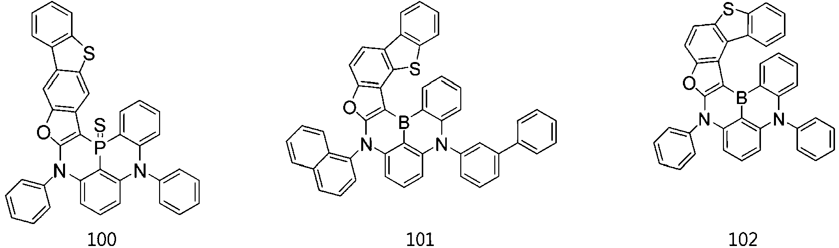

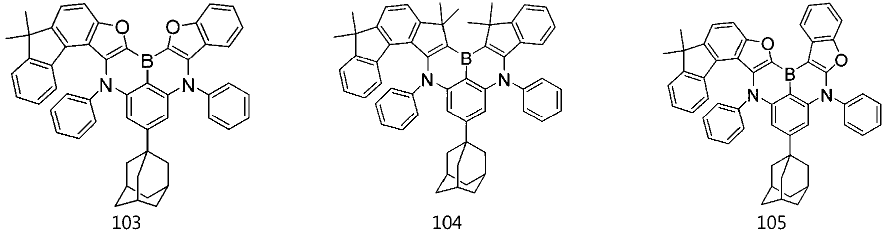

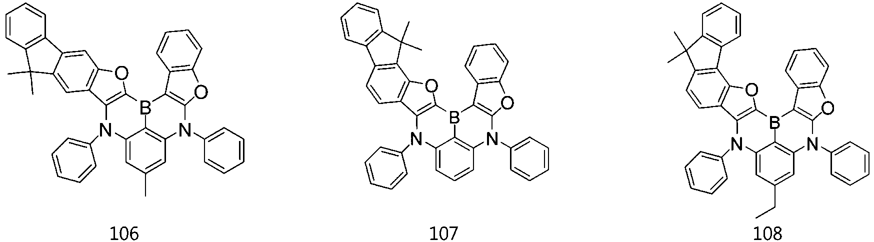

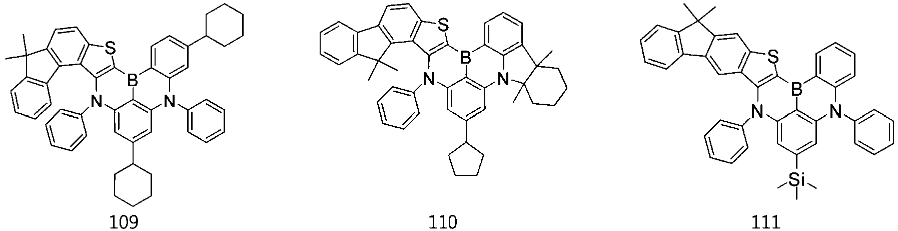

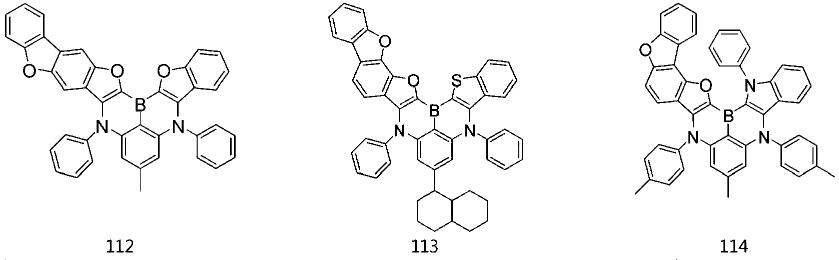

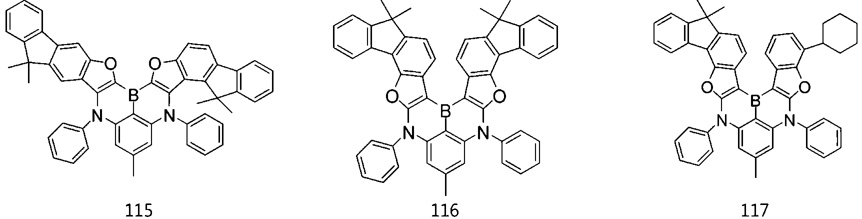

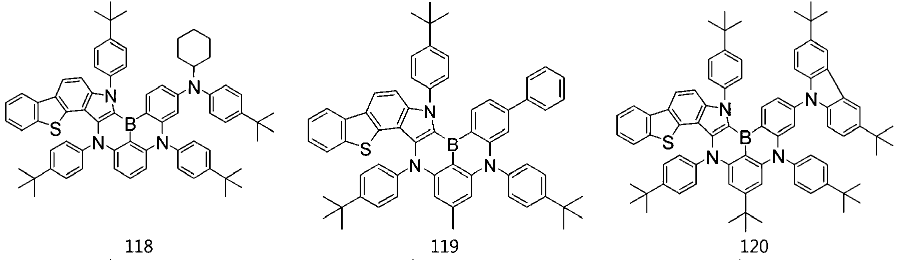

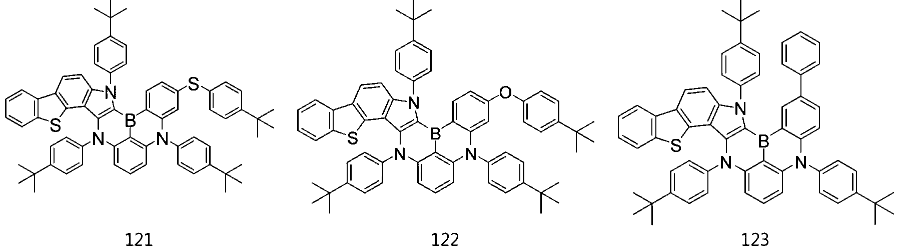

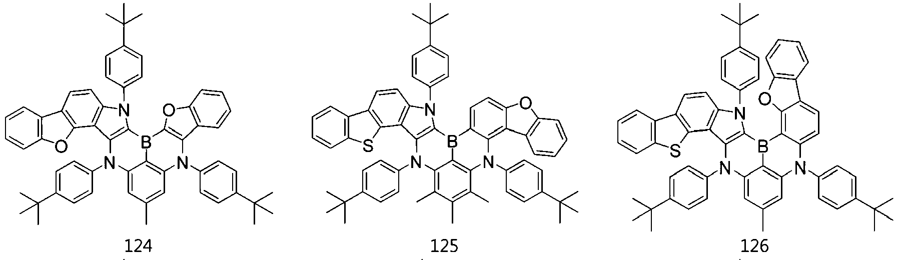

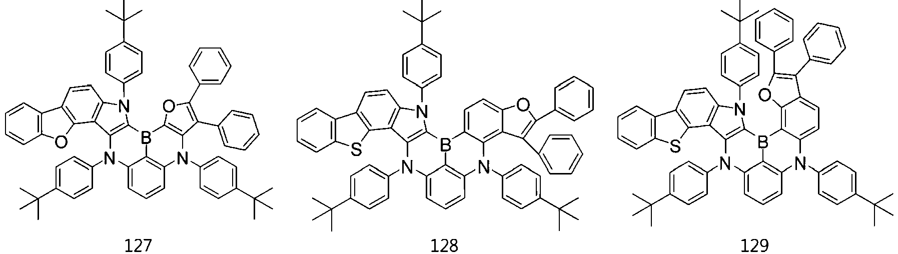

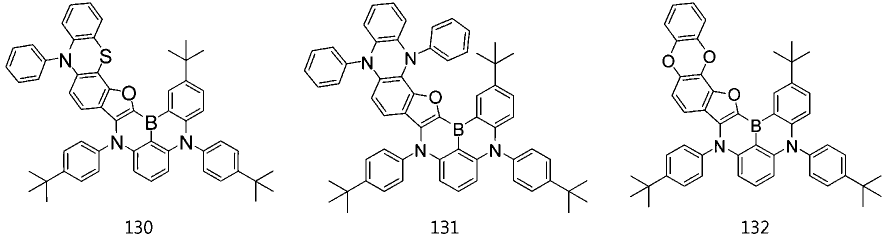

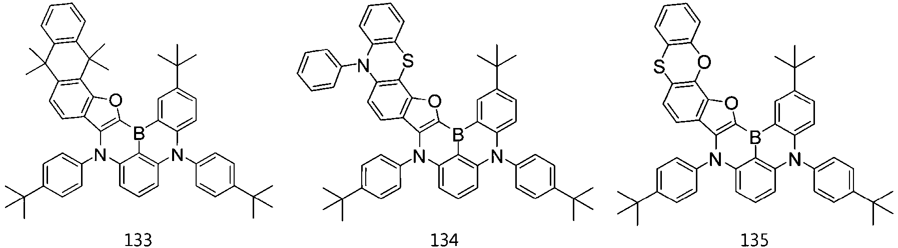

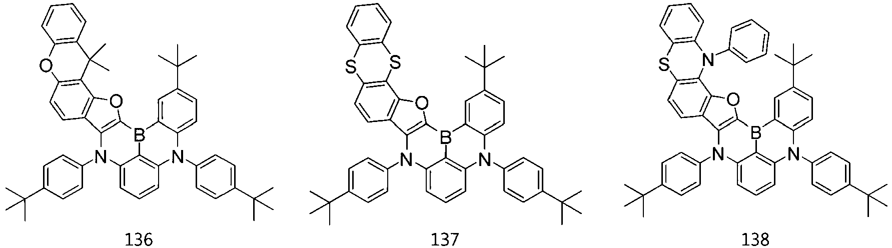

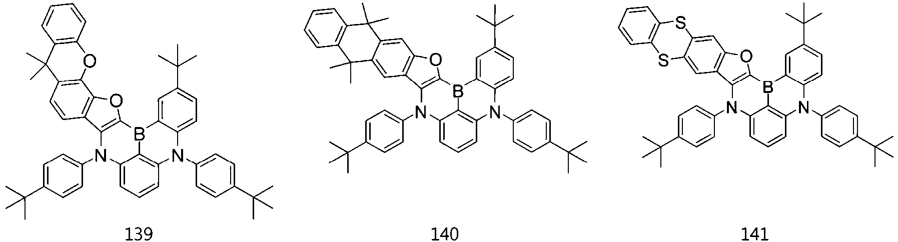

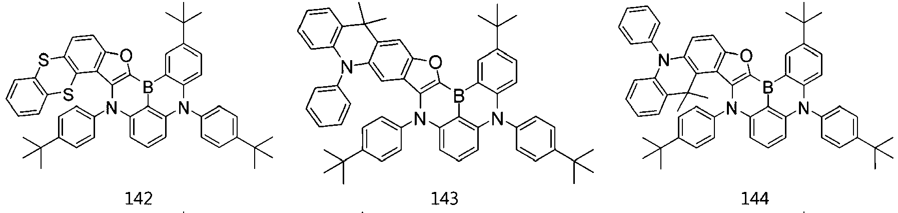

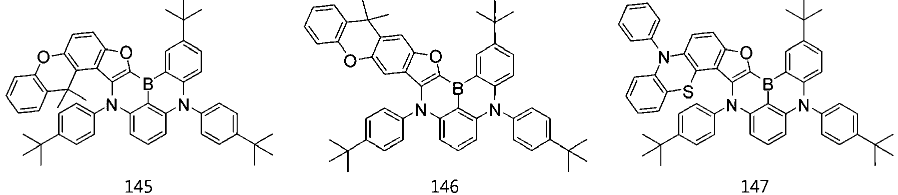

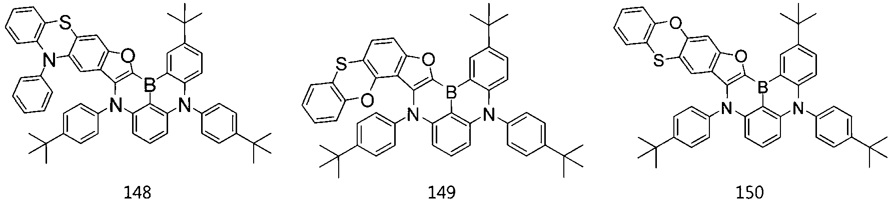

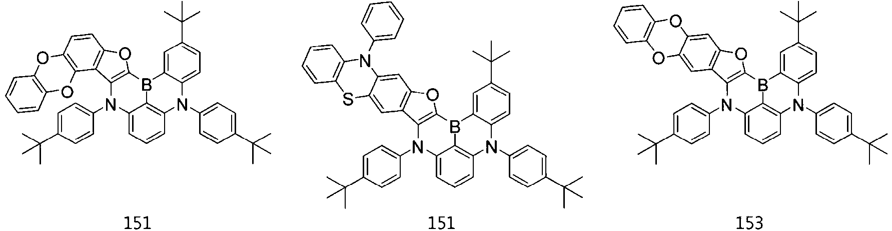

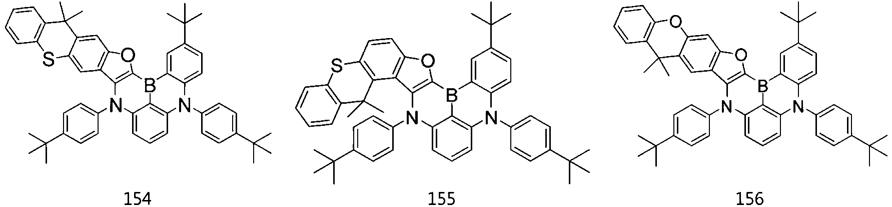

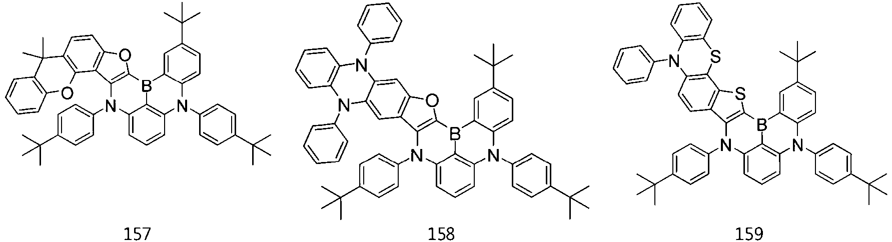

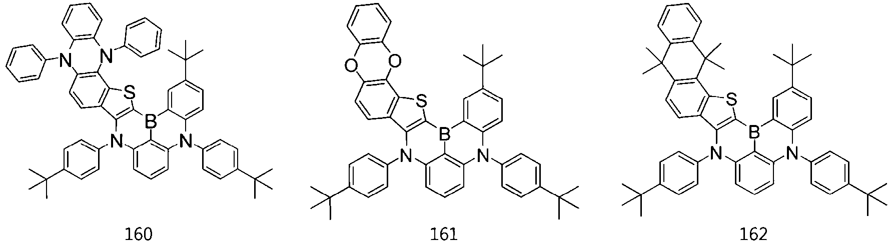

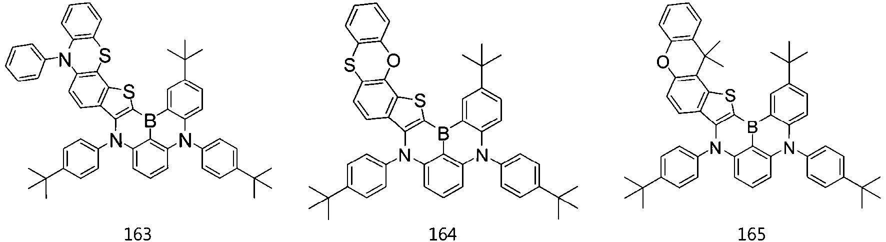

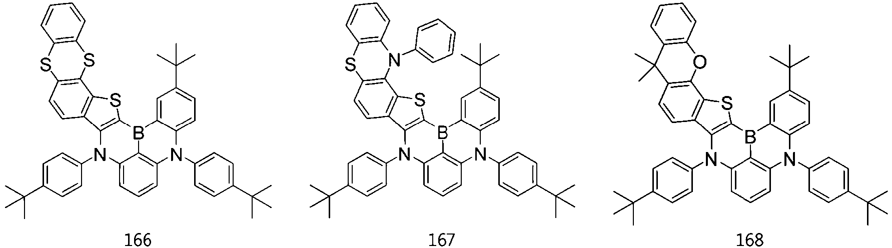

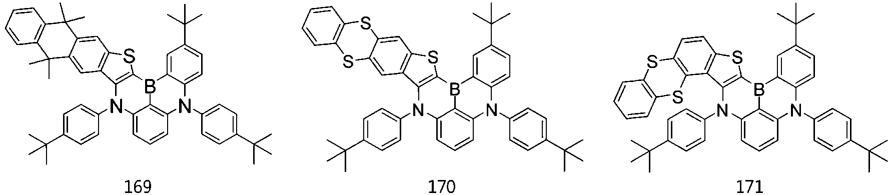

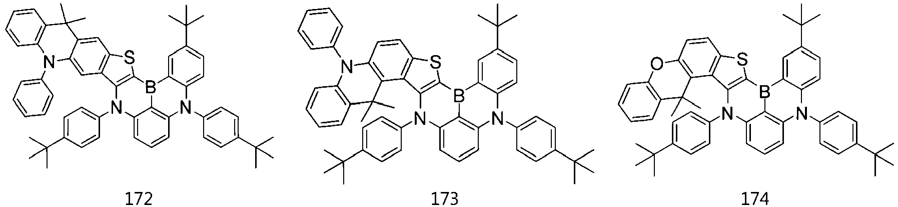

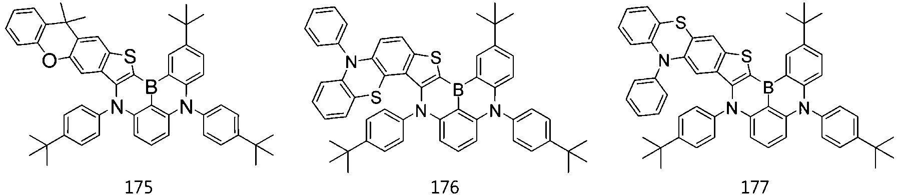

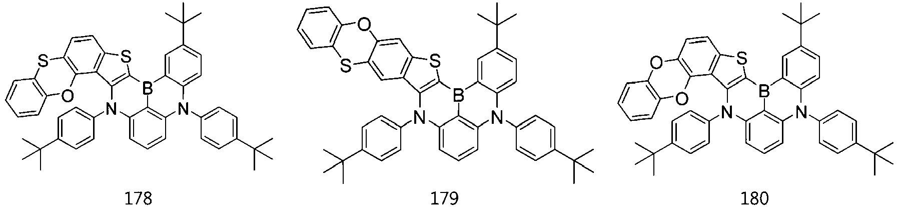

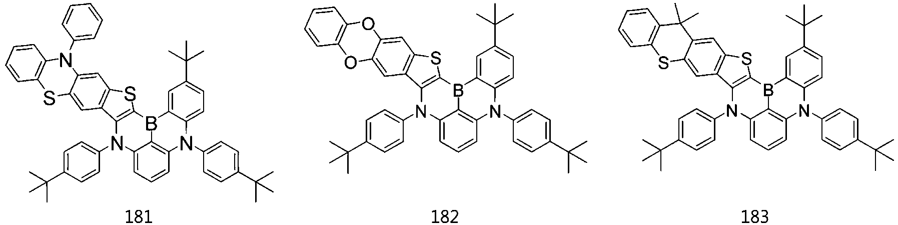

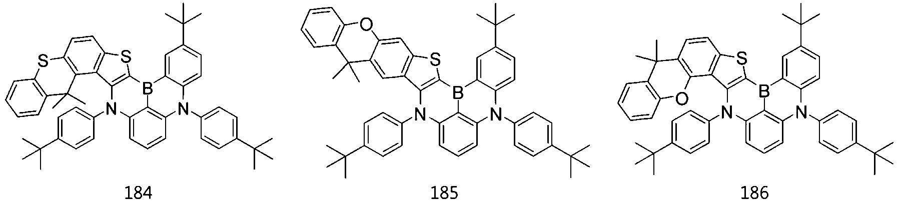

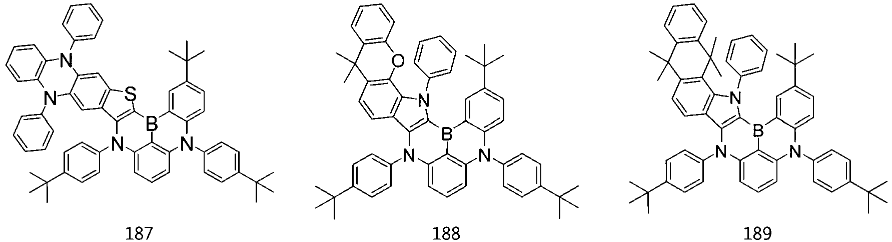

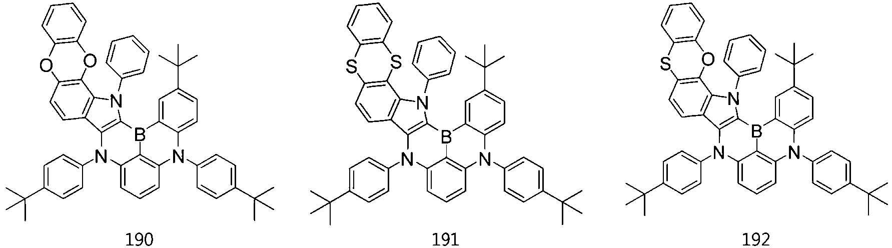

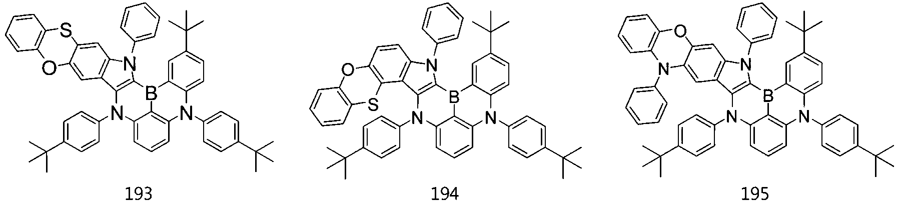

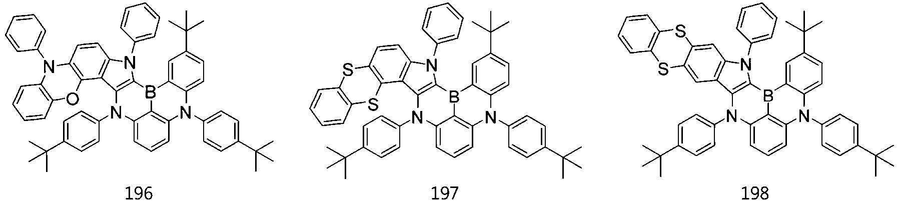

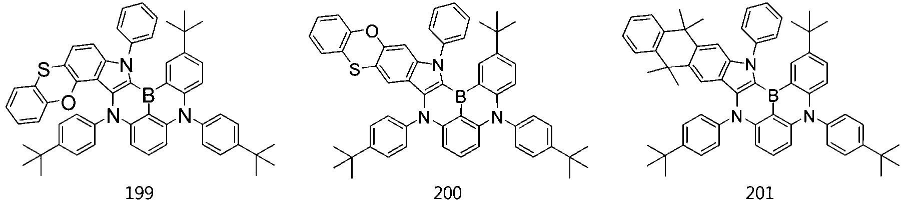

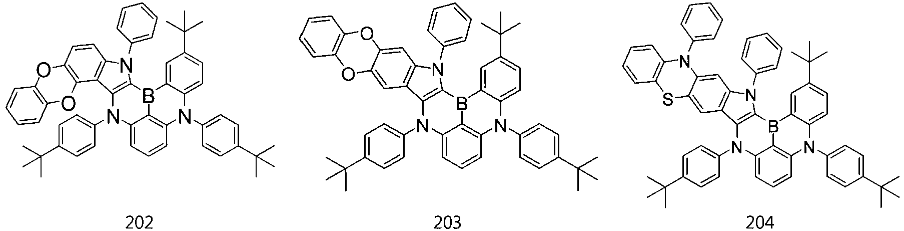

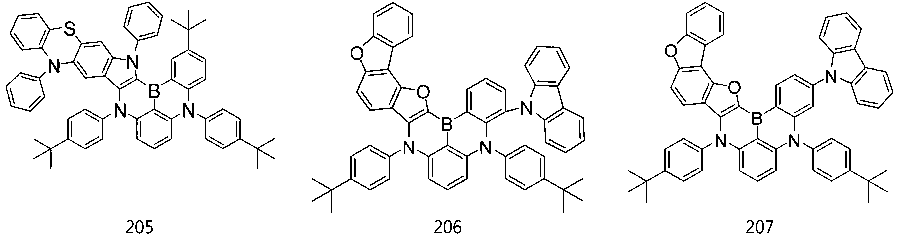

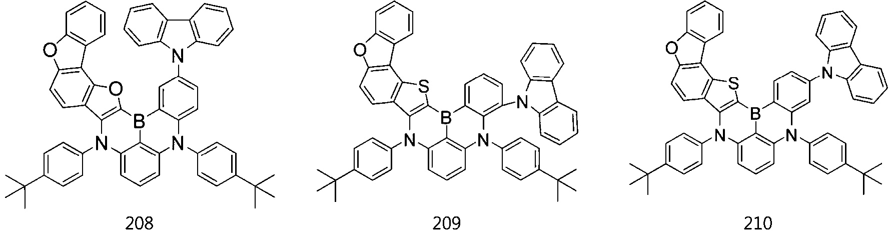

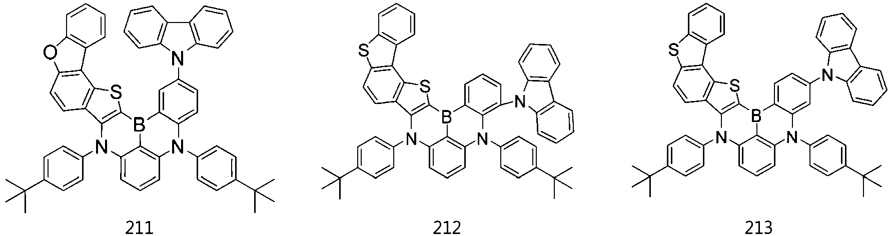

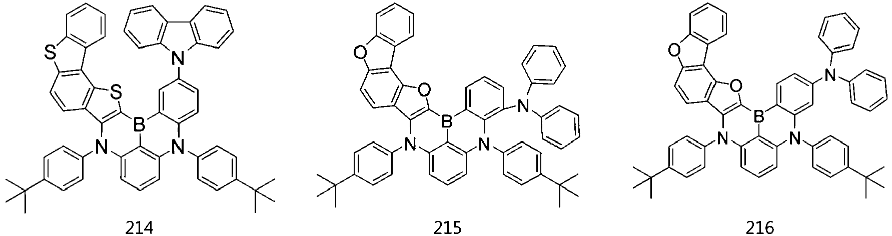

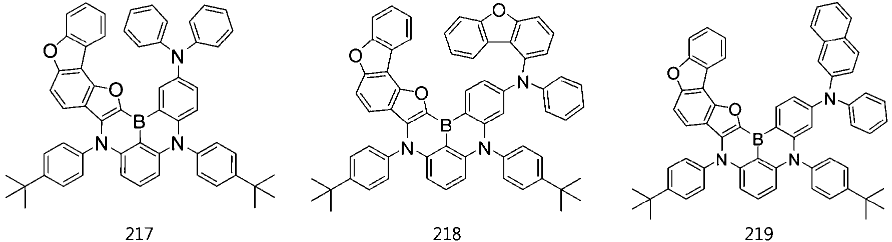

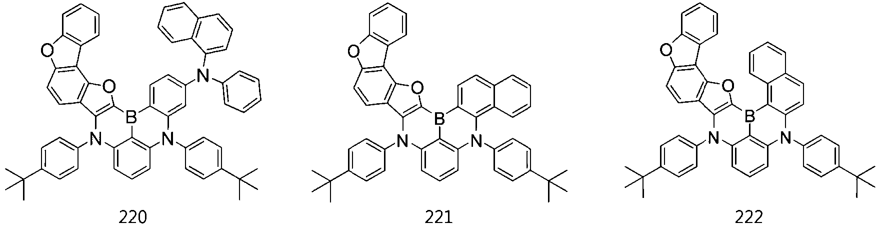

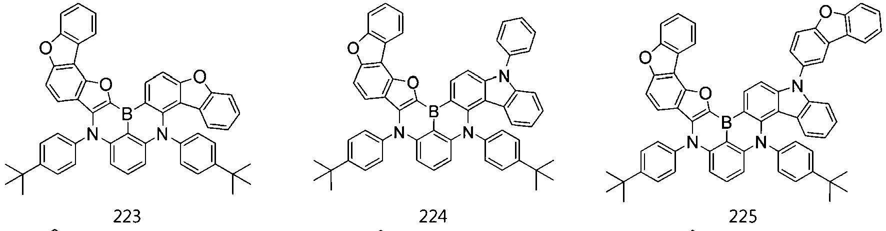

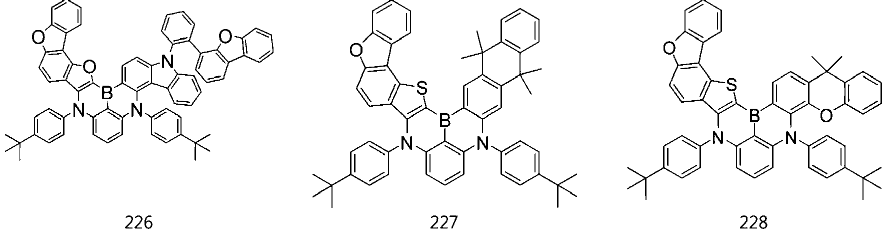

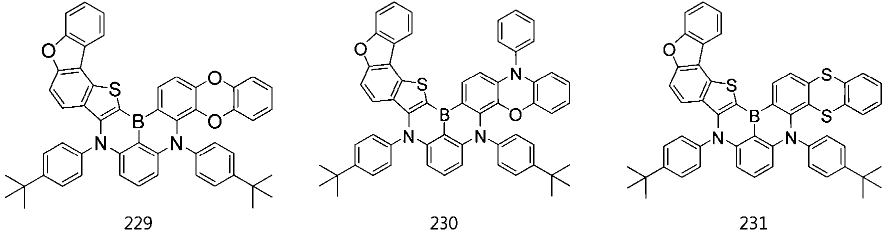

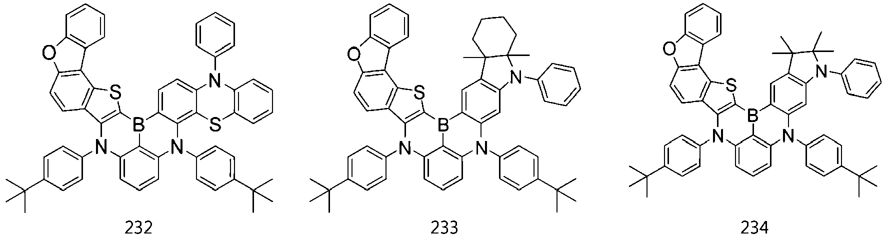

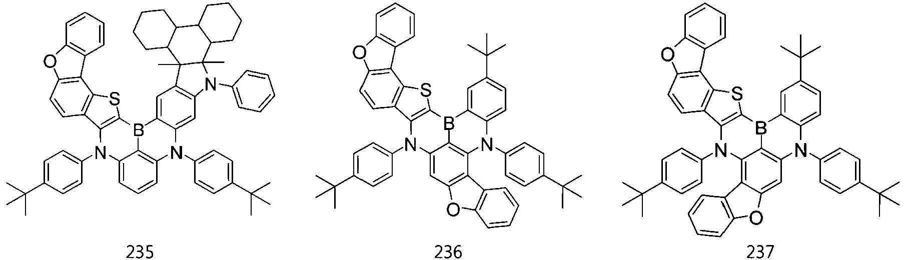

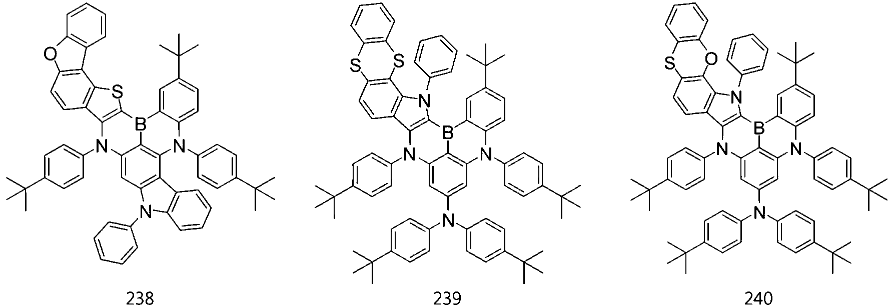

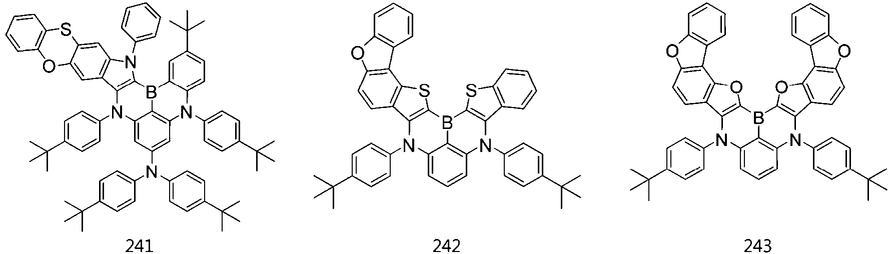

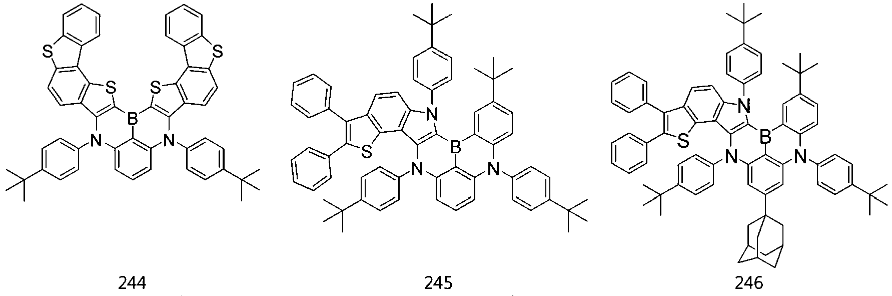

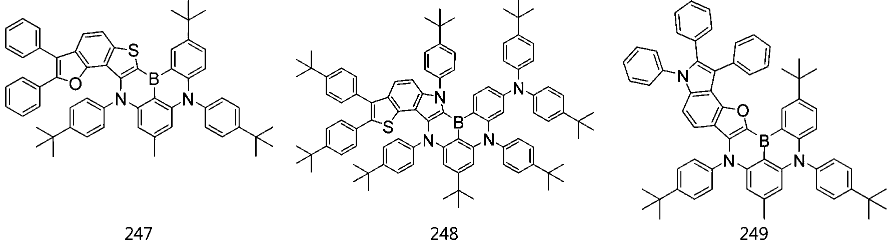

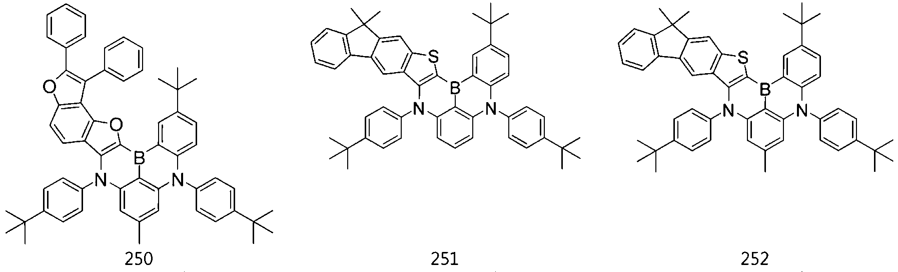

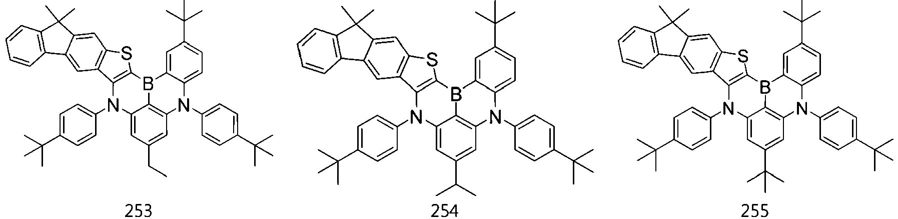

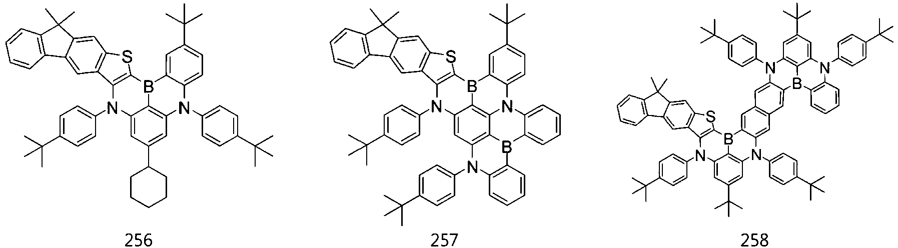

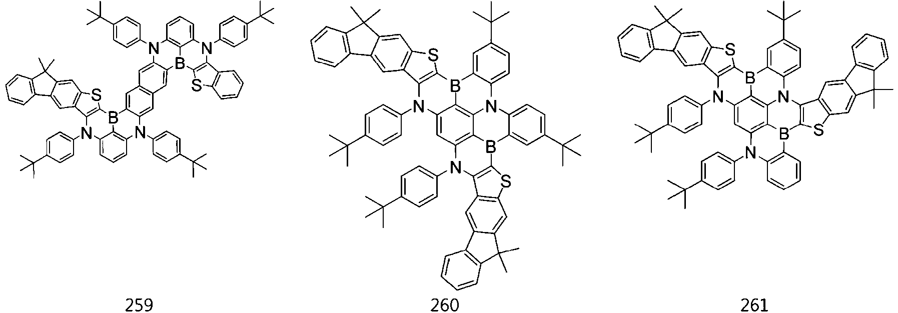

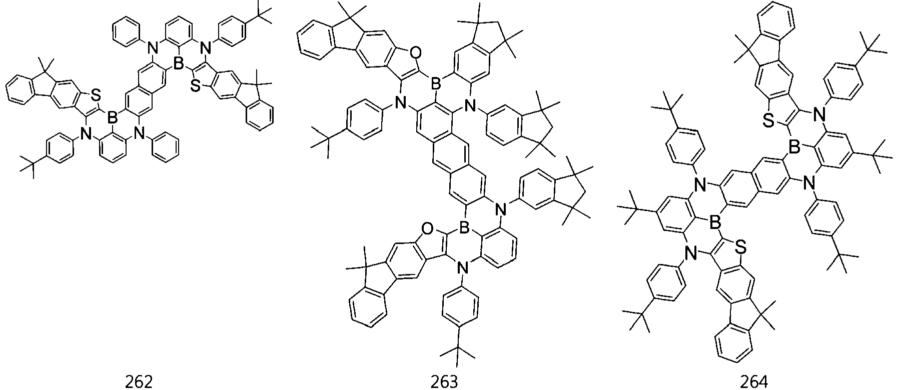

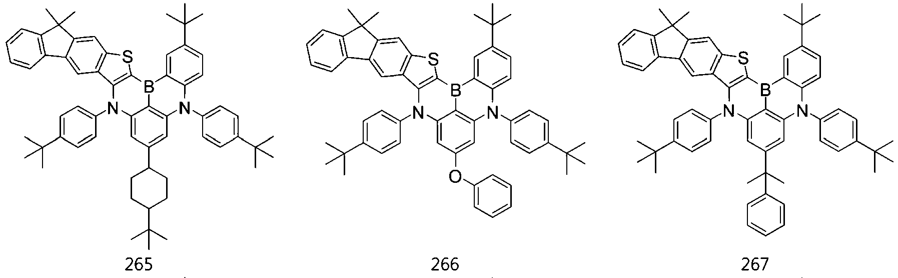

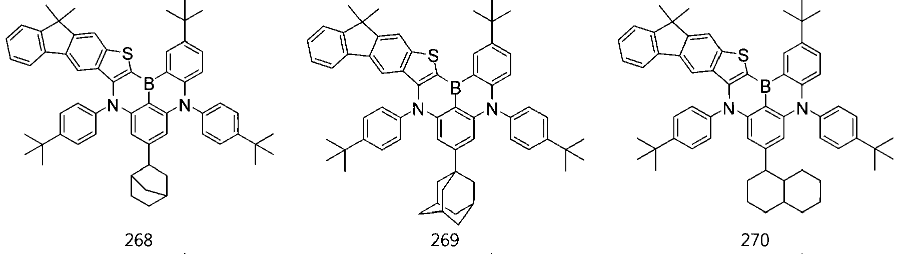

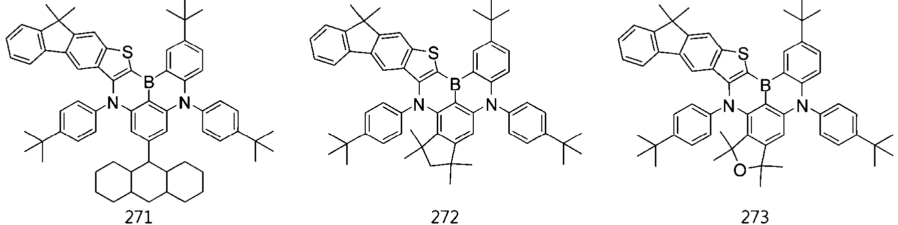

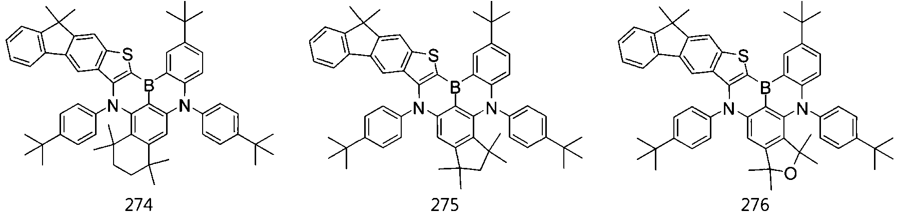

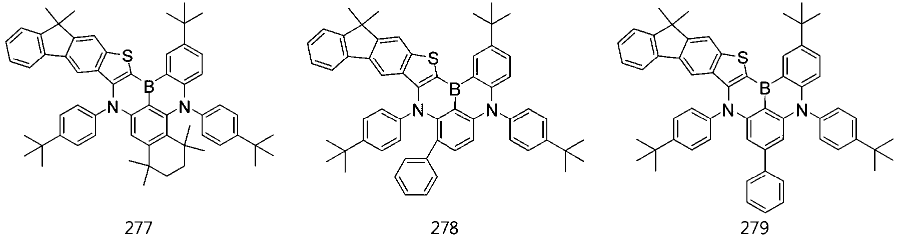

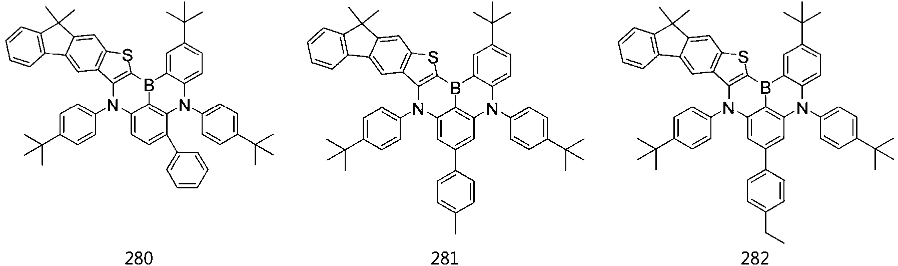

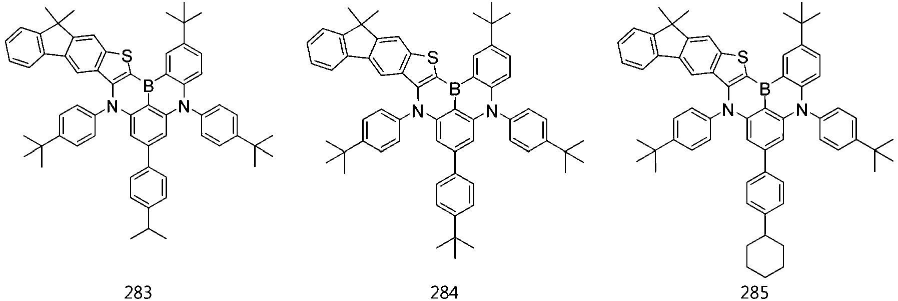

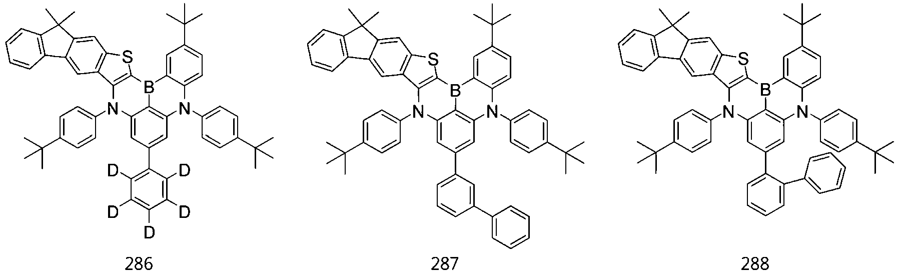

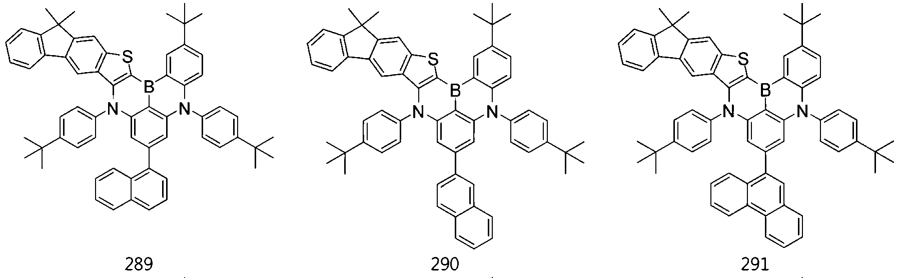

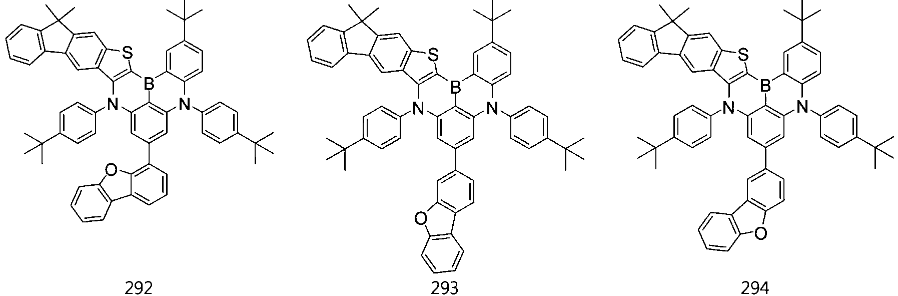

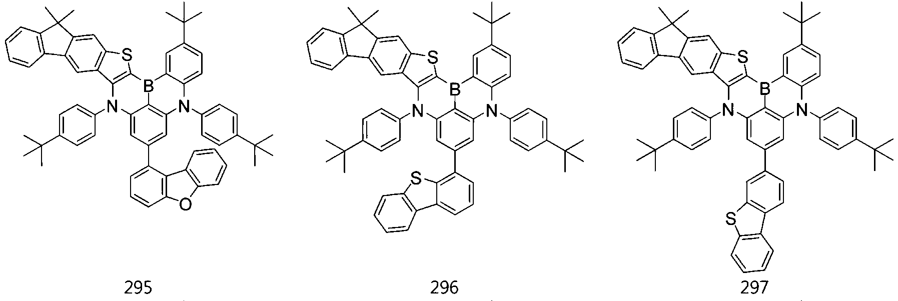

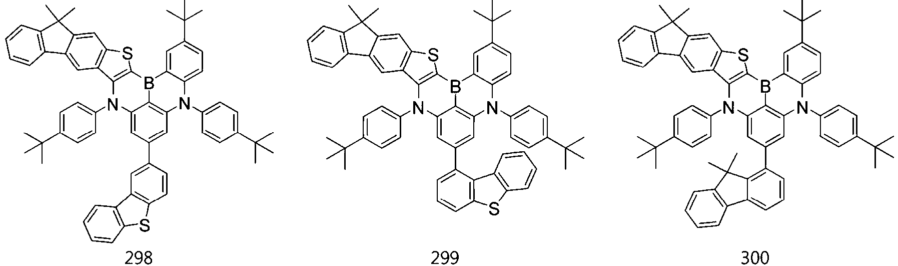

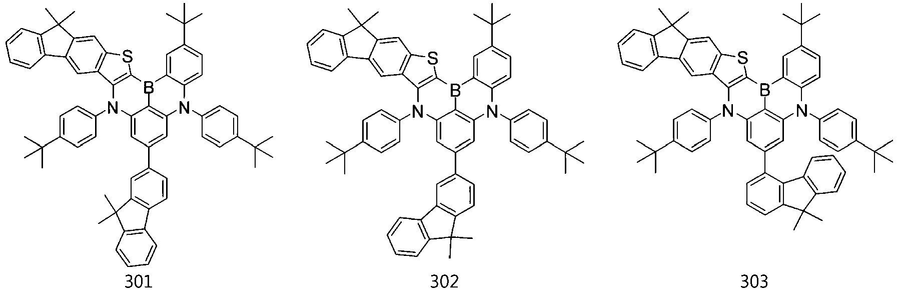

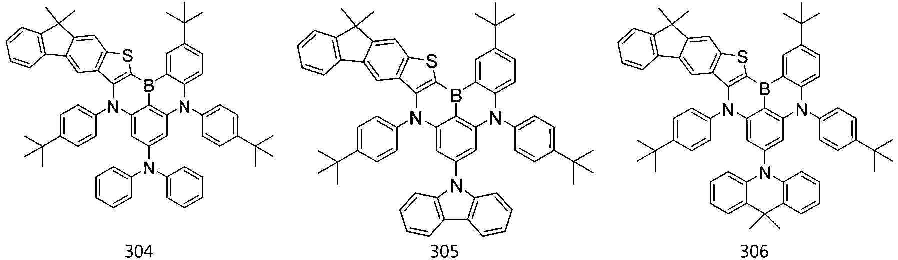

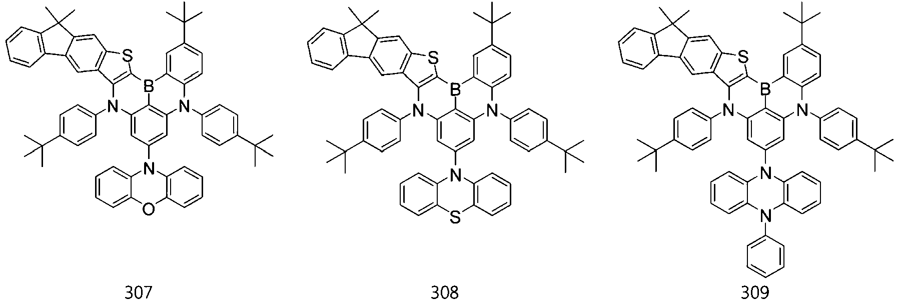

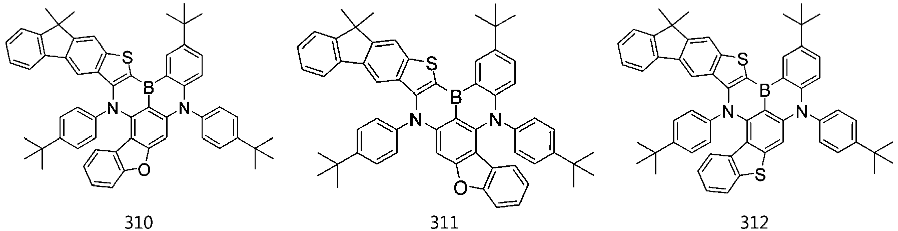

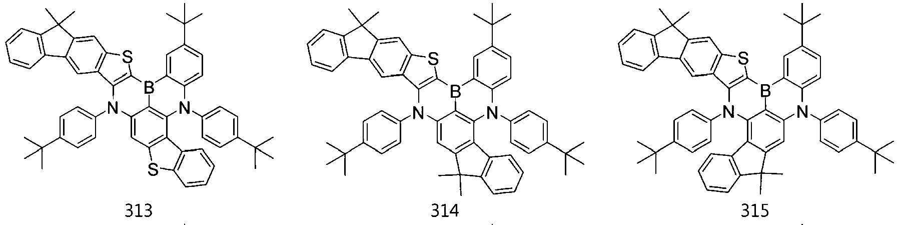

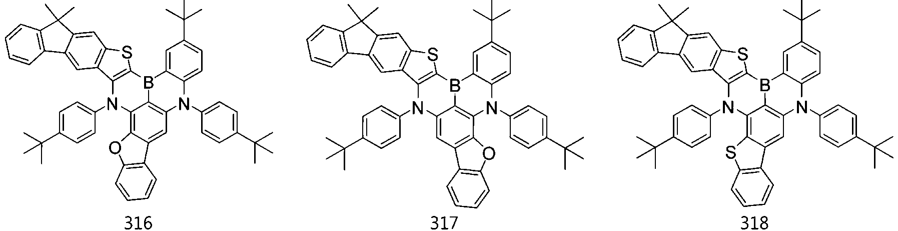

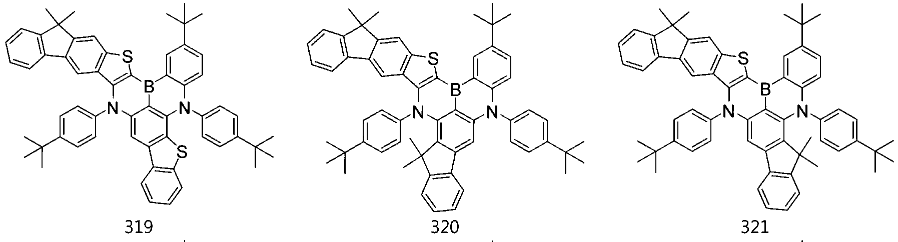

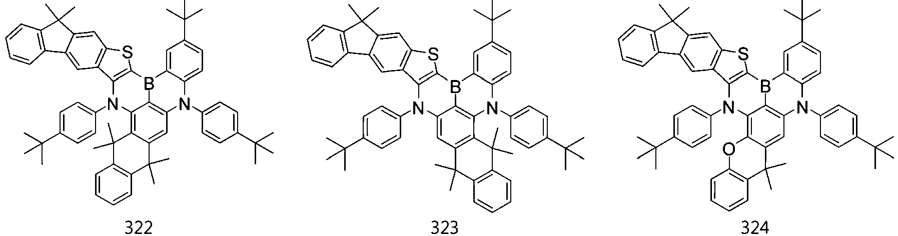

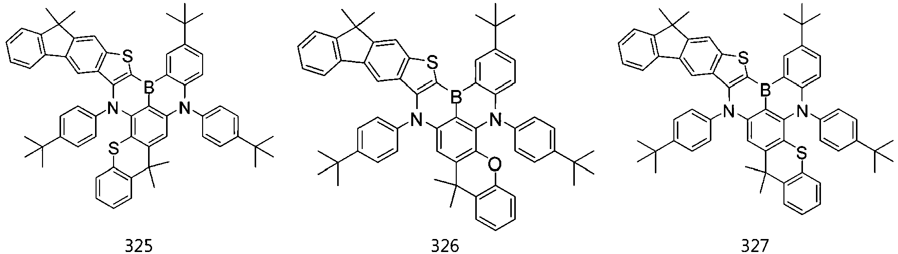

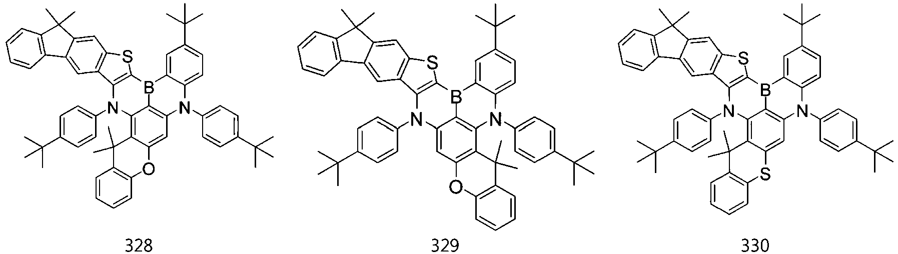

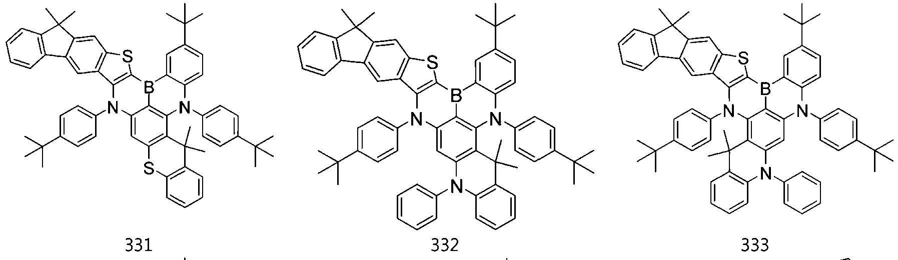

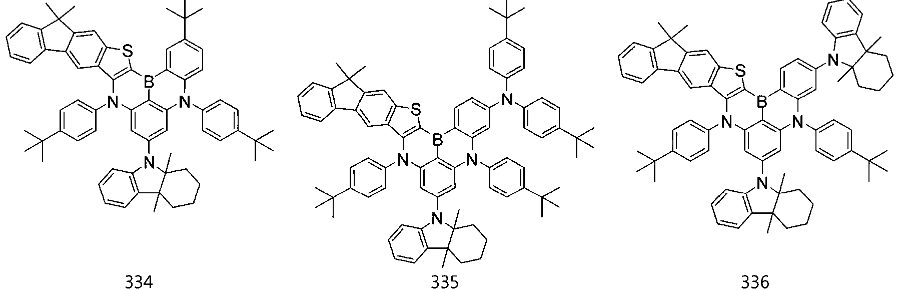

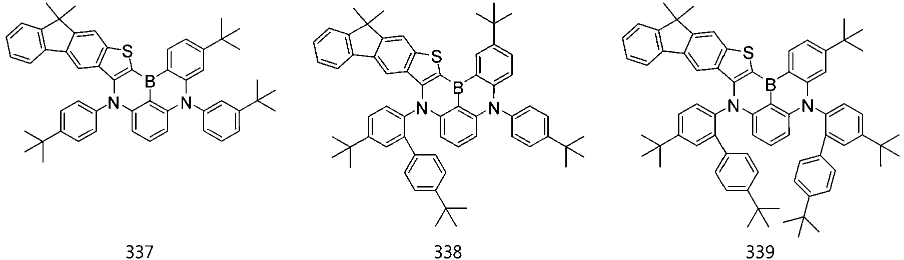

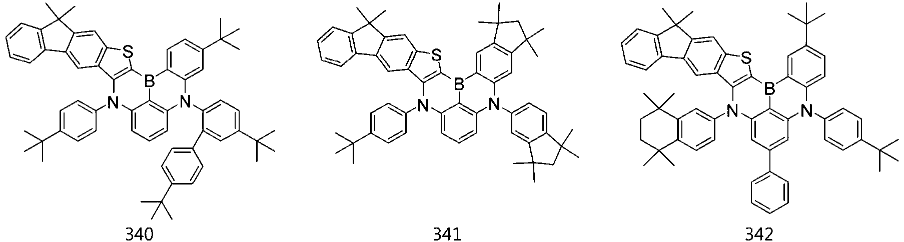

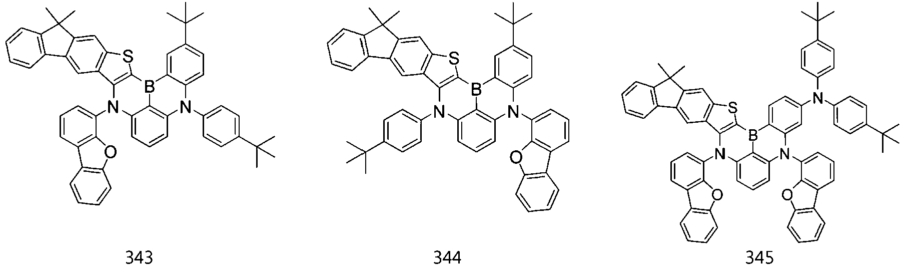

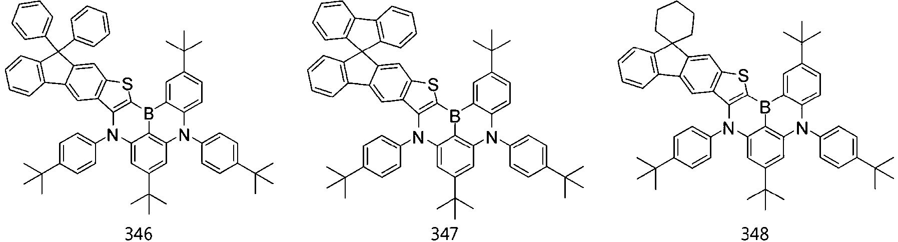

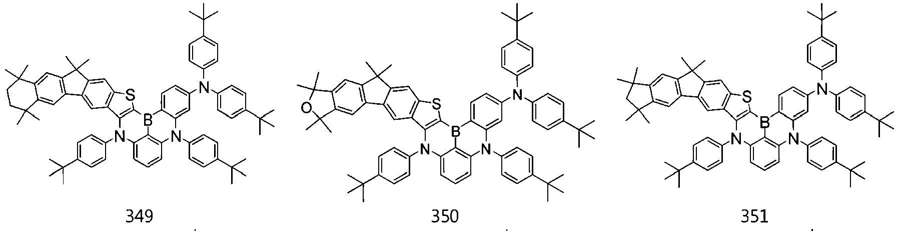

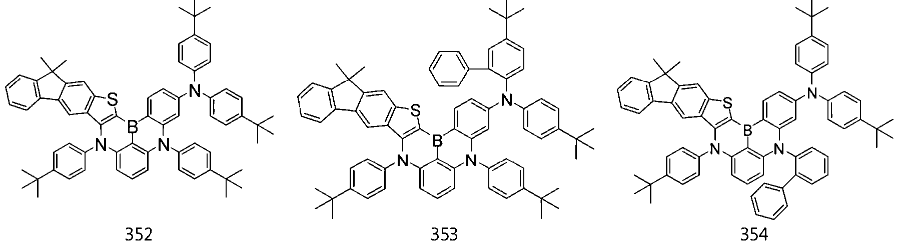

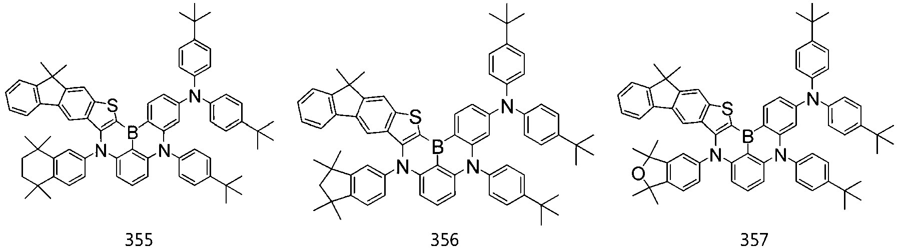

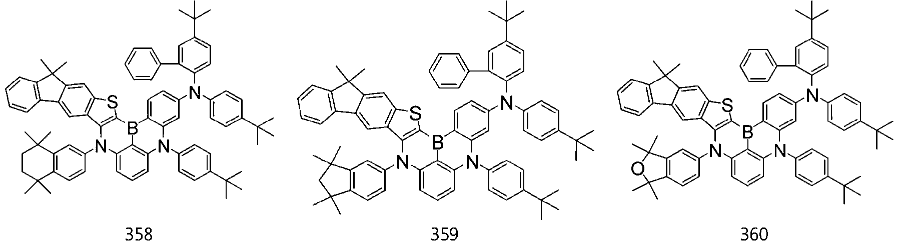

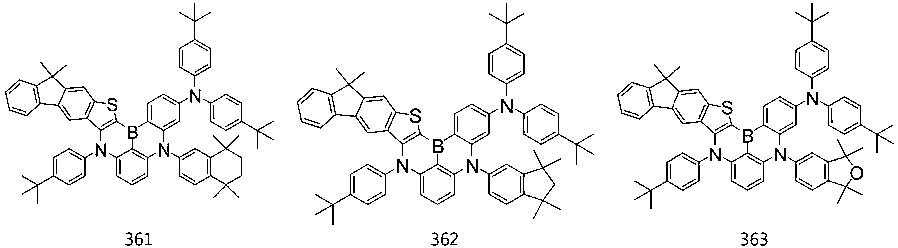

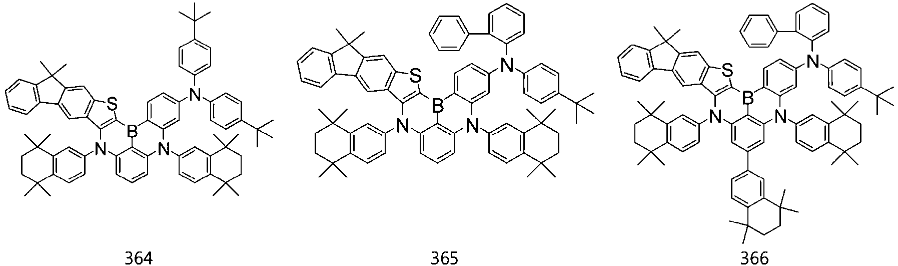

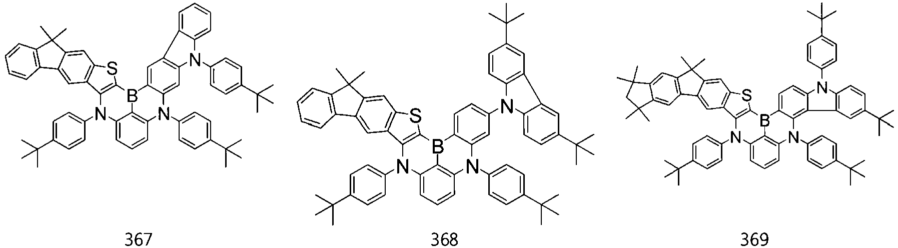

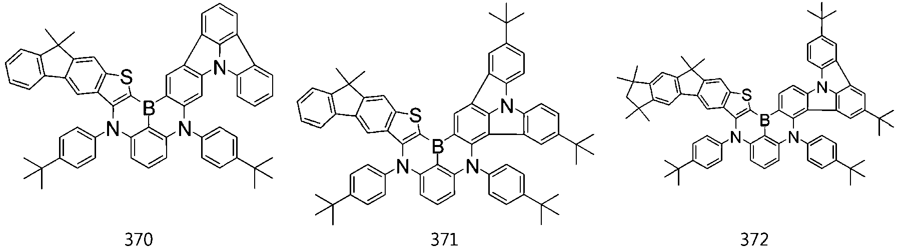

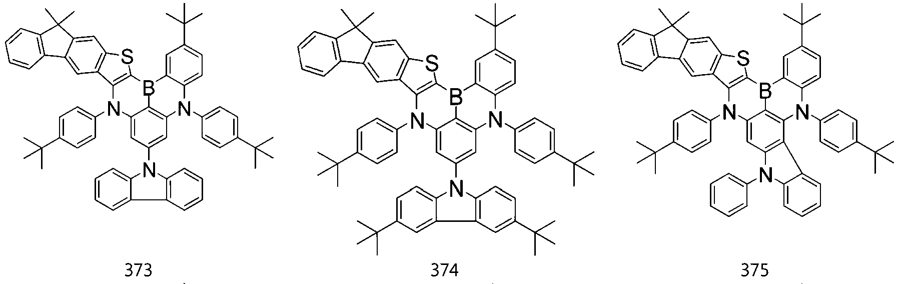

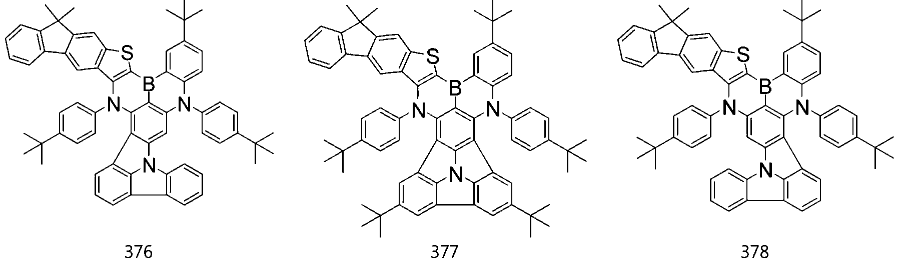

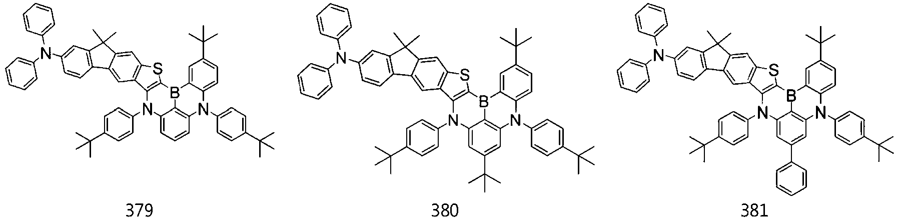

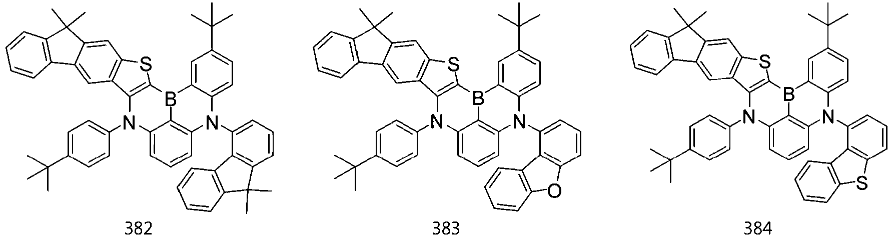

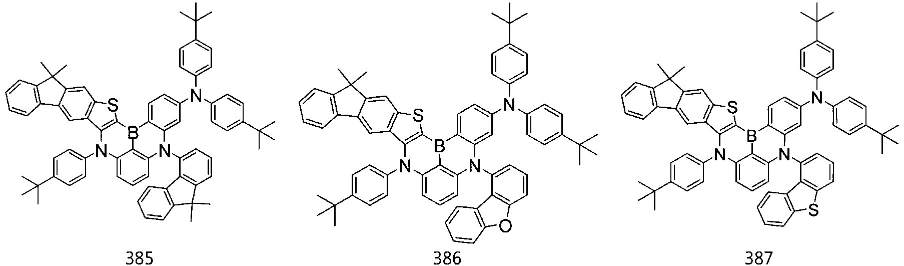

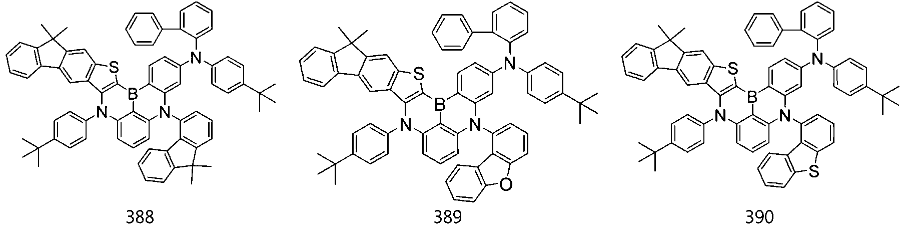

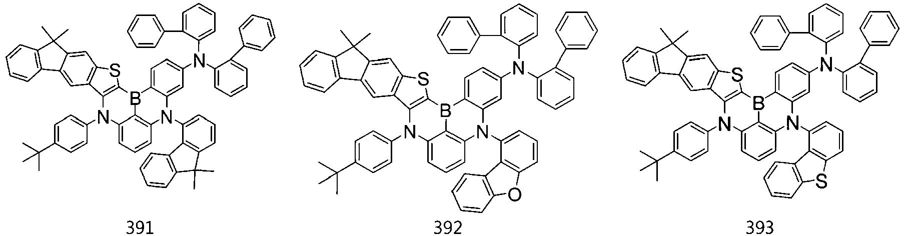

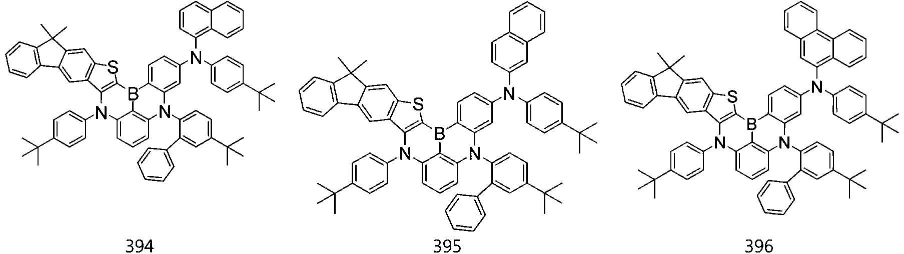

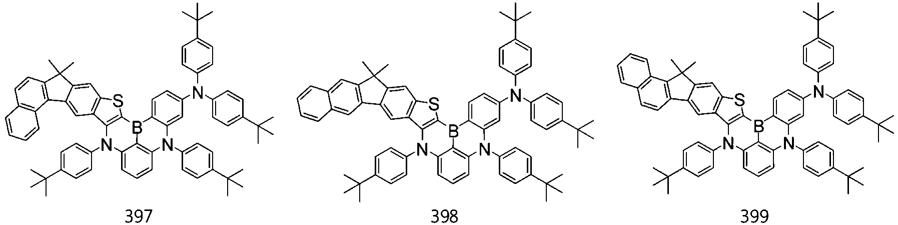

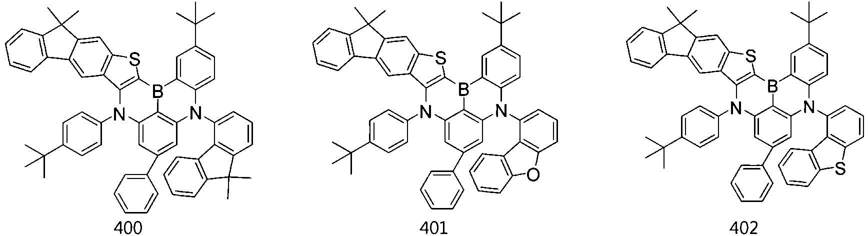

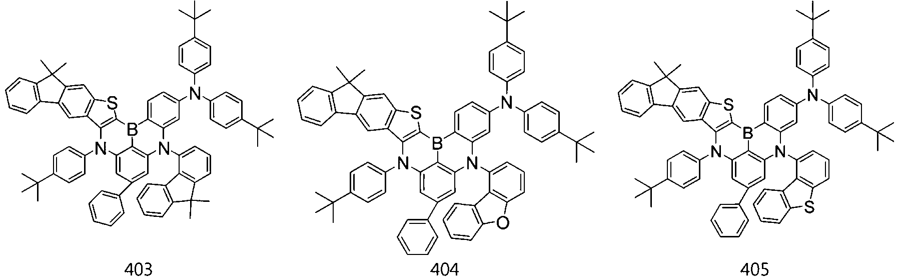

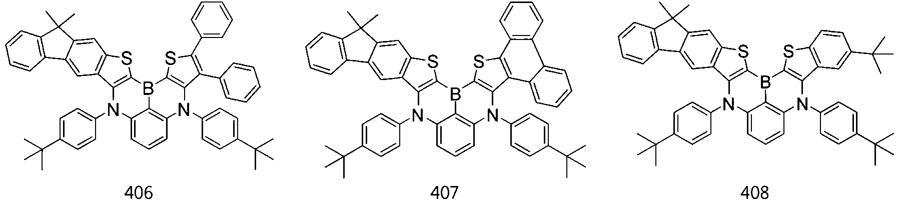

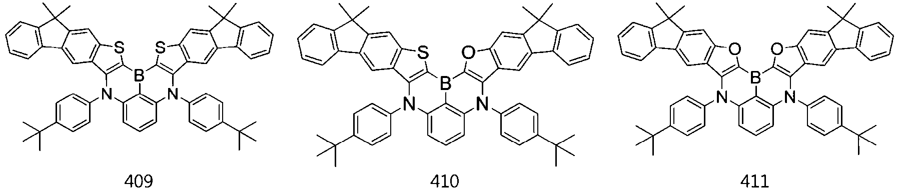

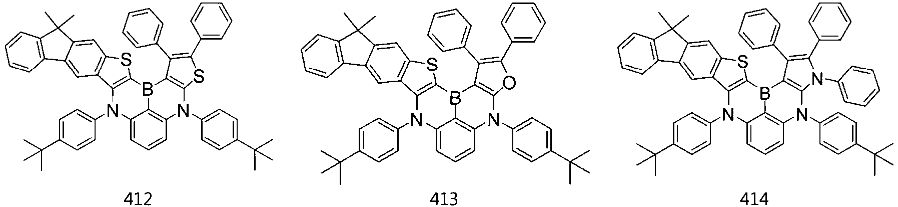

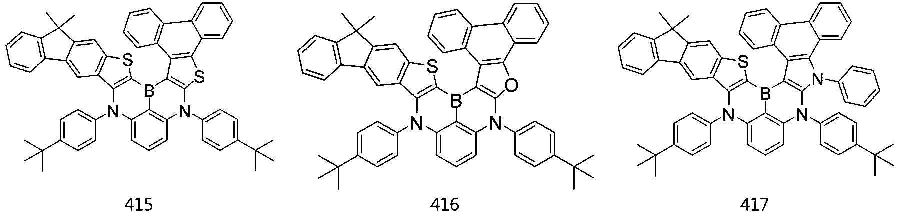

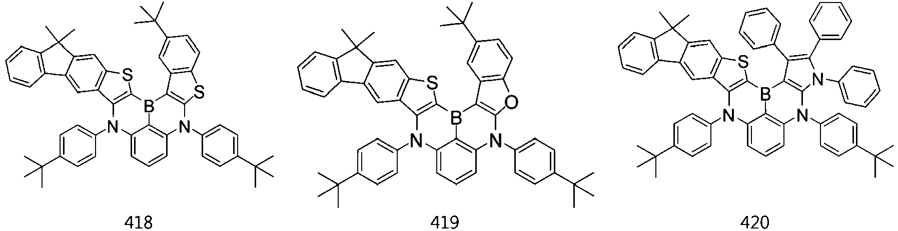

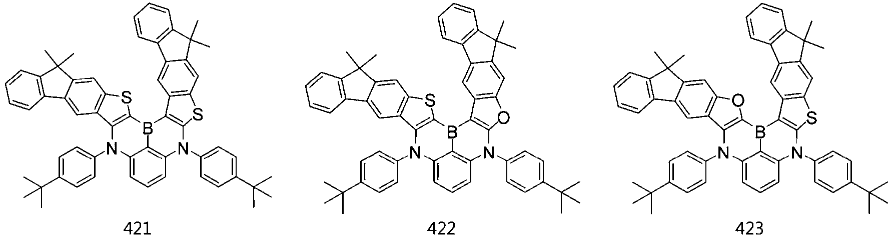

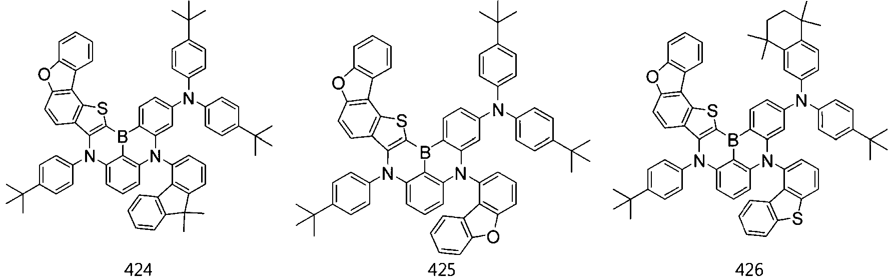

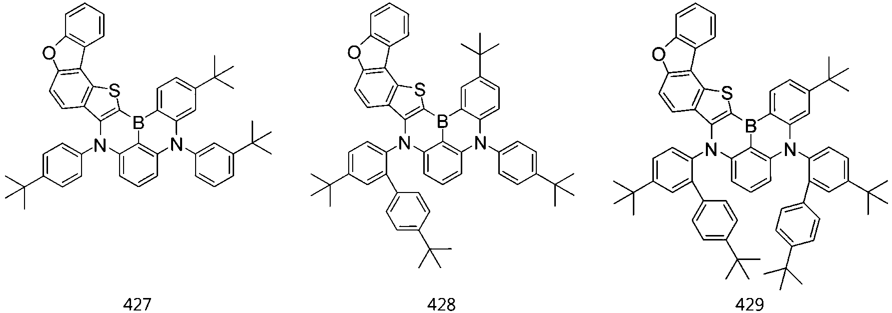

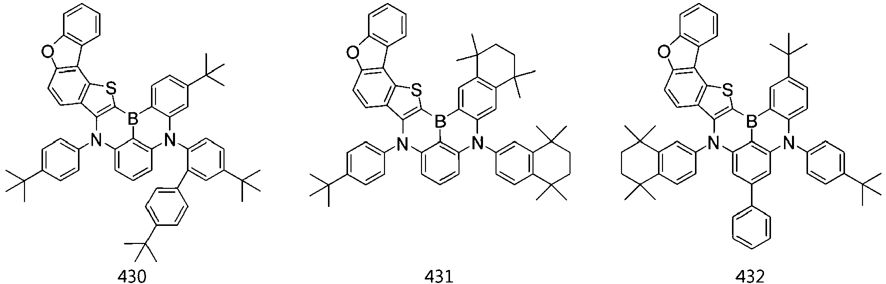

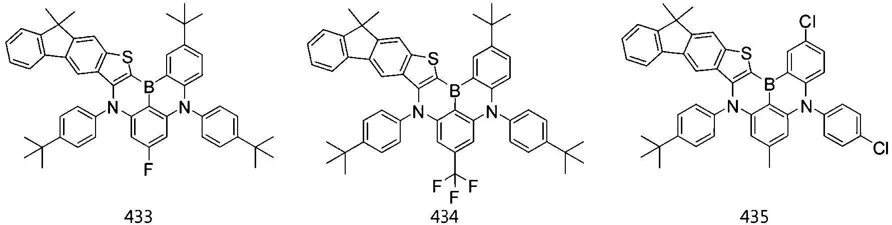

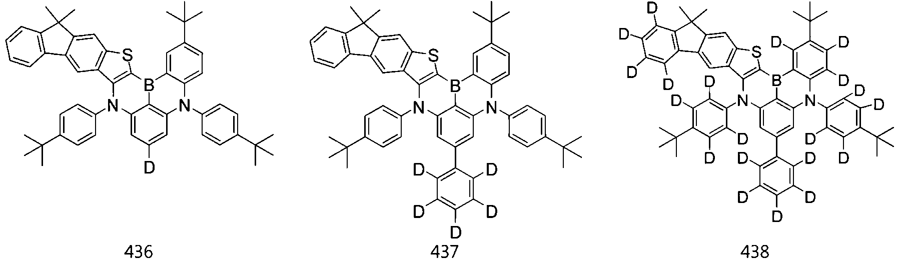

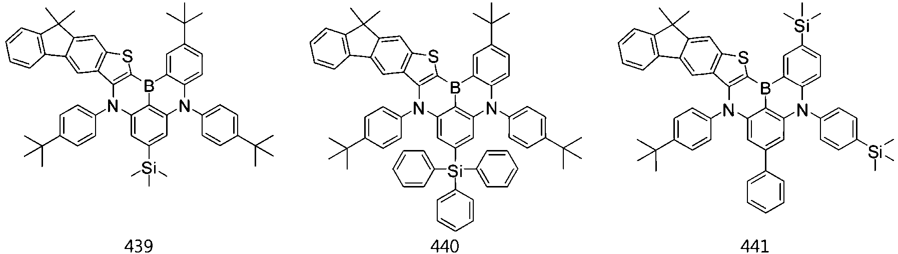

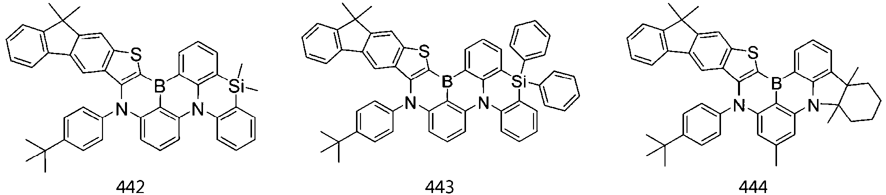

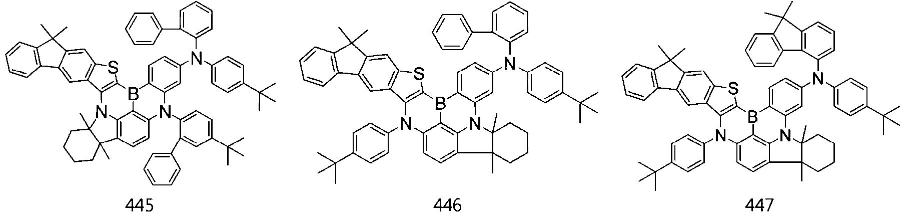

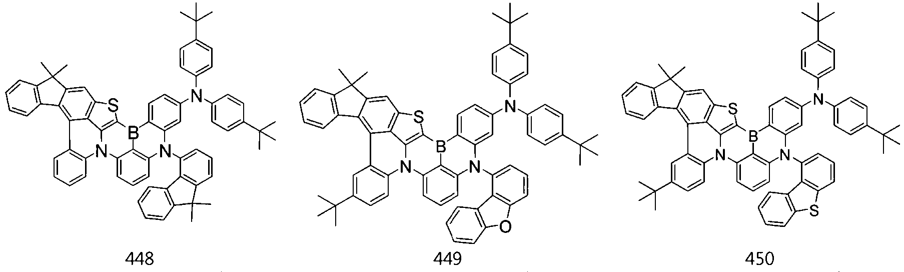

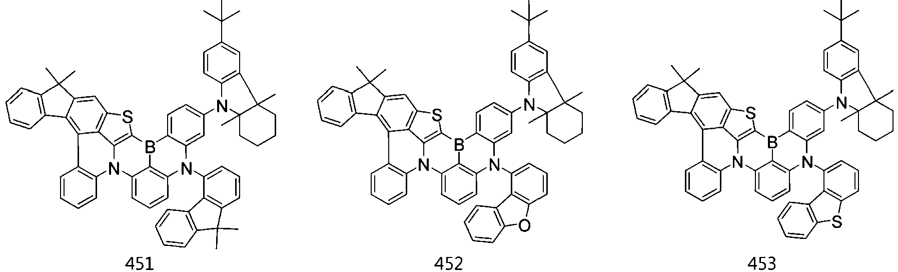

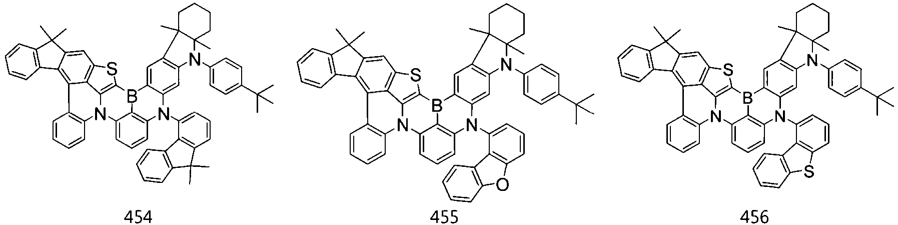

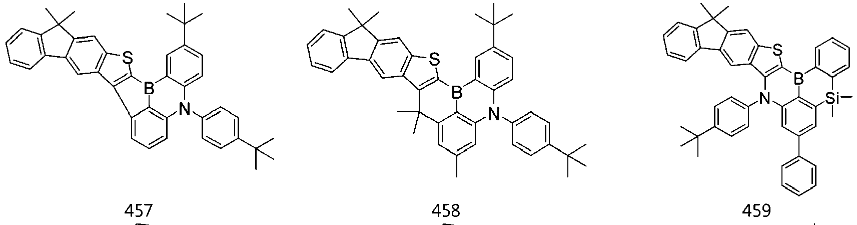

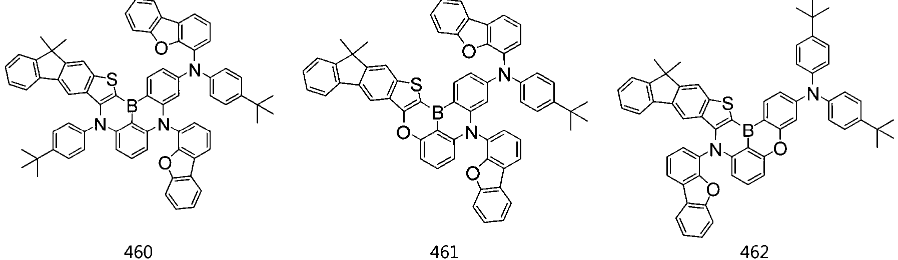

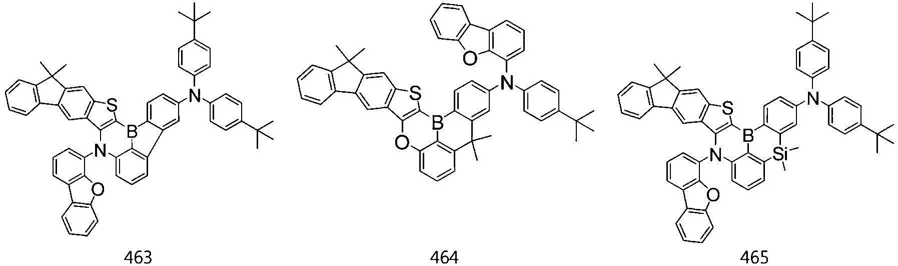

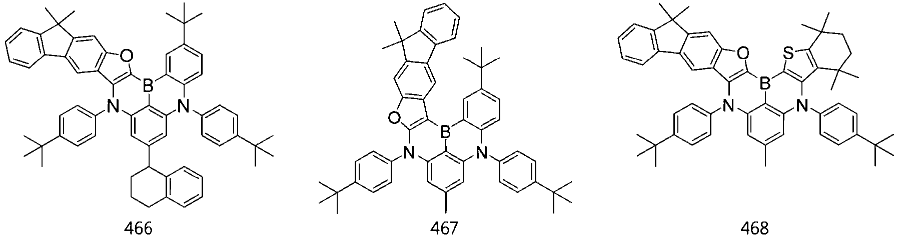

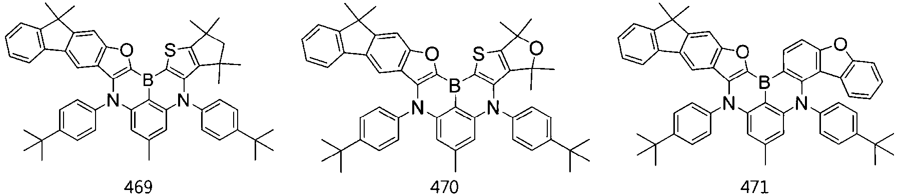

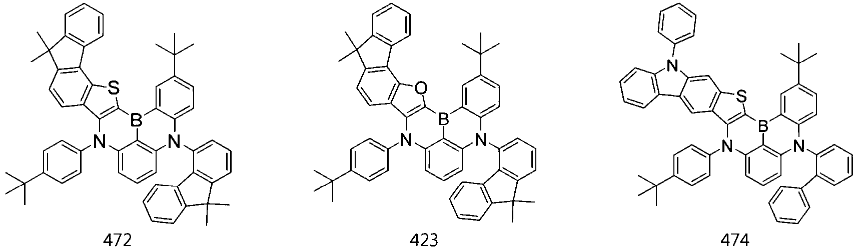

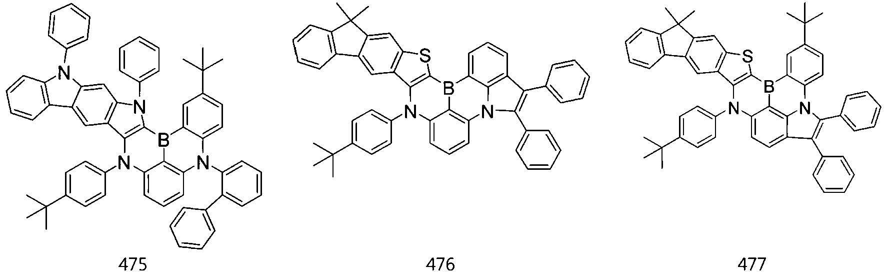

As can be seen from the specific compounds, a polycyclic aromatic structure including B, P, P=O, P=S, Al, or the like is formed and substituents are introduced thereinto, thereby synthetizing organic light-emitting materials having intrinsic characteristics of the substituents. For example, by introducing, into the structures, substituents used for materials for a hole injection layer, a hole transport layer, a light-emitting layer, an electron transport layer, an electron injection layer, an electron blocking layer, a hole blocking layer, and the like used in the manufacture of the organic light-emitting device, organic light-emitting materials that satisfy the requirements for respective organic layers can be produced. Based thereon, highly efficient and long-lasting organic light-emitting devices can be realized.

In addition, in another aspect, the present invention is directed to an organic light-emitting device including a first electrode, a second electrode, and at least one organic layer interposed between the first electrode and the second electrode, wherein the organic layer includes at least one compound represented by [Formula A-1] or [Formula A-2] according to the present invention or a fused multimer thereof.

That is, the organic light-emitting device according to an embodiment of the present invention may have a structure including a first electrode, a second electrode and at least one organic layer disposed therebetween, and the organic light-emitting device may be manufactured using a conventional method and materials for manufacturing devices, except that the compound of [Formula A-1] or [Formula A-2] according to the present invention, or a fused multimer thereof is used in the organic layer of the device.

The organic layer of the organic light-emitting device according to the present invention may have a single layer structure or a multilayer structure in which two or more organic layers are stacked. For example, the organic layer may have a structure including a hole injection layer, a hole transport layer, a hole blocking layer, a light-emitting layer, an electron blocking layer, an electron transport layer, an electron injection layer, and the like. However, the structure of the organic layer is not limited thereto and may include a smaller or larger number of organic layers, and the preferred organic material layer structure of the organic light-emitting device according to the present invention will be described in more detail in Example which will be given later.

Hereinafter, an embodiment of the organic light-emitting device according to the present invention will be described in more detail.

The organic light-emitting device according to the present invention includes an anode, a hole transport layer, a light-emitting layer, an electron transport layer and a cathode, and if necessary, may further include a hole injection layer between the anode and the hole transport layer, may further include an electron injection layer between the electron transport layer and the cathode, may further include one or two intermediate layers, and may further include a hole blocking layer or an electron blocking layer. As described above, the organic light-emitting device may further include an organic layer having various functions depending on characteristics thereof.

First, the organic light-emitting device according to the present invention may include an anthracene derivative represented by the following [Formula C] as a host compound in the light-emitting layer. 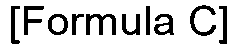 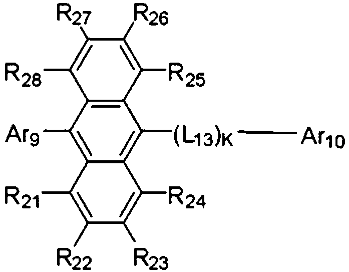 wherein
R₂₁ to R₂₈ are identical to or different from each other, and are the same as defined in R₁ of [Formula A-1] to [Formula A-3],
Ar₉ and Ar₁₀ are identical to or different from each other, and are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C20 alkynyl group, a substituted or unsubstituted C3-C30 cycloalkyl group, a substituted or unsubstituted C5-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted C1-C30 alkylamine group, a substituted or unsubstituted C6-C30 arylamine group, a substituted or unsubstituted C1-C30 alkylsilyl group, and a substituted or unsubstituted C6-C30 arylsilyl group, and
L₁₃ is a single bond, or is selected from a substituted or unsubstituted C6-C20 arylene group and a substituted or unsubstituted C2-C20 heteroarylene group, is preferably a single bond or a substituted or unsubstituted C6-C20 arylene group, and k is an integer from 1 to 3, provided that, when k is 2 or more, L₁₃'s are identical to or different from each other.

In addition, in an embodiment of the present invention, Ar₉ of [Formula C] may be a substituent represented by the following [Formula C-1]: 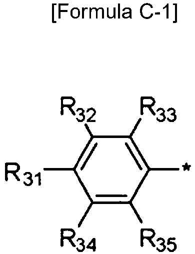 wherein
R₃₁ to R₃₅ are identical to or different from each other, are the same as defined in R₁ of [Formula A-1] or [Formula A-2] and may be bonded to an adjacent substituent to form a saturated or unsaturated ring.

In addition, in an embodiment of the present invention, Ar₁₀ in [Formula C] may be substituted dibenzofuran.

In addition, in an embodiment of the present invention, [Formula C] may have a structure substituted with at least one deuterium, and [Formula C] may have a structure, 30% or more of which is substituted with deuterium, that is, may have a deuteration degree of 30% or more, and preferably a deuteration degree of 40% or more.

The deuteration degree means a percentage of (the number of deuterium substituted)/(the total number of hydrogen and deuterium substituted) in the total substituent structure of the compound represented by [Formula C].

Specifically, [Formula C] used in the organic light-emitting device according to the present invention may be selected from the following [Formula C1] to [Formula C60].

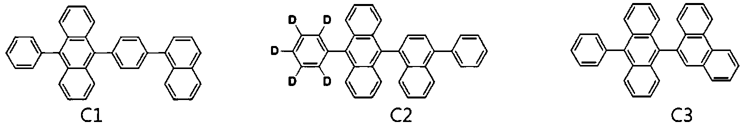

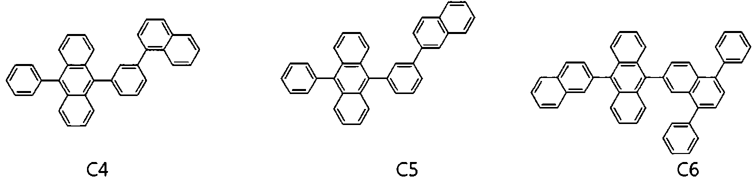

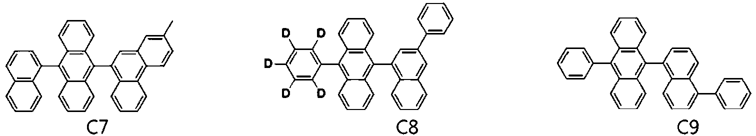

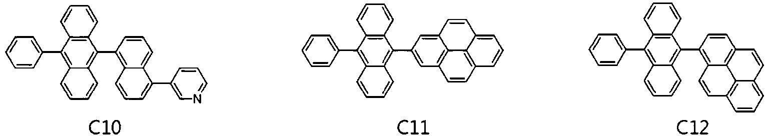

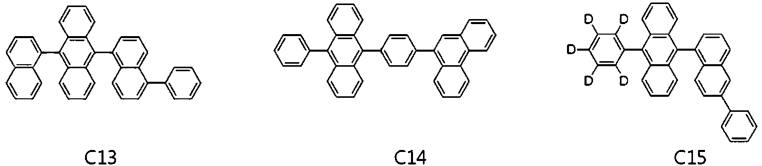

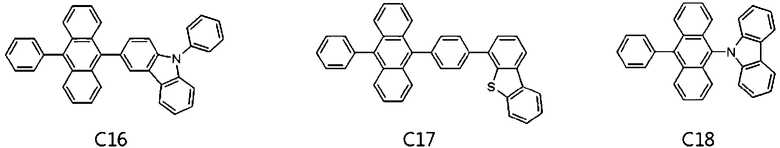

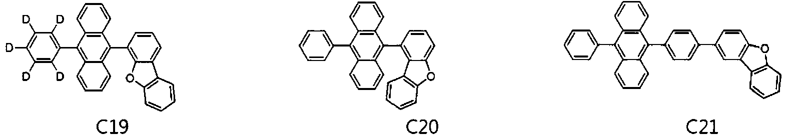

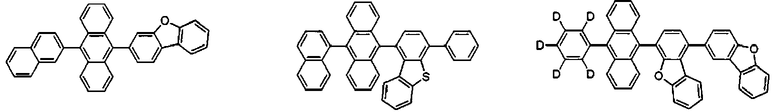

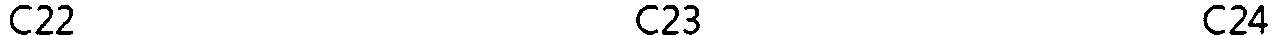

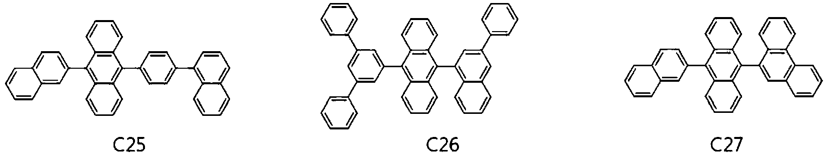

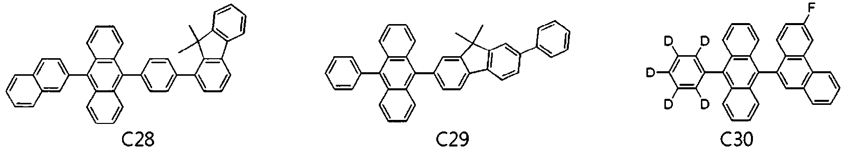

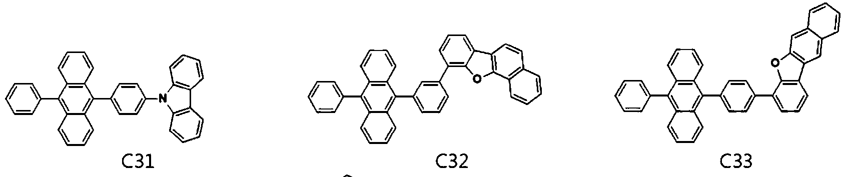

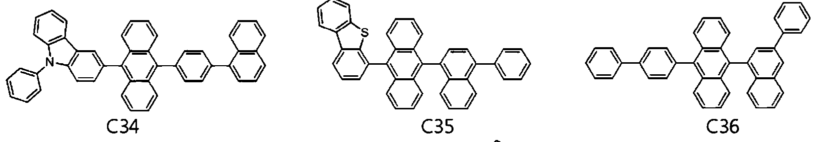

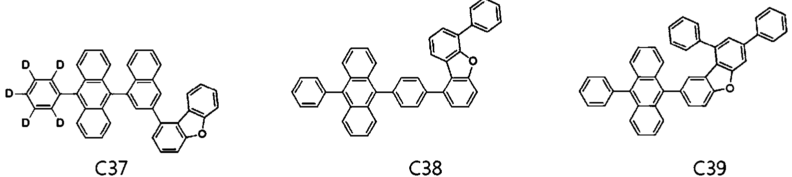

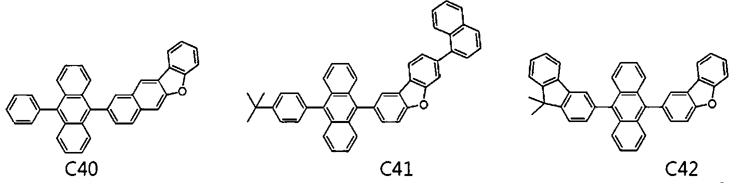

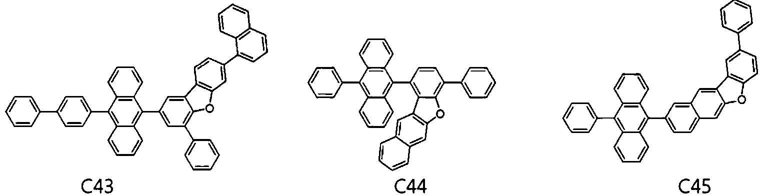

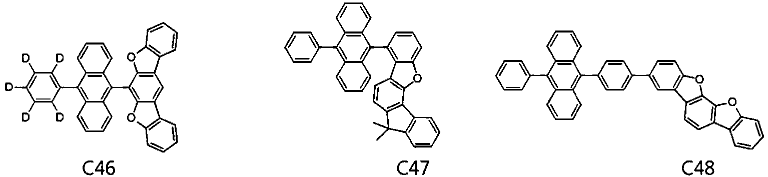

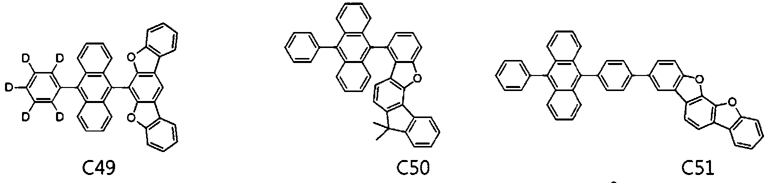

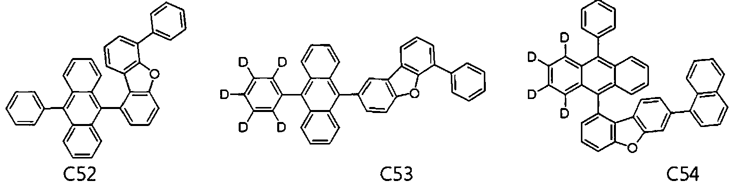

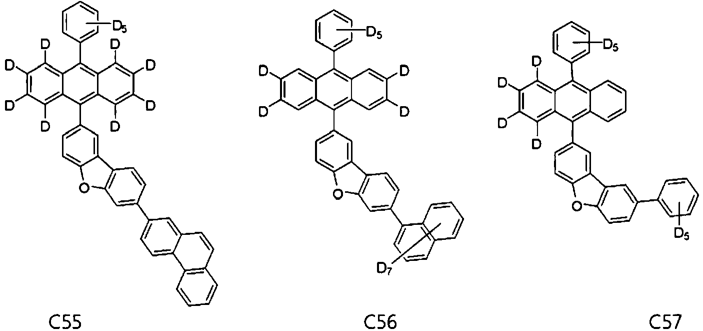

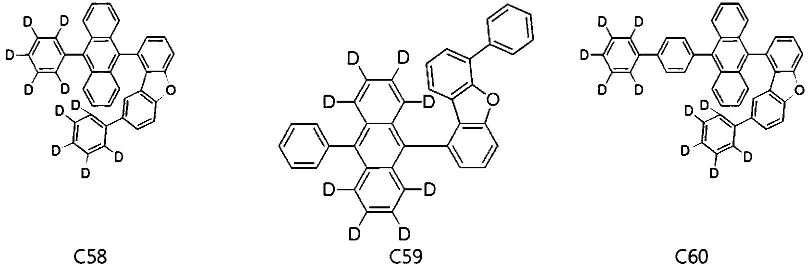

Meanwhile, the specific structure of the organic light-emitting device according to an embodiment of the present invention, the method of manufacturing the same, and respective organic layer materials will be described as follows.

First, a substrate is coated with a material for an anode to form the anode. The substrate used herein is a substrate generally used for organic light-emitting devices and is preferably an organic substrate or a transparent plastic substrate that has excellent transparency, surface evenness, handleability and waterproofness. In addition, a material for the anode is indium tin oxide (ITO), indium zinc oxide (IZO), tin oxide (SnO₂), zinc oxide (ZnO), or the like, which is transparent and has excellent conductivity.

A hole injection layer is formed on the anode by vacuum thermal evaporation or spin coating using a material for the hole injection layer, and then a hole transport layer is formed on the hole injection layer by vacuum thermal evaporation or spin coating using a material for the hole transport layer.

The material for the hole injection layer may be used without particular limitation as long as it is commonly used in the art and specific examples thereof include 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], DNTPD [N,N'-diphenyl-N,N'-bis-[4-(phenyl-m-tolyl-amino)-phenyl]-biphenyl-4,4'-diamine], and the like.

In addition, the material for the hole transport layer is also used without particular limitation as long as it is commonly used in the art and is, for example, N,N'-bis(3-methylphenyl)-N,N'-diphenyl-[1,1-biphenyl]-4,4'-diamine (TPD) or N,N'-di(naphthalen-1-yl)-N,N'-diphenylbenzidine (α-NPD).

Subsequently, a hole auxiliary layer and a light-emitting layer are sequentially stacked on the hole transport layer, and a hole blocking layer is selectively deposited on the light-emitting layer by vacuum deposition or spin coating to form a thin film. Because the lifetime and efficiency of the device are reduced when holes are introduced into the cathode through the organic light-emitting layer, the hole blocking layer is formed using a material having a very low HOMO (highest occupied molecular orbital) level so as to prevent this problem. The hole blocking material used herein is not particularly limited and is typically BAlq, BCP or TPBI that has an electron transport ability and has an ionization potential higher than that of a light-emitting compound.

The material used for the hole blocking layer may be BAlq, BCP, Bphen, TPBI, NTAZ, BeBq₂, OXD-7, Liq, or the like, but is not limited thereto.

An electron transport layer is deposited on the hole blocking layer through vacuum deposition or spin coating and a metal for forming a cathode is formed on the electron injection layer through vacuum thermal evaporation to form a cathode. As a result, an organic light-emitting device according to an embodiment is completed.

Here, the metal for forming the cathode may be lithium (Li), magnesium (Mg), aluminum (Al), aluminum-lithium (Al-Li), calcium (Ca), magnesium-indium (Mg-In), magnesium-silver (Mg-Ag) or the like. A transmissive cathode using ITO or IZO may be used in order to obtain a top-emission type light-emitting device.

The material for the electron transport layer functions to stably transport electrons injected from the cathode and may be a well-known electron transport material. Examples of the well-known electron transport material include quinoline derivatives, especially, tris(8-quinolinolate)aluminum (Alq3), TAZ, BAlq, beryllium bis(benzoquinolin-10-olate: Bebq2) and oxadiazole derivatives (PBD, BMD, BND, etc.).

In addition, each of the organic layers may be formed by a monomolecular deposition or solution process. The deposition is a method of forming a thin film by evaporating a material for forming each layer through heating in the presence of a vacuum or low pressure and the solution process is a method of forming a thin film by mixing a material for forming each layer with a solvent and forming the thin film from the mixture through a method such as inkjet printing, roll-to-roll coating, screen printing, spray coating, dip coating, or spin coating.

In addition, the organic light-emitting device according to the present invention may further include a light-emitting layer of a blue light-emitting material, a green light-emitting material, or a red light-emitting material that emits light in a wavelength range of 380 nm to 800 nm. That is, the light-emitting layer of the present invention includes a plurality of light-emitting layers, and a blue light-emitting material, a green light-emitting material, or a red light-emitting material in the additionally formed light-emitting layer may be a fluorescent material or a phosphorescent material.

In addition, the organic light-emitting device is used for a display or lighting system selected from flat panel displays, flexible displays, monochromatic or white flat panel lighting systems, monochromatic or white flexible lighting systems, vehicle displays, and displays for virtual or augmented reality.

Hereinafter, the present invention will be described in more detail with reference to preferred examples. However, it will be obvious to those skilled in the art that these examples are merely provided for illustration of the present invention, and should not be construed as limiting the scope of the present invention.

### Synthesis Example 1. Synthesis of Compound 35

### Synthesis Example 1-1. Synthesis of <Intermediate 35-2>

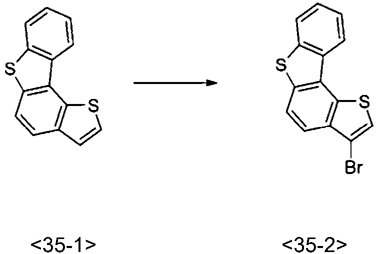

35-1 (50.0 g) synthesized with reference to the prior literature (Journal of Heterocyclic Chemistry (1984), 21(1), 185-92) and DMF (250 mL) were added to a reactor, followed by cooling to 0°C. N-bromosuccinimide (37.0 g) was added thereto, followed by stirring for 12 hours. The reaction product was warmed to room temperature, followed by stirring for 48 hours, cooling to 0°C, and adding saturated aqueous sodium hydrogen carbonate solution (100 mL) thereto. The organic layer was extracted with ethyl acetate, concentrated under reduced pressure, and then 35-2 was separated by silica gel column chromatography. (31 g, yield 46.7%)
MS (ESI) calcd for Chemical Formula: C₁₄H₈BrS₂ (Pos)318.93, found 318.9

### Synthesis Example 1-2. Synthesis of <Intermediate 35-5>

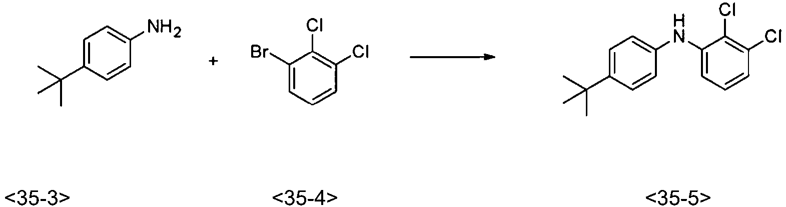

35-3 (66.1 g), 35-4 (100.0 g), palladium acetate (II) (1.99 g), and (±)-2,2'-bis(diphenylphosphino)-1,1'-binaphthalene were added to a reactor (5.51 g), sodium tert-butoxide (85.1 g), and toluene (1,000 mL) were added thereto, and the mixture was stirred under reflux for 6 hours. The reaction product was cooled to room temperature and then water (300 mL) was added thereto. The organic layer was extracted with ethyl acetate, concentrated under reduced pressure, and then 35-5 was separated by silica gel column chromatography. (119 g, yield 91.8%)
MS (ESI) calcd for Chemical Formula: C₁₆H₁₈Cl₂N (Pos)294.08, found 294.0

### Synthesis Example 1-3. Synthesis of <Intermediate 35-6>

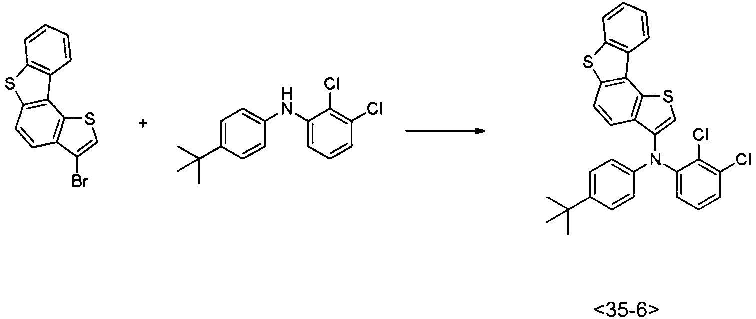

35-2 (32.9 g), 35-5 (30.0 g), tris (dibenzylideneacetone) dipalladium (0) (3.55 g), tri-tert-butylphosphonium tetrafluoroborate (3.55 g), sodium tert-butoxide (19.6 g) and toluene (300 mL) were added to a reactor, followed by stirring under reflux for 12 hours. The reaction product was cooled to room temperature and then water (100 mL) was added thereto. The organic layer was extracted with ethyl acetate, concentrated under reduced pressure, and then 35-6 was separated by silica gel column chromatography. (41.9 g, yield 77.2%)
MS (ESI) calcd for Chemical Formula: C₃₀H₂₄Cl₂NS₂ (Pos)532.07, found 532.0

### Synthesis Example 1-4. Synthesis of <Intermediate 35-8>

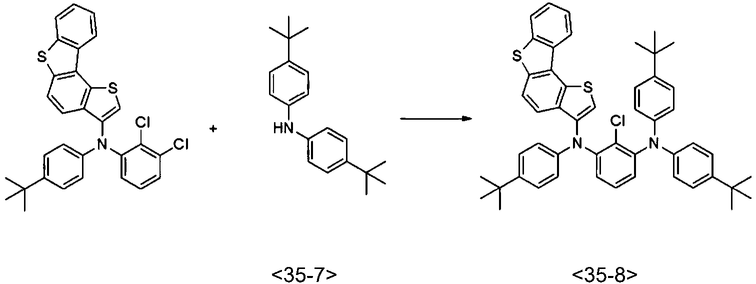

35-6 (25.0 g), 35-7 (15.9 g), bis(tri-tert-butylphosphine)palladium(0) (0.48 g), sodium tert-butoxide (9.0 g), and toluene (250 mL) were added to a reactor, followed by stirring under reflux for 12 hours. The reaction product was cooled to room temperature and then water (100 mL) was added thereto. The organic layer was extracted with ethyl acetate, concentrated under reduced pressure, and then 35-8 was separated by silica gel column chromatography. (29.1 g, yield 79.7%)
MS (ESI) calcd for Chemical Formula: C₅₀H₅₀ClN₂S₂ (Pos)777.31, found 777.3

### Synthesis Example 1-5. Synthesis of Compound 35

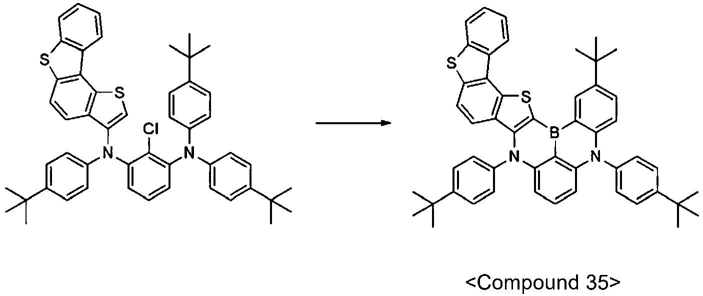

35-8 (20.0 g) and tert-butylbenzene (200 mL) were added to a reactor, and then 1.7 M tert-butyllithium (45.4 mL) was added dropwise at -60°C. The reaction product was heated to 60°C and was then stirred for 2 hours. After cooling to -60°C, boron tribromide (4.9 mL) was added dropwise thereto. The reaction product was warmed to room temperature, followed by stirring for 1 hour, cooling to 0°C, and dropwise addition of 9.0 mL of N,N-diisopropylethylamine. The reaction product was heated to 120°C and then was stirred for 12 hours. After cooling to room temperature, water (84 mL) and sodium acetate (4.2 g) were added thereto. The organic layer was extracted with ethyl acetate, concentrated under reduced pressure, and then compound 35 was separated by silica gel column chromatography. (2.1 g, yield 10.9%)
MS (ESI) calcd for Chemical Formula: C₅₀H₄₈BN₂S₂ (Pos)751.34, found 751.3

### Synthesis Example 2. Preparation of Compound 251

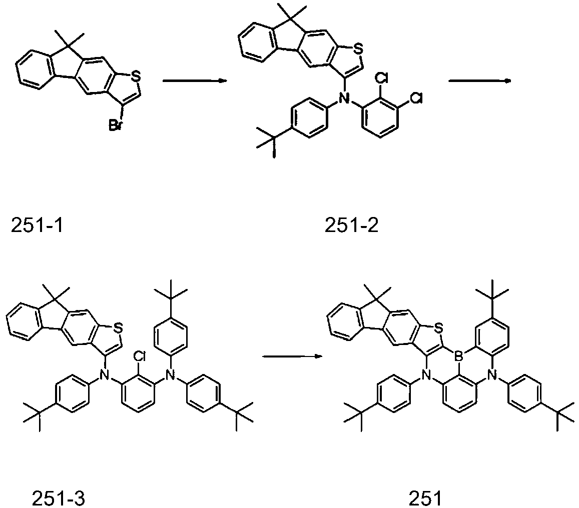

Compound 251 (15.3%) was synthesized in the same manner as in Synthesis Example 1, except that Intermediate 251-1 synthesized by the method described in the prior literature (Chinese Patent Publication No. CN111303149A) was used instead of Intermediate 35-2.
MS (ESI) calcd for Chemical Formula: C₅₃H₅₄BN₂S (Pos)761.41, found 761.4

### Synthesis Example 3. Preparation of Compound 252

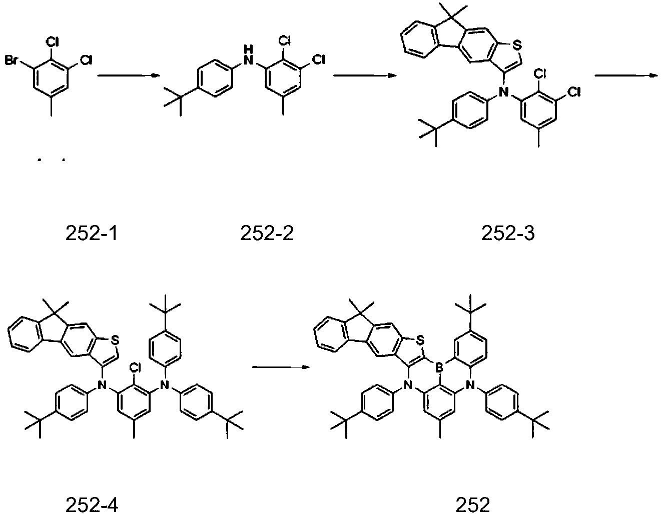

Compound 252 (23.4%) was synthesized from Intermediate 252-4 in the same manner as in Synthesis Example 2, except that Intermediate 252-1 was used instead of Intermediate 35-4. MS (ESI) calcd for Chemical Formula: C₅₄H₅₆BN₂S (Pos)775.43, found 775.4

### Synthesis Example 4. Preparation of Compound 255

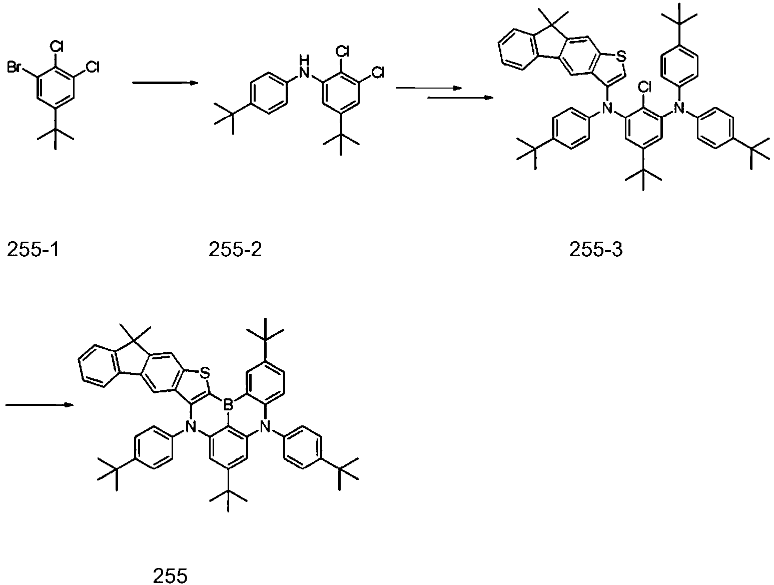

Compound 255 (14.8%) was synthesized from Intermediate 255-3 in the same manner as in Synthesis Example 2, except that Intermediate 255-1 was used instead of Intermediate 35-4. MS (ESI) calcd for Chemical Formula: C₅₄H₅₆BN₂S (Pos)817.47, found 817.4

### Synthesis Example 5. Preparation of Compound 279

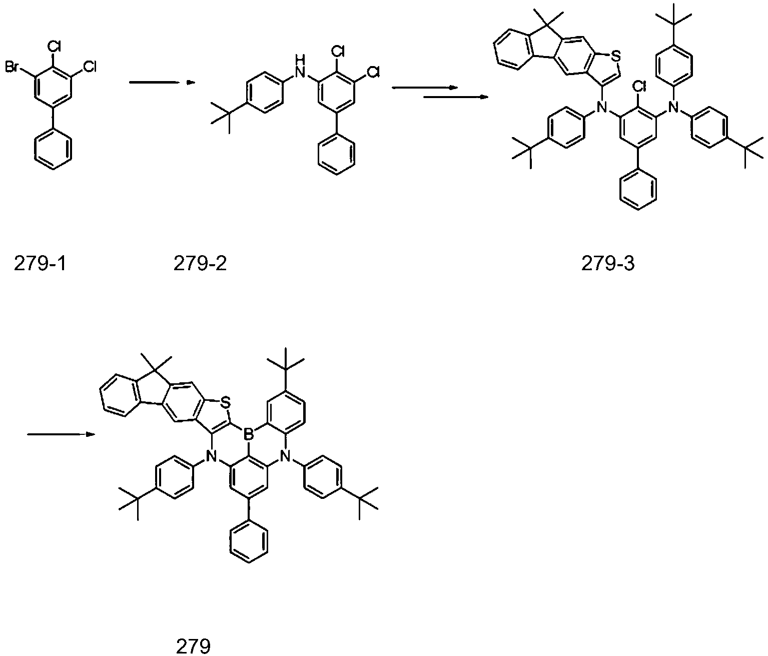

Compound 279 (12.4%) was synthesized from Intermediate 279-3 in the same manner as in Synthesis Example 2, except that Intermediate 279-1 was used instead of Intermediate 35-4. MS (ESI) calcd for Chemical Formula: C₅₄H₅₆BN₂S (Pos)837.44, found 837.4

### Synthesis Example 6. Preparation of Compound 341

### (1) Synthesis of Intermediate 341-3

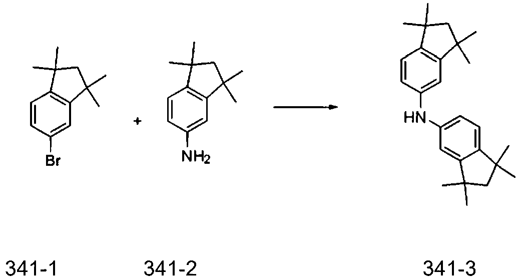

Intermediate 341-3 (yield 83.1%) was obtained from Intermediate 341-1 and Intermediate 341-2 using the synthesis method described in the prior literature (Tetrahedron, 2014, vol. 70, #32, p.4754 - 4759).
MS (ESI) calcd for Chemical Formula: C₂₆H₃₆N (Pos)362.29, found 362.2

### (2) Synthesis of Compound 341

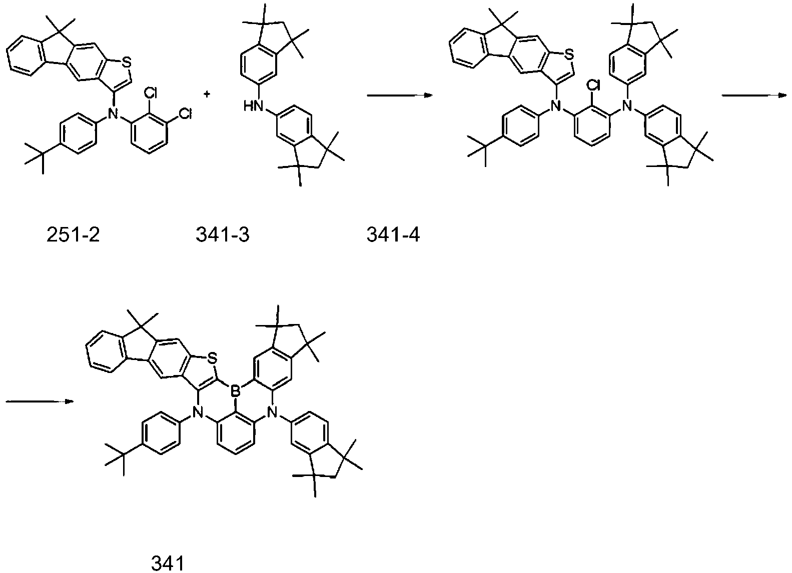

Compound 341 (16.4%) was synthesized from Intermediate 341-4 in the same manner as in Synthesis Example 2, except that Intermediate 341-3 was used instead of Intermediate 35-7. MS (ESI) calcd for Chemical Formula: C₅₉H₆₂BN₂S (Pos)841.47, found 841.4

### Synthesis Example 7. Preparation of Compound 354

### (1) Synthesis of Intermediate 354-3

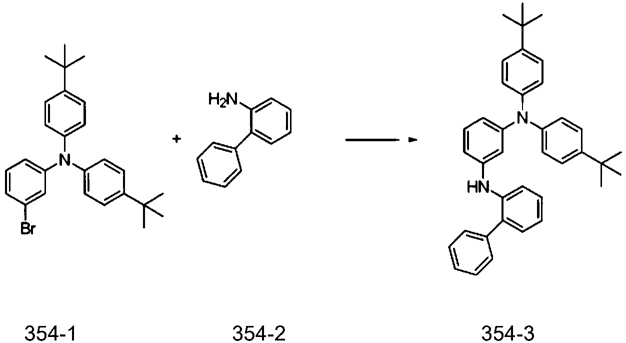

50.0 g of Intermediate 354-1 synthesized by the method described in the prior literature (Journal of Materials Chemistry C: Materials for Optical and Electronic Devices (2013), 1 (11), 2224-2232), 28.4 g of 354-2, 2.10 g of tris (dibenzylideneacetone)dipalladium (0), 1.43 g of bis(diphenylphosphino)-1,1'-binaphthyl, 22.0 g of sodium tert-butoxide, and toluene were stirred under reflux for 16 hours. The resulting mixture was cooled to room temperature, ethyl acetate and water were added thereto and the organic layer was separated and purified by silica gel chromatography to obtain Intermediate 354-3. (53.0 g, 88.2%)
MS (ESI) calcd for Chemical Formula: C₃₈H₄₁N₂ (Pos)525.33, found 525.3

### (2) Synthesis of Compound 354

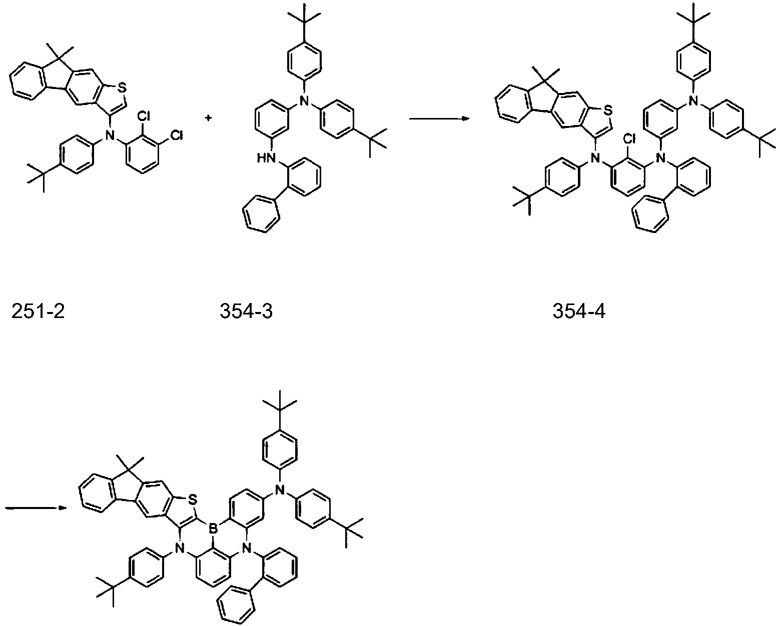

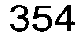

Compound 354 (11.9%) was synthesized from Intermediate 354-4 in the same manner as in Synthesis Example 2, except that Intermediate 354-3 was used instead of Intermediate 35-7.
MS (ESI) calcd for Chemical Formula: C₅₉H₆₂BN₂S (Pos)841.47, found 841.4

### Synthesis Example 8. Preparation of Compound 444

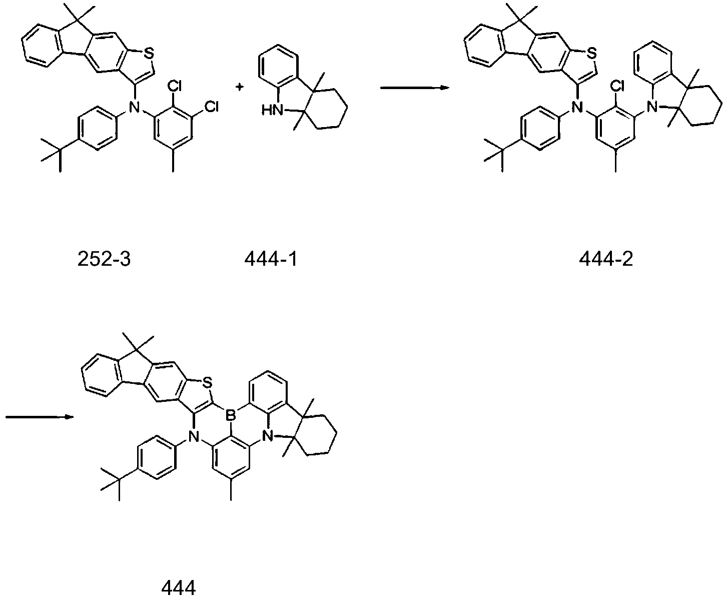

Compound 444 (11.9%) was synthesized from Intermediate 444-2 in the same manner as in Synthesis Example 3, except that Intermediate 444-1 synthesized using the method described in the prior literature (Korean Patent No. KR102149450) was used instead of Intermediate 35-7.
MS (ESI) calcd for Chemical Formula: C₅₉H₆₂BN₂S (Pos)695.37, found 695.3

### Synthesis Example 9. Preparation of Compound 472

### (1) Synthesis of Intermediate 472-2

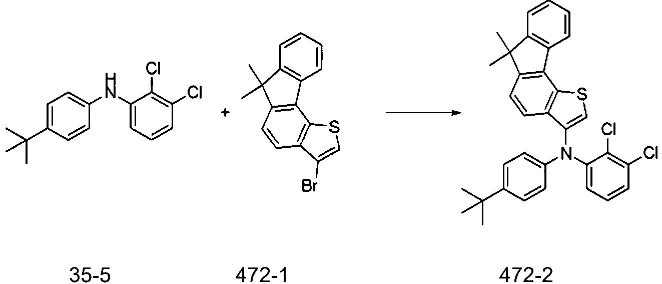

Compound 472-2 (87.7%) was synthesized from Intermediate 472-1 in the same manner as in Synthesis Example 1, except that Intermediate 472-1 synthesized by the method described in the prior literature (Chinese Patent No. CN111303149A) was used instead of Intermediate 35-2. MS (ESI) calcd for Chemical Formula: C₃₃H₃₀Cl₂NS (Pos)695.37, found 695.3

### (2) Synthesis of Compound 472

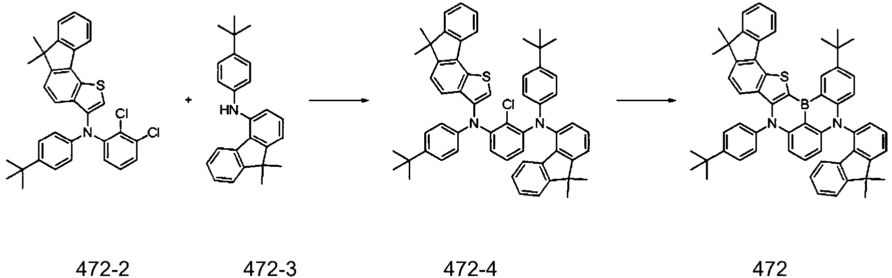

Compound 472 (13.9%) was synthesized from Intermediate 472-4 in the same manner as in Synthesis Example 1, except that Intermediate 472-2 was used instead of Intermediate 35-6 and Intermediate 472-3 synthesized by the method described in the prior literature (Korean Patent Publication No. KR201759015A) was used instead of Intermediate 35-7.
MS (ESI) calcd for Chemical Formula: C₅₈H₅₄BN₂S (Pos)821.41, found 821.4

### Synthesis Example 10. Preparation of Compound 474

### (1) Synthesis of Intermediate 474-2

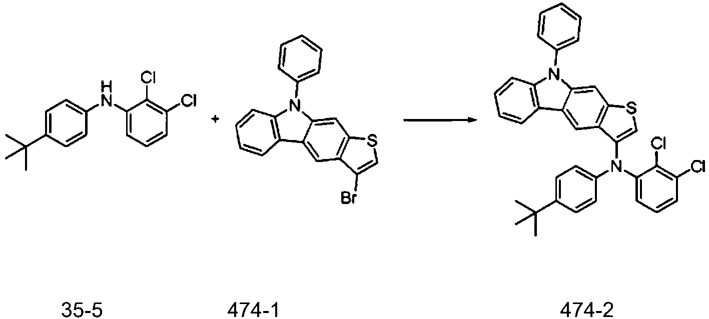

Compound 474-2 (92.4%) was synthesized from Intermediate 474-1 in the same manner as in Synthesis Example 1, except that Intermediate 474-1 synthesized by the method described in the prior literature (Chinese Patent No. CN111303149A) was used instead of Intermediate 35-2.
MS (ESI) calcd for Chemical Formula: C₃₆H₂₉Cl₂N₂S (Pos)591.15, found 591.1

### (2) Synthesis of Compound 474

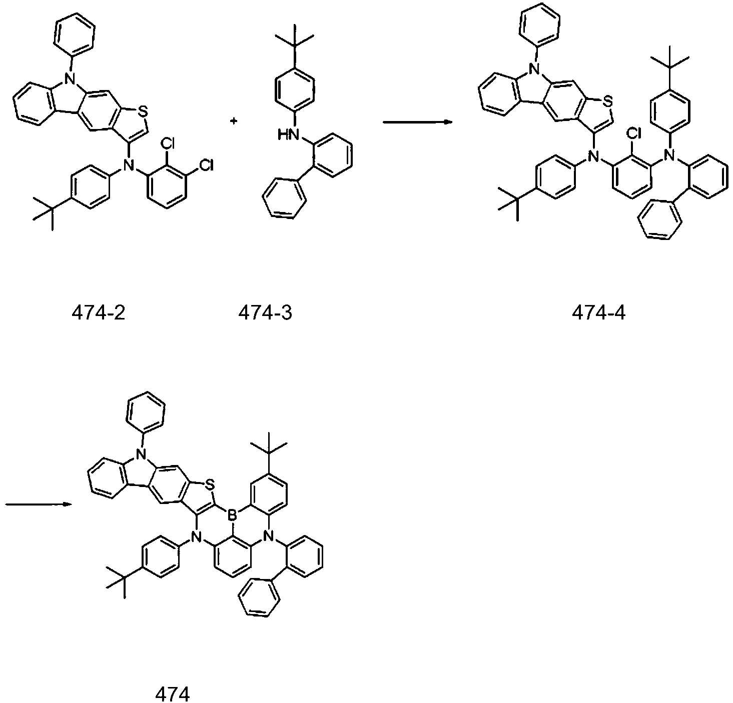

Compound 474 (12.7%) was synthesized from Intermediate 474-4 in the same manner as in Synthesis Example 1, except that Intermediate 474-2 was used instead of Intermediate 35-6 and Intermediate 474-3 synthesized by the method described in the prior literature (Chinese Patent Publication No. CN111303149A) was used instead of Intermediate 35-7.
MS (ESI) calcd for Chemical Formula: C₅₈H₄₉BN₃S (Pos)830.38, found 830.3

### Synthesis Example 11. Preparation of Compound 286

### (1) Synthesis of Intermediate 286-2

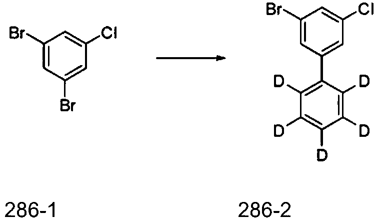

Compound 286-2 (65.3%) was synthesized from Intermediate 286-1 using the synthesis method described in the prior literature (Chinese Patent Publication No. CN110551154).
MS (ESI) calcd for Chemical Formula: C₁₂H₄D₅BrCl (Pos)271.99, found 271.9

### (2) Synthesis of Intermediate 286-3

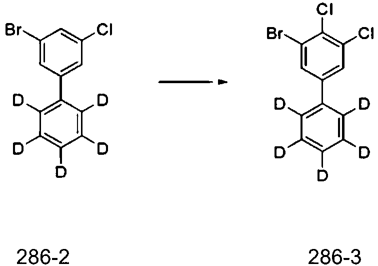

Intermediate 286-3 (73.6%) was synthesized from Intermediate 286-2 in the same manner as described in the prior literature (Chinese Patent Publication No. CN110551154) except that hexachloroethane was used instead of iodine.
MS (ESI) calcd for Chemical Formula: C₁₂H₃D₅BrCl₂ (Pos)305.95, found 305.9

### (3) Synthesis of Intermediate 286-6

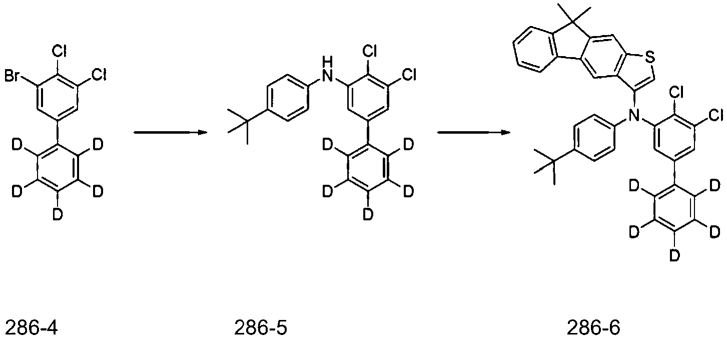

Compound 286-6 (90%) was synthesized from Intermediate 286-5 in the same manner as in Synthesis Example 2, except that Intermediate 286-4 was used instead of Intermediate 35-4.
MS (ESI) calcd for Chemical Formula: C₃₉H₂₉D₅Cl₂NS (Pos)623.21, found 623.2

### (4) Synthesis of Intermediate 286

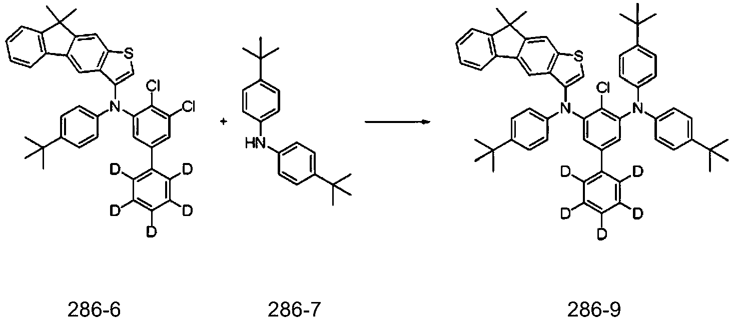

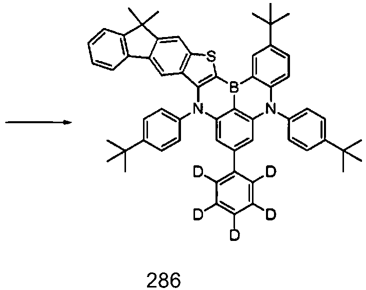

Compound 286 (12.8%) was synthesized from Intermediate 286-9 in the same manner as in Synthesis Example 1, except that Intermediate 286-6 was used instead of Intermediate 35-6.
MS (ESI) calcd for Chemical Formula: C₅₉H₅₃D₅BN₂S (Pos)842.47, found 842.4

### Synthesis Example 12. Preparation of Compound 292

### (1) Synthesis of Intermediate 292-4

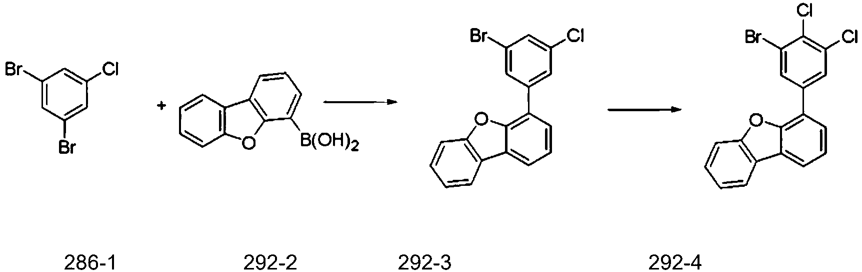

Intermediate 292-4 (77.7%) was synthesized from Intermediate 292-3 in the same manner as in Synthesis Example 11, except that Intermediate 292-2 was used instead of D5-phenyl boronic acid.
MS (ESI) calcd for Chemical Formula: C₁₈H₁₀BrCl₂O (Pos)390.93, found 390.9

### (2) Synthesis of Compound 292

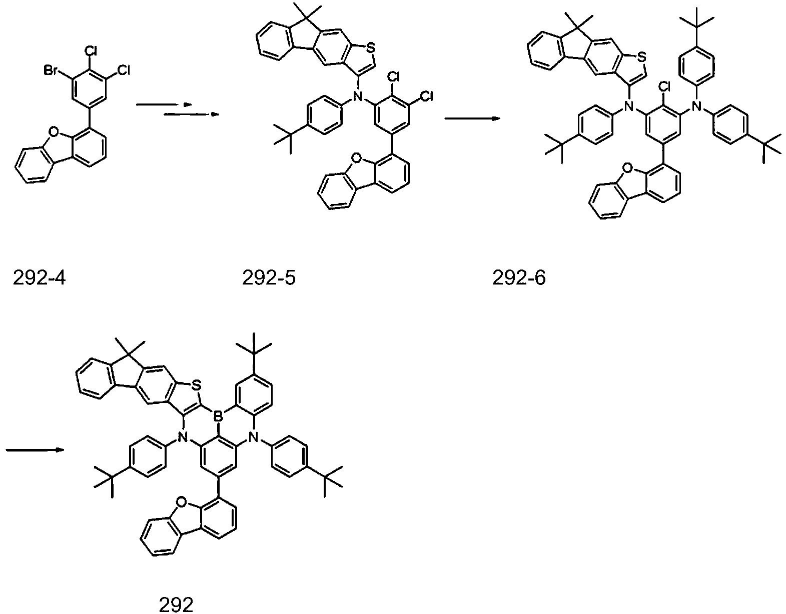

Compound 292 (9.4%) was synthesized from Intermediate 292-6 in the same manner as in Synthesis Example 11, except that Intermediate 292-4 was used instead of Intermediate 286-4.
MS (ESI) calcd for Chemical Formula: C₆₅H₆₀BN₂OS (Pos)927.45, found 927.4

### Synthesis Example 13. Preparation of Compound 303

### (1) Synthesis of Intermediate 303-3

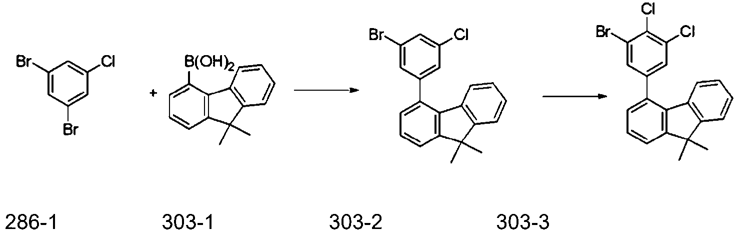

Intermediate 303-3 (81.2%) was synthesized from Intermediate 303-2 in the same manner as in Synthesis Example 11, except that Intermediate 303-1 was used instead of D5-phenyl boronic acid.
MS (ESI) calcd for Chemical Formula: C₂₁H₁₆BrCl₂ (Pos)416.98, found 416.9

### (2) Synthesis of Compound 303

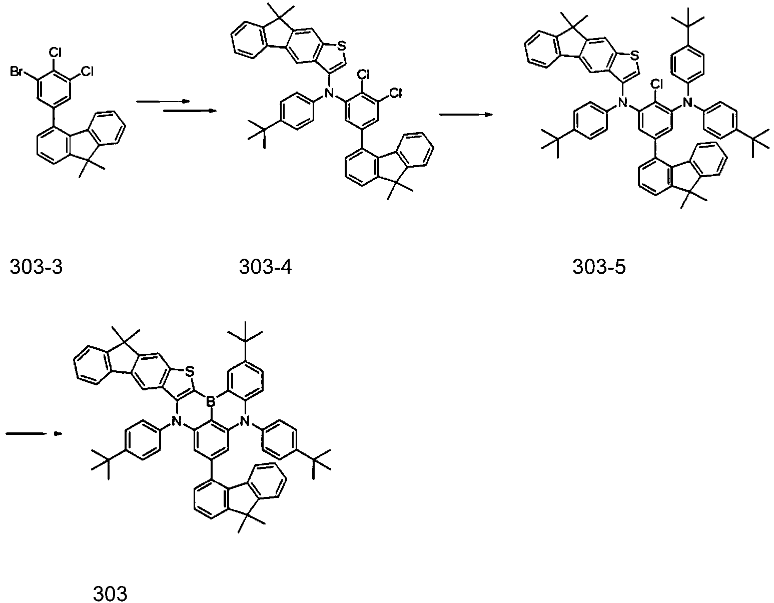

Intermediate 303 (11.8%) was synthesized from Intermediate 303-5 in the same manner as in Synthesis Example 11, except that Intermediate 303-3 was used instead of Intermediate 286-4.
MS (ESI) calcd for Chemical Formula: C₆₈H₆₆BN₂S (Pos)953.51, found 953.5

### Examples 1 to 10: Fabrication of organic light-emitting devices

ITO glass was patterned such that a light-emitting area of the ITO glass was adjusted to 2 mm × 2 mm and was then washed. The ITO glass was mounted in a vacuum chamber, a base pressure was set to 1 × 10⁻⁷ torr, and HAT-CN (700 Å) and [Formula G] (250 Å) were sequentially deposited on ITO. Then, a mixture (weight ratio of 98:2) of the compounds shown in [Table 1] as a host and a dopant was deposited to a thickness of 250Å to form a light-emitting layer. Then, a mixture (1:1) of [Formula E-1] and [Formula E-2] was deposited thereon to a thickness of 300Å to form an electron transport layer, [Formula E-1] was deposited thereon to a thickness of 5Å to form an electron injection layer, and Al was deposited thereon to a thickness of 1,000Å. As a result, an organic light-emitting device was fabricated. The luminous characteristics of the organic light-emitting device were measured at 0.4 mA.

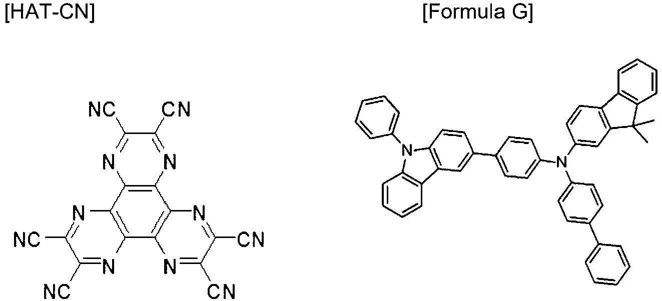

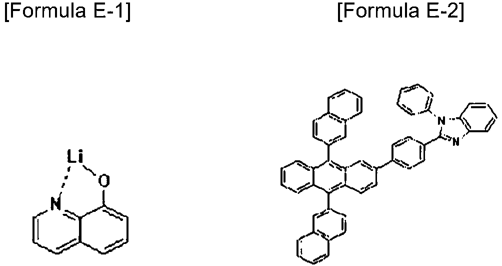

### Comparative Examples 1 to 2

Organic light-emitting devices were fabricated in the same manner as in Examples above, except that the host compound and the dopant compound described in Comparative Examples 1 and 2 of Table 1 below were used instead of the compound according to the present invention in the light-emitting layer in the device structure of Examples above. The luminous characteristics of the organic light-emitting device were measured at 0.4 mA. The structures of BH1, BH2, and BD1 used in Comparative Examples 1 and 2 are as follows.

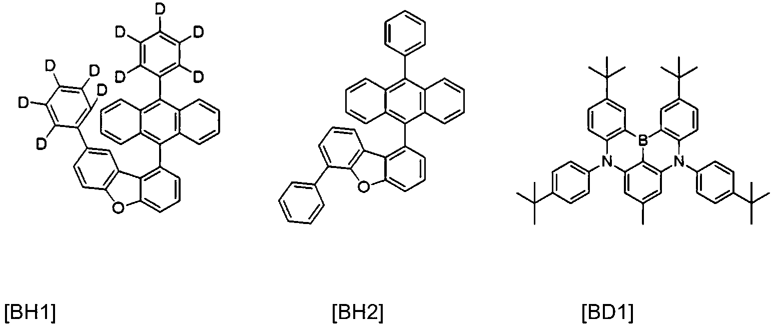

The voltage, external quantum efficiency, and lifespan of the organic light-emitting devices manufactured according to Examples 1 to 10 and Comparative Examples 1 to 2 were measured, and the results are shown in Table 1 below.

**[Table 1]**

| Item | Host | Dopant | Voltage (V) | External quantum efficiency (%) | Lifespan (LT97) |
|---|---|---|---|---|---|
| Example 1 | BH1 | Compound 35 | 3.5 | 9.11 | 200 |
| Example 2 | BH1 | Compound 111 | 3.5 | 9.54 | 120 |
| Example 3 | BH1 | Compound 143 | 3.5 | 8.77 | 105 |
| Example 4 | BH1 | Compound 168 | 3.5 | 9.38 | 100 |
| Example 5 | BH1 | Compound 169 | 3.5 | 9.07 | 170 |
| Example 6 | BH1 | Compound 279 | 3.5 | 9.39 | 210 |
| Example 7 | BH1 | Compound 288 | 3.5 | 8.96 | 183 |
| Example 8 | BH1 | Compound 341 | 3.5 | 8.92 | 172 |
| Example 9 | BH1 | Compound 424 | 3.5 | 9.23 | 256 |
| Example 10 | BH1 | Compound 472 | 3.5 | 9.05 | 210 |
| Comparative Example 1 | BH1 | BD1 | 3.5 | 7.56 | 111 |
| Comparative Example 2 | BH2 | BD1 | 3.5 | 6.37 | 57 |

As can be seen from [Table 1] above, the organic light-emitting device containing the polycyclic aromatic derivative compound or fused multimer thereof according to the present invention as a dopant compound for the light-emitting layer and a host compound having the characteristic structure according to the present invention exhibits remarkably improved external quantum efficiency and long lifespan, compared to organic light-emitting devices using the compound (Comparative Examples 1 and 2) having a characteristic structure different from the compound according to the present invention.

### Industrial Applicability

The polycyclic aromatic compound or fused multimer thereof according to the present invention can be used for an organic layer to realize a highly efficient organic light-emitting device and thus is applicable to displays or lighting systems selected from flat panel displays, flexible displays, monochromatic or white flat panel lighting systems, monochromatic or white flexible lighting systems, vehicle displays, displays for virtual or augmented reality and the like.

## Claims

1. A polycyclic aromatic compound represented by the following [Formula A-1] or [Formula A-2], or a fused multimer thereof having a plurality of unit structures represented by [Formula A-1] or [Formula A-2],
wherein the fused multimer has a structure in which the unit structures are bonded to each other whereby a ring included in the structure represented by [Formula A-1] or [Formula A-2] is shared, or the unit structures are bonded to each other whereby rings included in the structure represented by [Formula A-1] or [Formula A-2] are fused to each other, 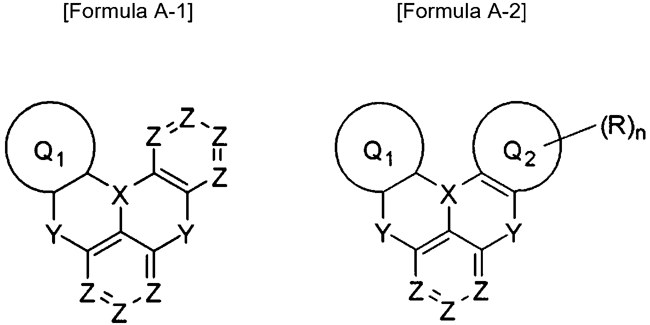
wherein
X is B, P, P=O, P=S or Al,
Y is selected from N-R₁, CR₂R₃, O, S, Se, and SiR₄R₅, with the proviso that Y's are identical to or different from each other,
Z is CR₆ or N, with the proviso that Z's and R₆'s are identical to or different from each other, R and R₁ to R₆ are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring, with the proviso that R and R₁ to R₆ are bonded to each other or each thereof is linked to an adjacent substituent to form an alicyclic or aromatic monocyclic or polycyclic ring, and the carbon atom of the formed alicyclic or aromatic monocyclic or polycyclic ring is substituted with at least one heteroatom selected from N, S and O, and
Q₁ and Q₂ are identical to or different from each other, and are each independently a substituted or unsubstituted C6-C50 aromatic hydrocarbon ring or a substituted or unsubstituted C2-C50 aromatic heterocyclic group.

2. The polycyclic aromatic compound or fused multimer thereof according to claim 1, wherein Q₁ is represented by the following [Structural formula 1]: 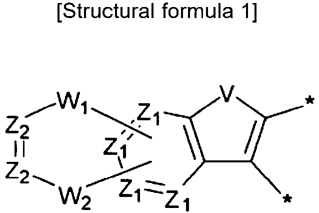
V is selected from NR₁, CR₂R₃, O, S, Se, and SiR₄R₅,
W₁ and W₂ are identical to or different from each other and are each independently selected from a single bond, NR₁, CR₂R₃, O, S, and SiR₄R₅, with the exception that both W₁ and W₂ are single bonds,
R₁ to R₅ are defined in [Formula A-1] or [Formula A-2] above,
two adjacent ones selected from a plurality of Z₁'s are respectively linked to W₁ and W₂, the others are N or CR₇, and Z₁'s and R₇'s are identical to or different from each other,
R₇'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring,
Z₂'s are each independently N or CR₈, with the proviso that Z₂'s and R₈'s are identical to or different from each other,
R₈'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring, with the proviso that R₈'s are bonded to each other or each thereof is linked to an adjacent substituent to form an alicyclic or aromatic monocyclic or polycyclic ring, and the carbon atom of the formed alicyclic or aromatic monocyclic or polycyclic ring is substituted with at least one heteroatom selected from N, S and O.

3. The polycyclic aromatic compound or fused multimer thereof according to claim 1, wherein Q₂ is represented by any one of the following [Structural Formula 1] to [Structural Formula 5]. 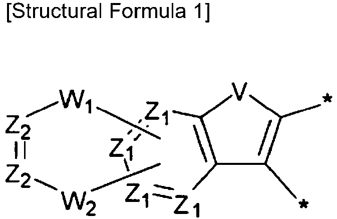 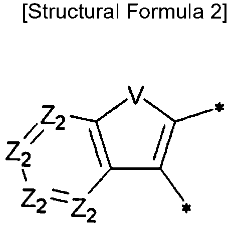 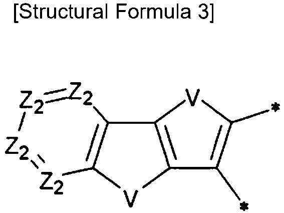 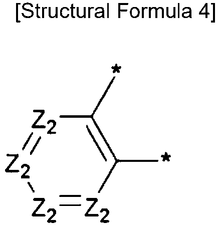 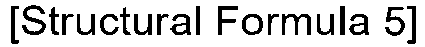 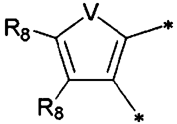 wherein
V is selected from NR₁, CR₂R₃, O, S, Se, and SiR₄R₅, with the proviso that V's in [Structural Formula 3] are identical to or different from each other,
W₁ and W₂ are identical to or different from each other, and are each independently a single bond, or are selected from NR₁, CR₂R₃, O, S, and SiR₄R₅, with the exception that both W₁ and W₂ are single bonds,
R₁ to R₅ are defined in [Formula A-1] or [Formula A-2],
two adjacent ones selected from Z₁'s are respectively linked to W₁ and W₂, and the others are N or CR₇, with the proviso that Z₁'s and R₇'s are identical to or different from each other, R₇'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic-aromatic ring,
Z₂'s are each independently N or CR₈, with the proviso that Z₂'s and R₈'s are identical to or different from each other, and
R₈'s are each independently selected from hydrogen, deuterium, a substituted or unsubstituted C1-C30 alkyl group, a C2-C24 alkenyl group, a C2-C24 alkynyl group, a substituted or unsubstituted C6-C50 aryl group, a substituted or unsubstituted C3-C30 cycloalkyl group, a substituted or unsubstituted C3-C30 cycloalkenyl group, a substituted or unsubstituted C1-C30 heterocycloalkyl group, a substituted or unsubstituted C1-C30 heteroalkyl group, a substituted or unsubstituted C1-C50 heteroaryl group, a substituted or unsubstituted C1-C30 alkoxy group, a substituted or unsubstituted C6-C30 aryloxy group, a substituted or unsubstituted C3-C30 cycloalkyloxy group, a substituted or unsubstituted C2-C30 heteroaryloxy group, a substituted or unsubstituted C1-C30 alkylthio group, a substituted or unsubstituted C6-C30 arylthio group, a substituted or unsubstituted C3-C30 cycloalkylthio group, a substituted or unsubstituted C2-C30 heteroarylthio group, a substituted or unsubstituted amine group, a substituted or unsubstituted silyl group, a nitro group, a cyano group, a halogen group, and a substituted or unsubstituted C3-C30 mixed aliphatic- aromatic ring, with the proviso that R₈'s are bonded to each other or each thereof is linked to an adjacent substituent to form an alicyclic or aromatic monocyclic or polycyclic ring, and the carbon atom of the formed alicyclic, aromatic monocyclic or polycyclic ring is substituted with at least one heteroatom selected from N, S and O.

4. The polycyclic aromatic compound or fused multimer thereof according to claim 1, wherein the polycyclic aromatic compound or fused multimer thereof is selected from compounds represented by the following [Compound 1] to [Compound 477]:

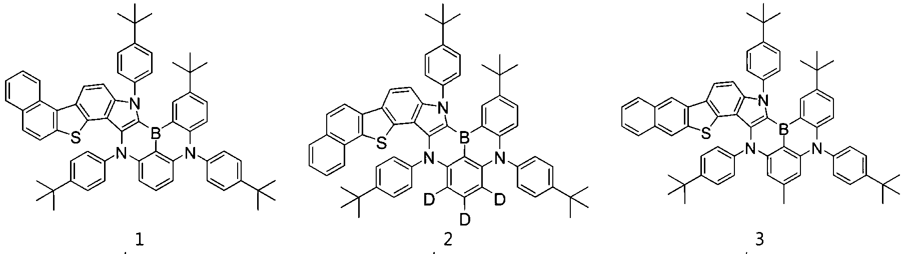

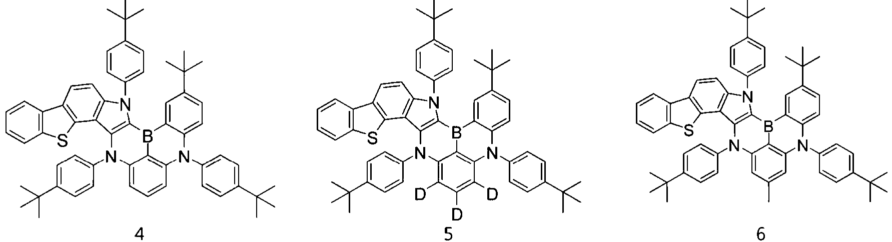

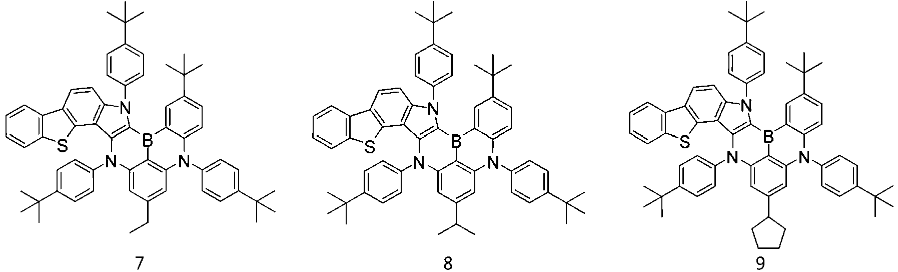

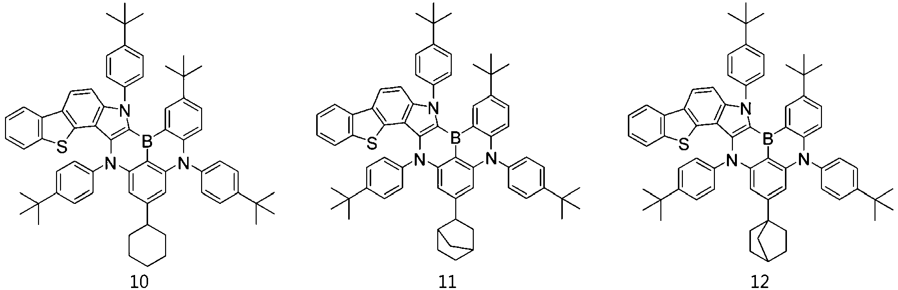

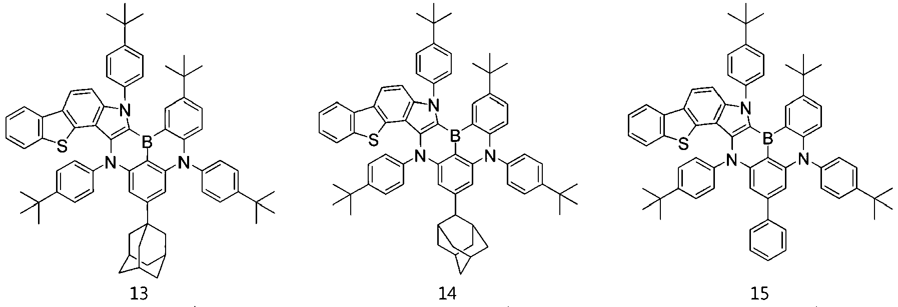

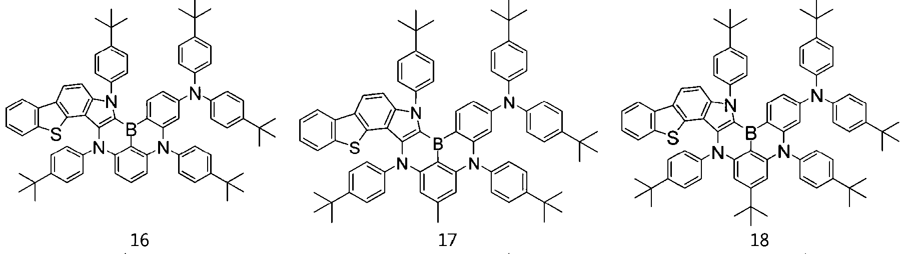

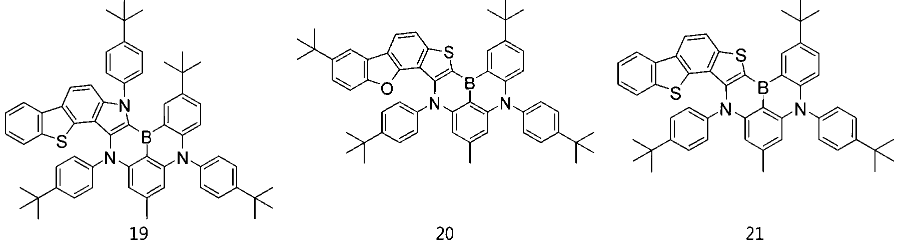

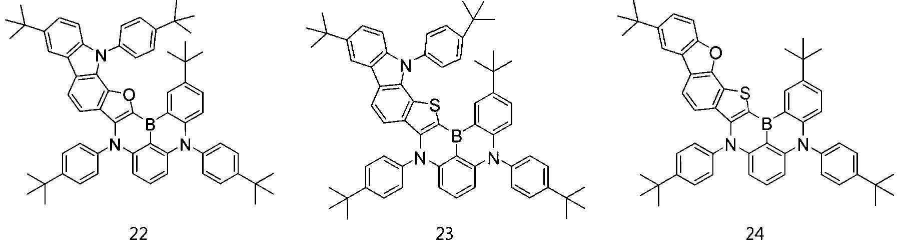

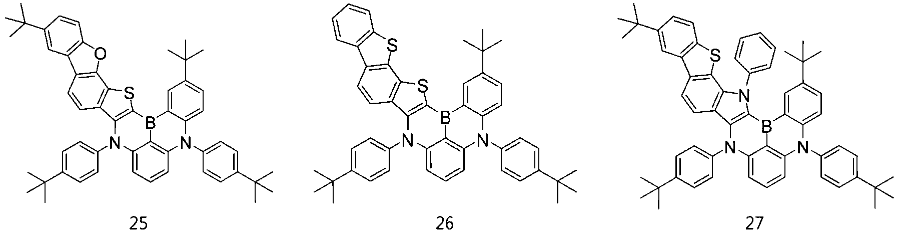

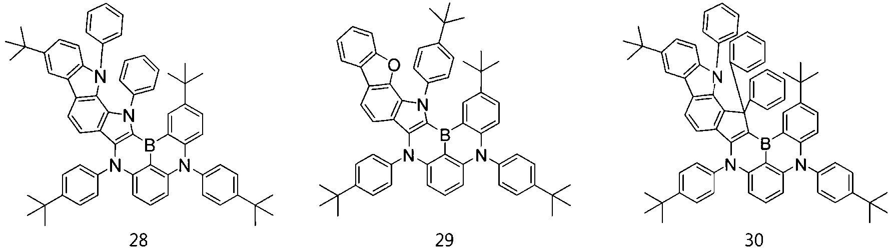

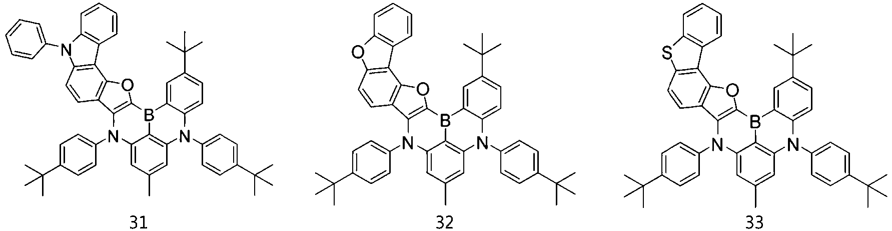

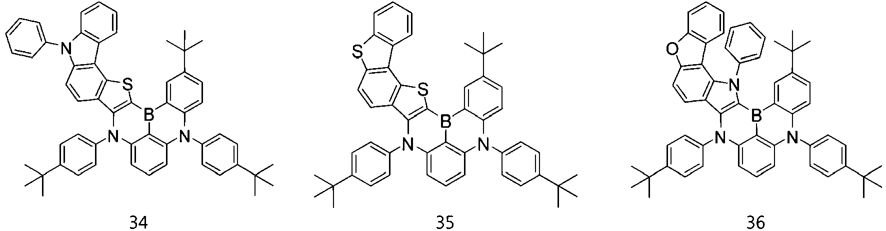

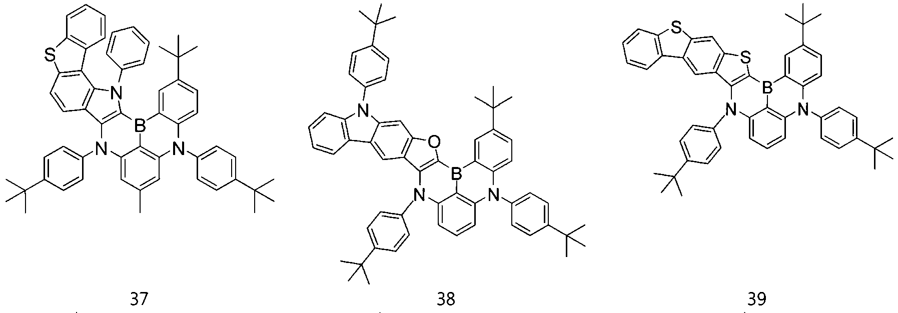

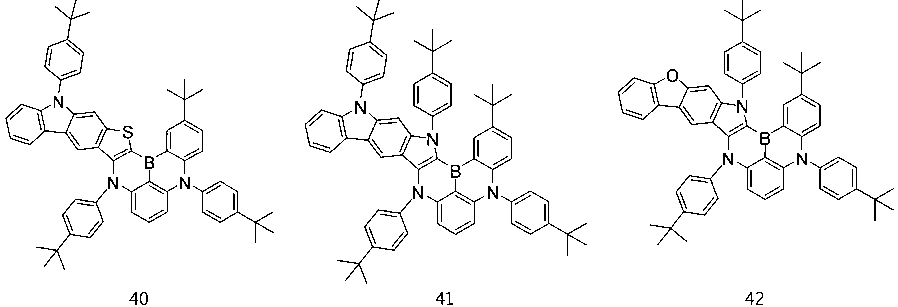

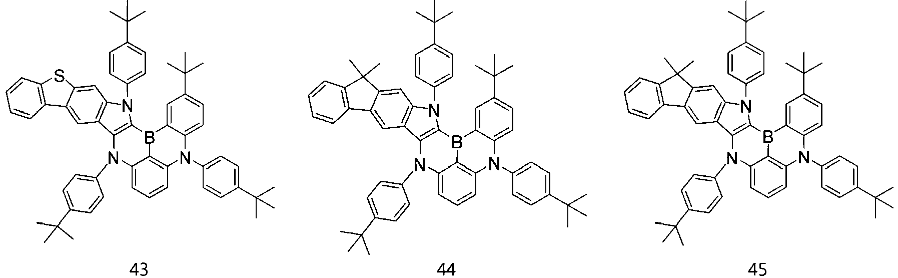

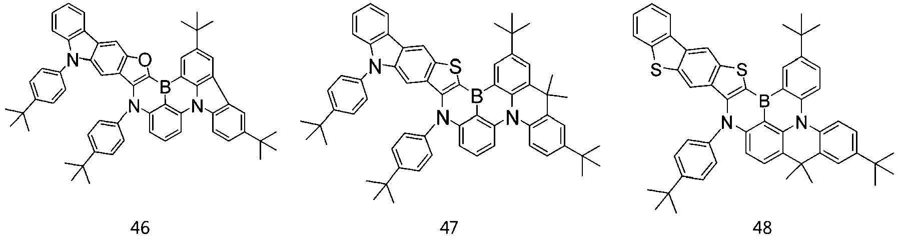

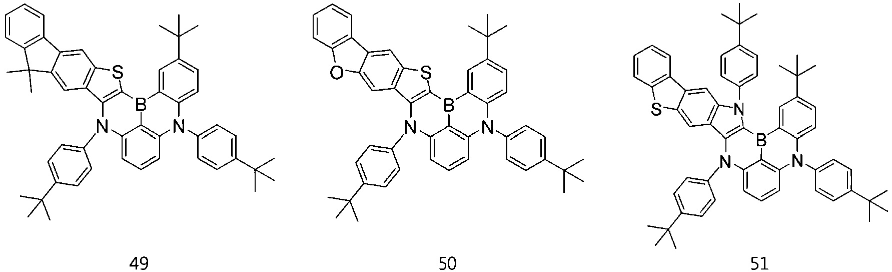

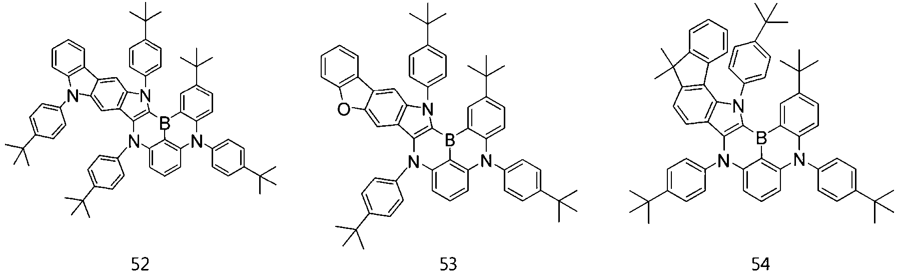

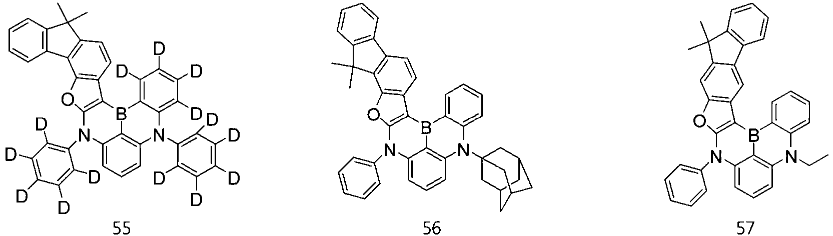

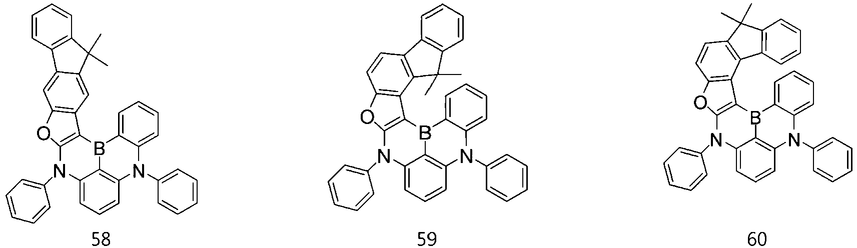

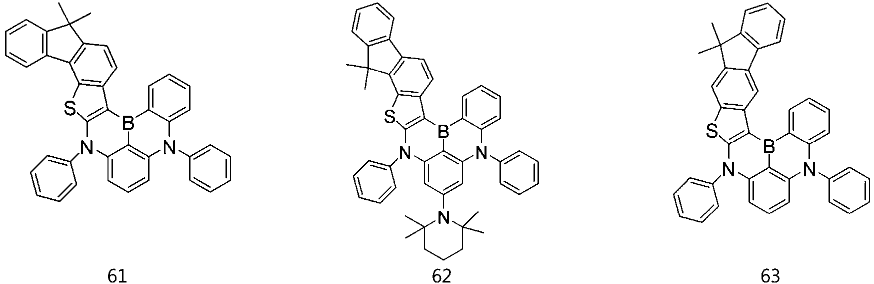

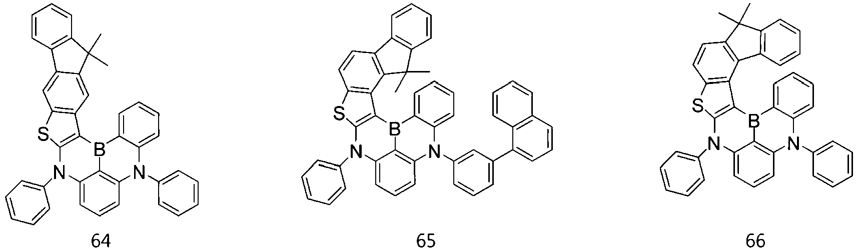

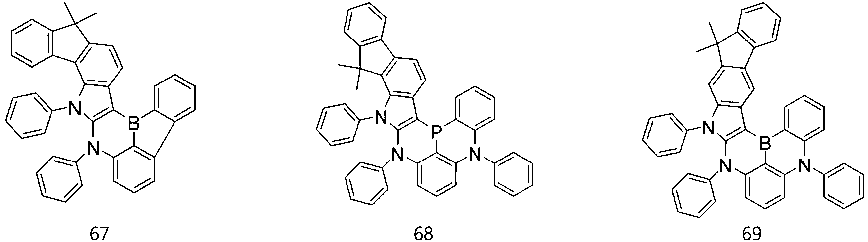

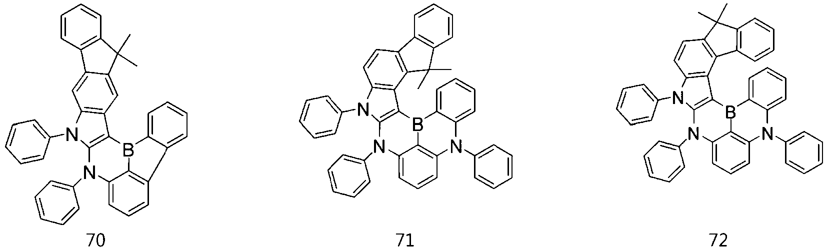

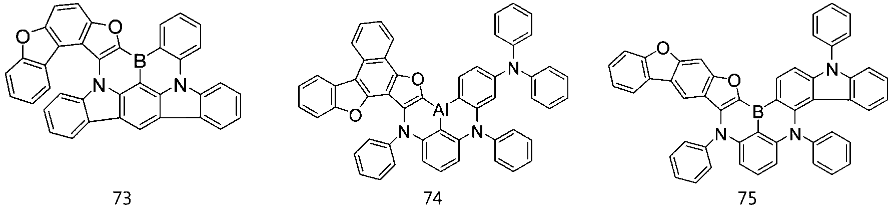

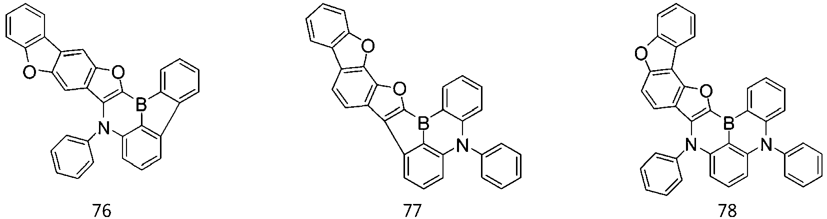

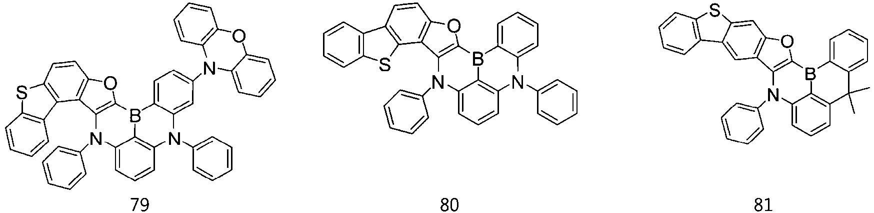

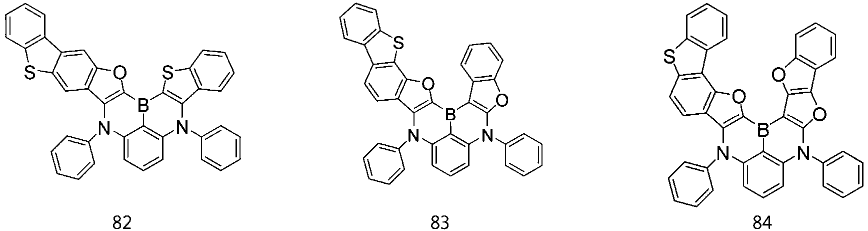

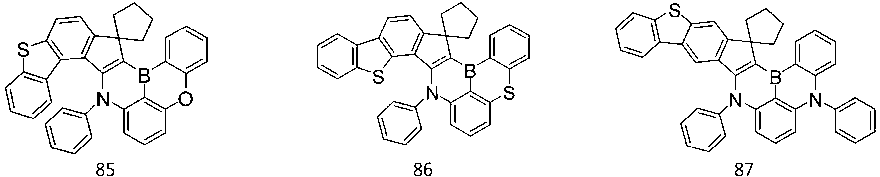

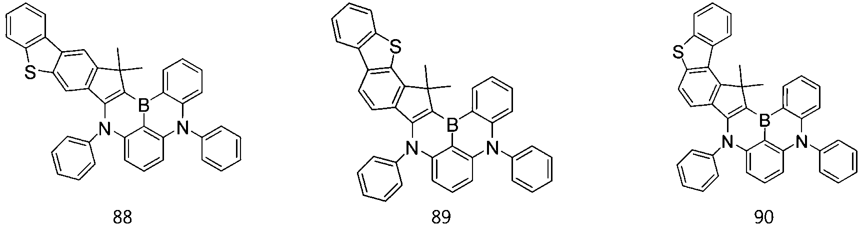

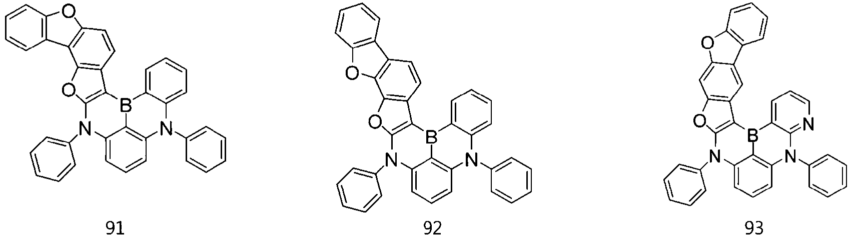

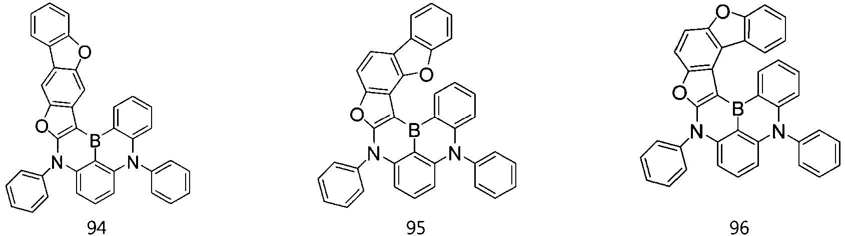

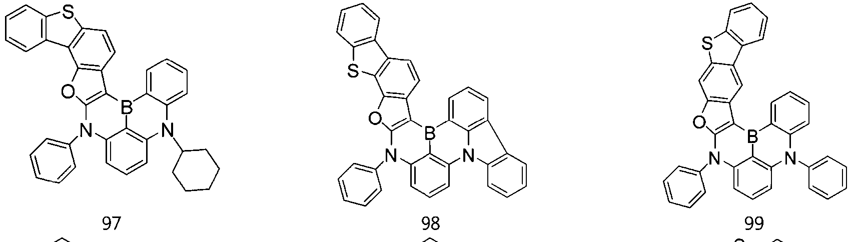

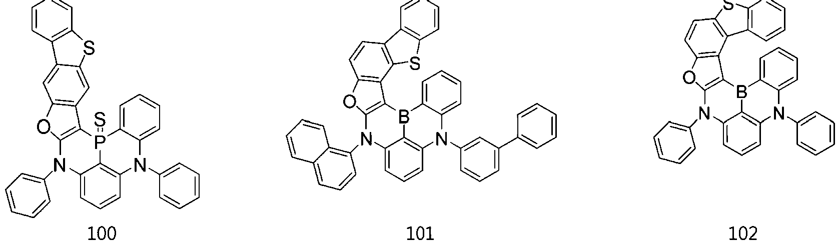

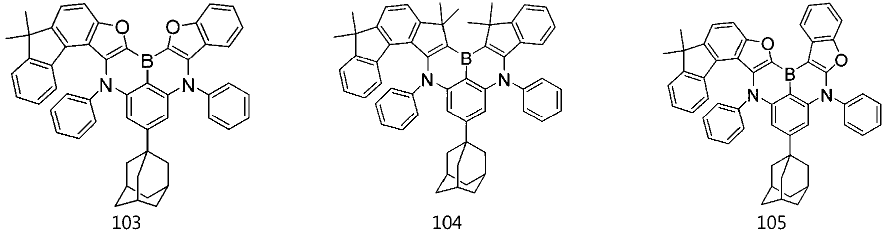

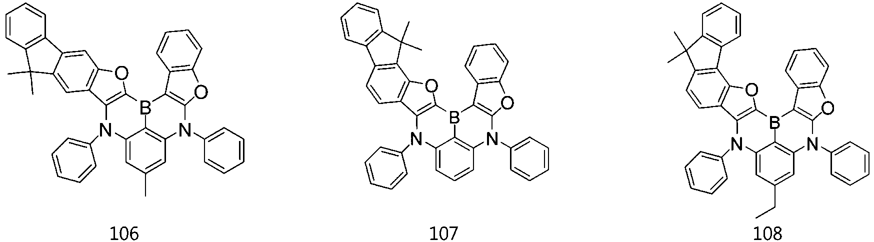

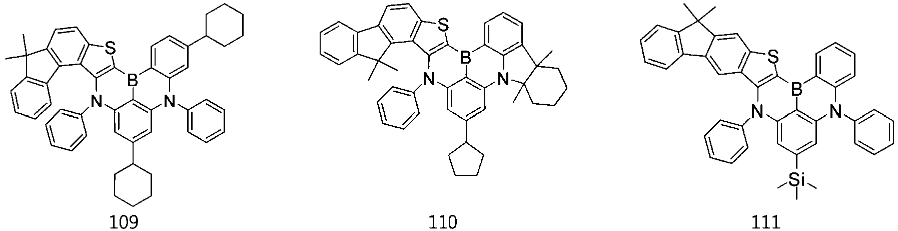

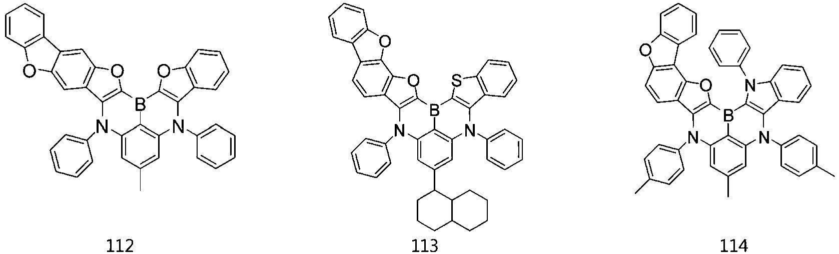

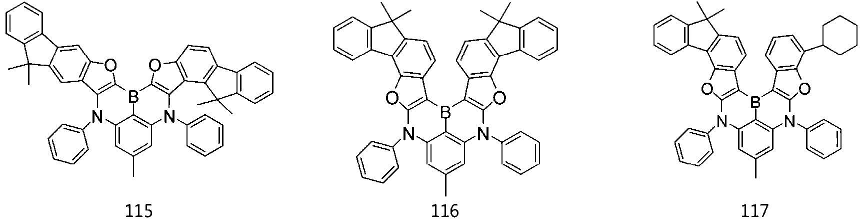

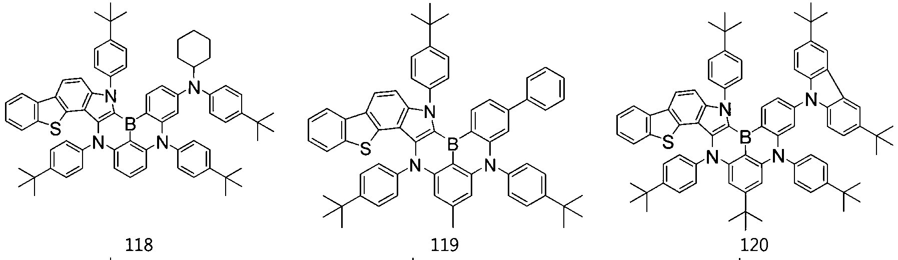

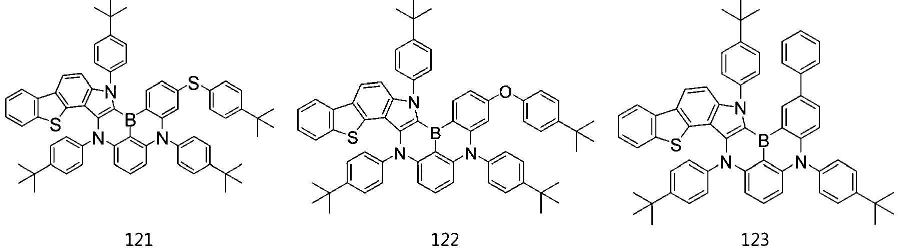

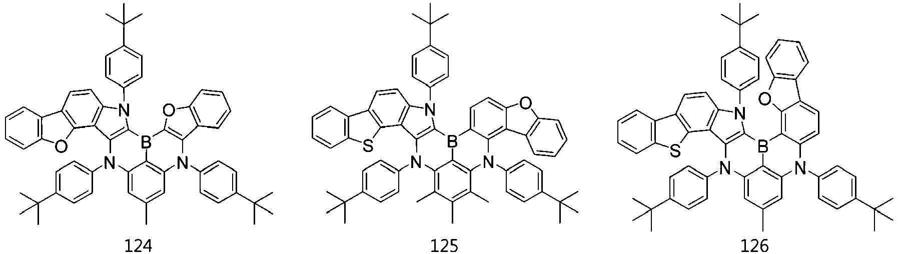

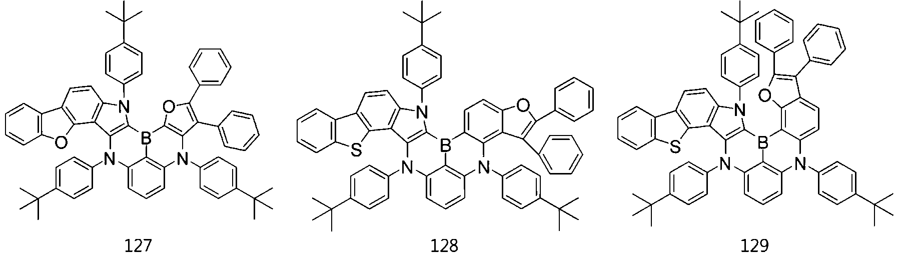

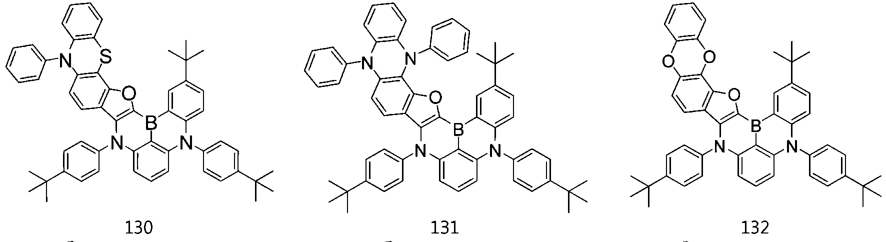

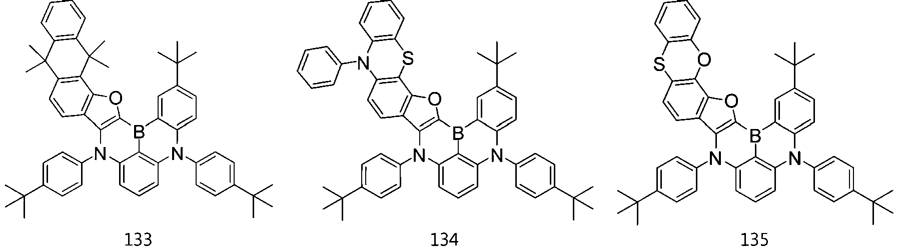

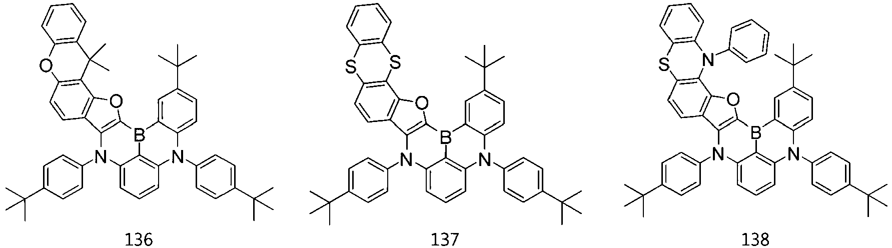

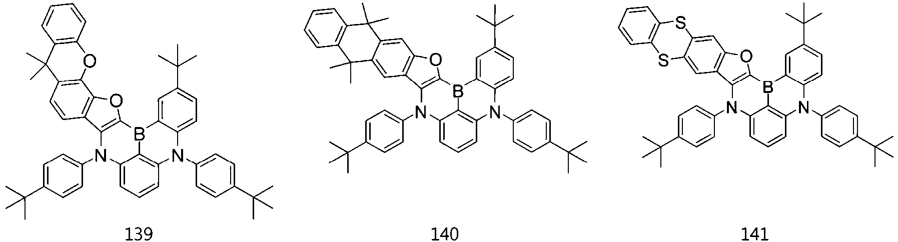

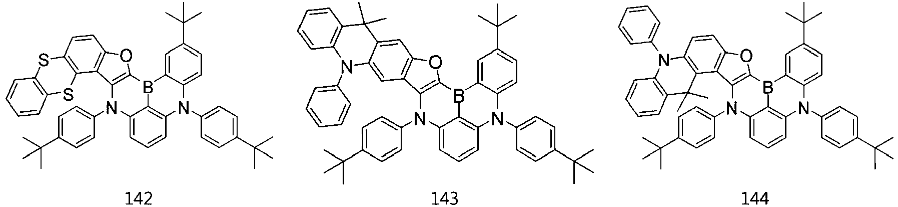

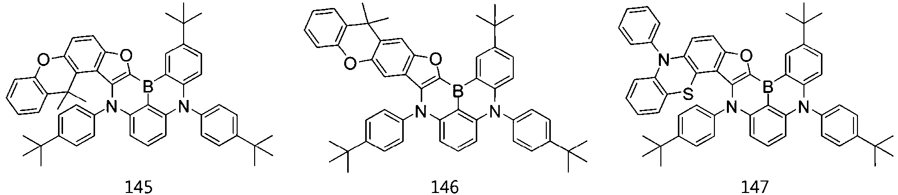

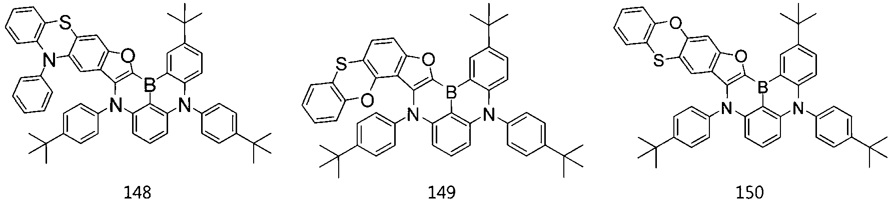

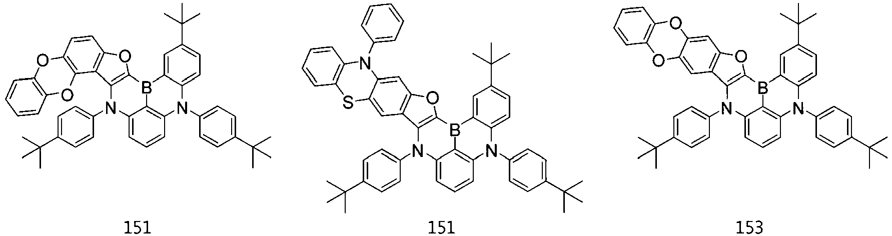

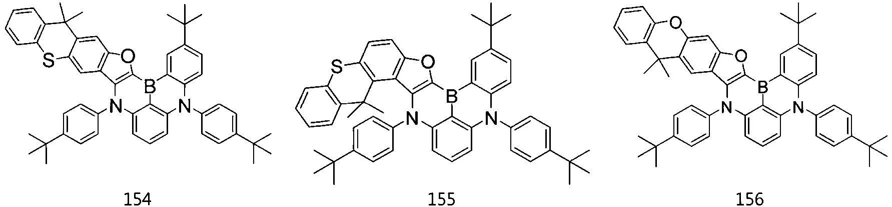

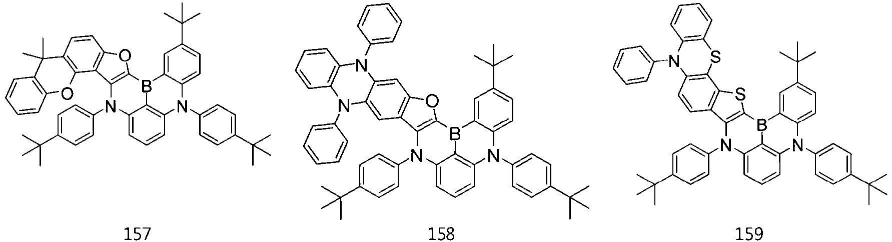

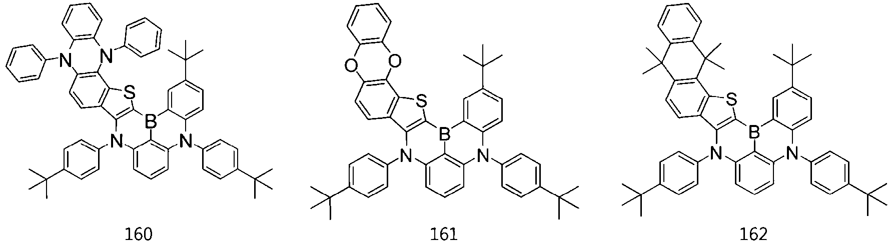

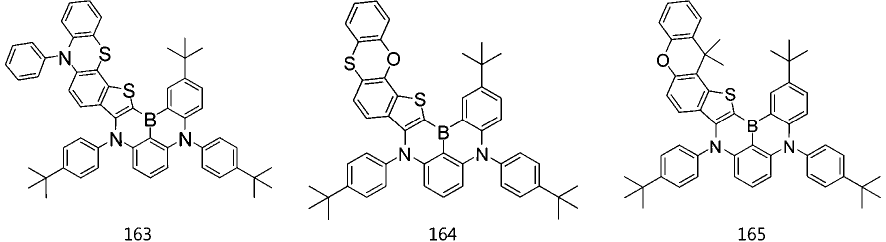

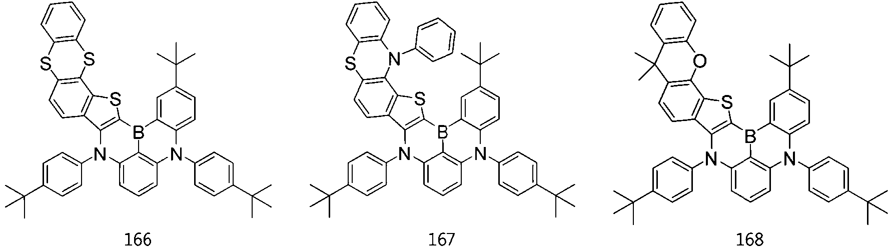

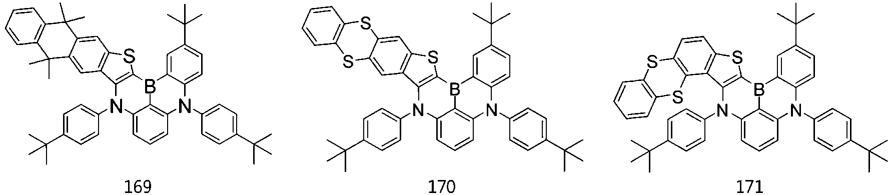

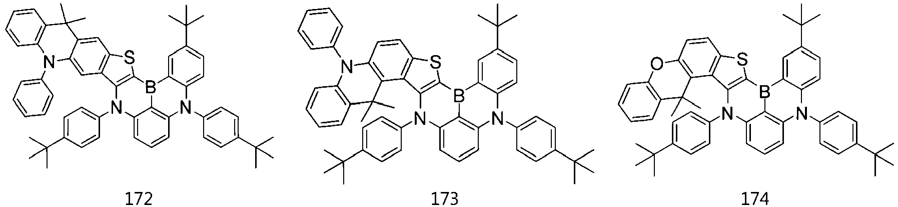

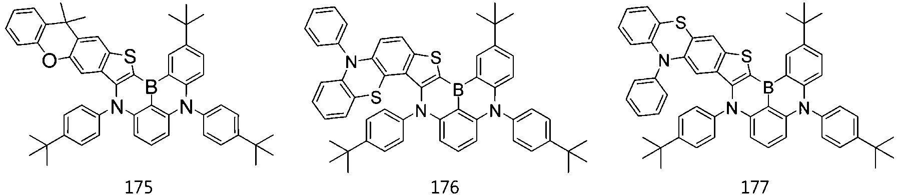

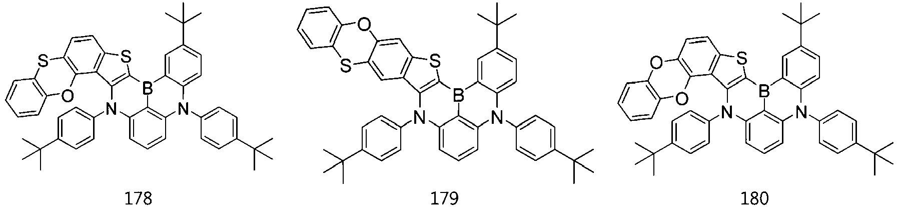

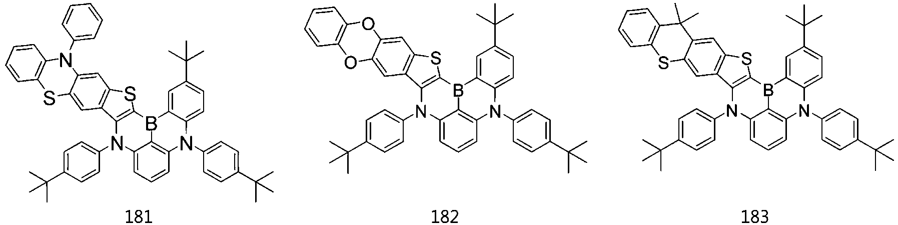

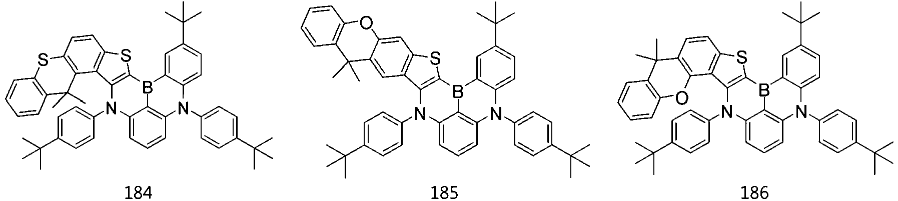

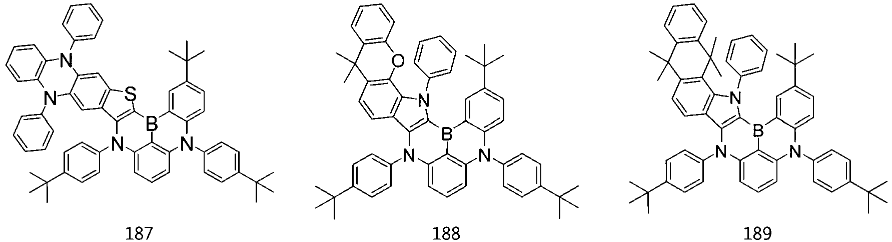

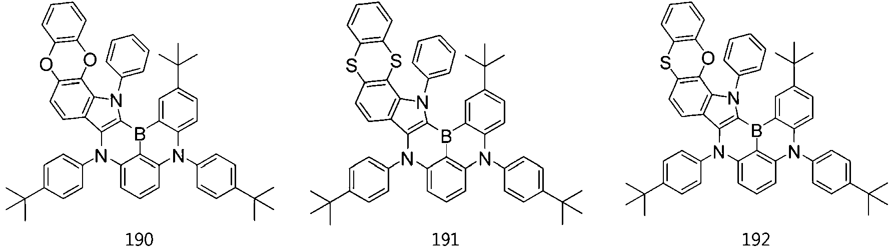

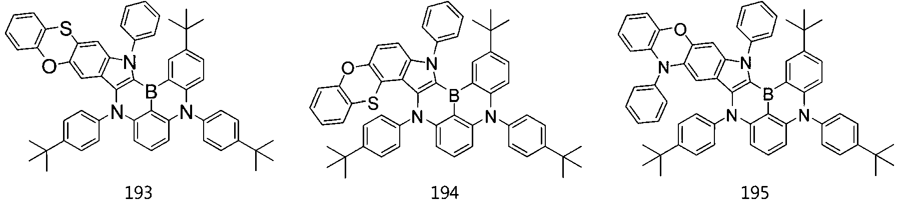

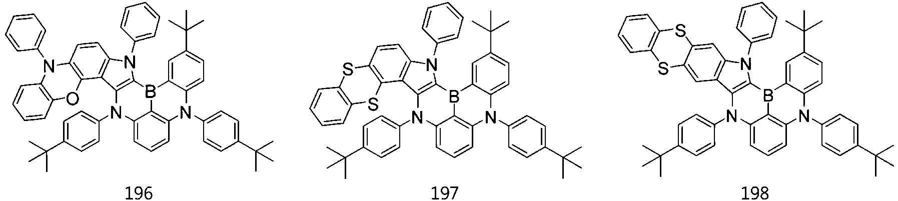

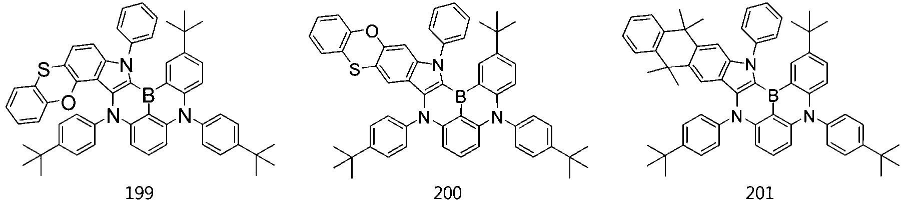

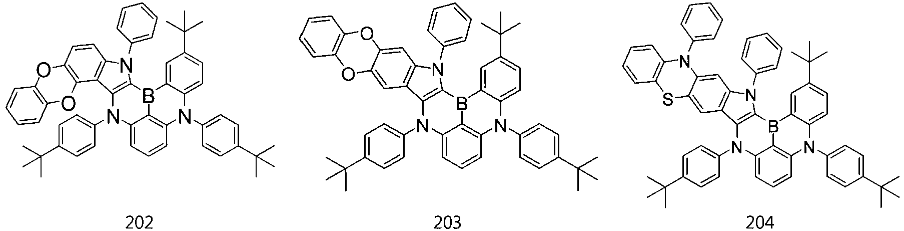

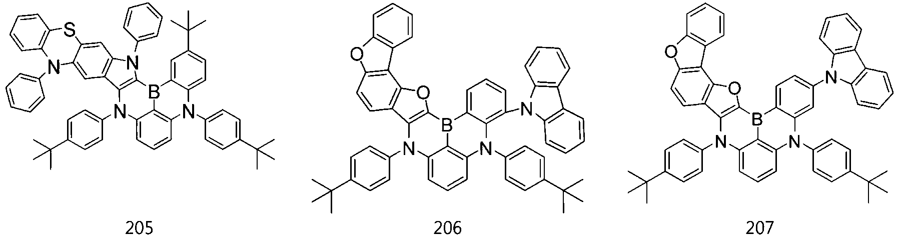

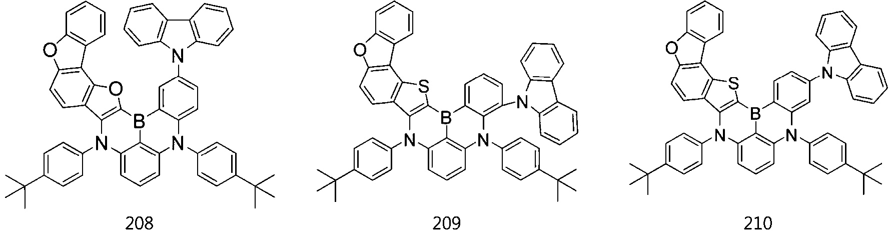

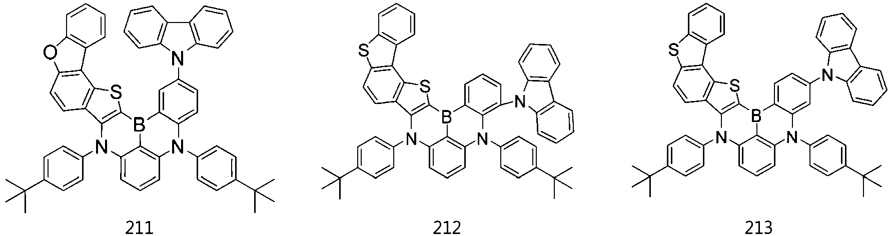

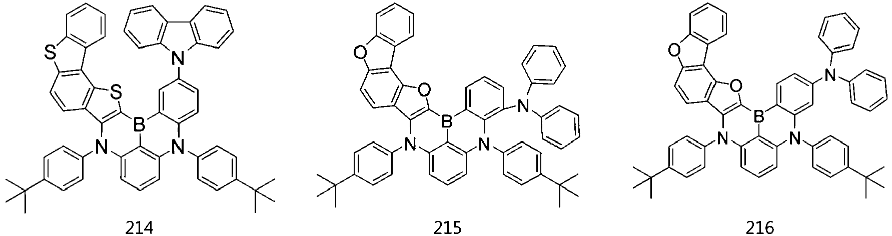

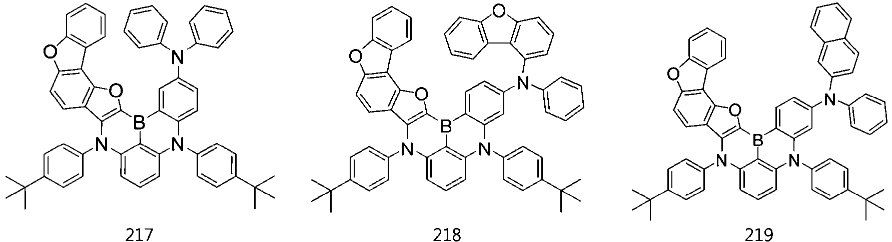

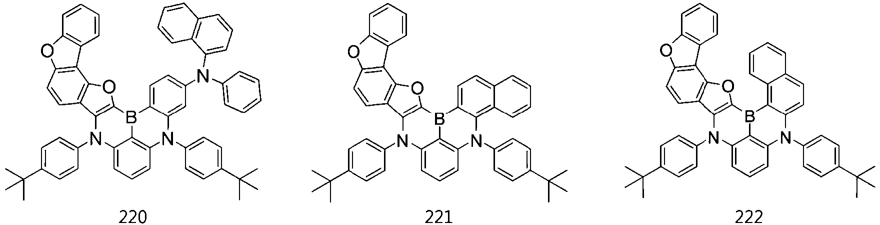

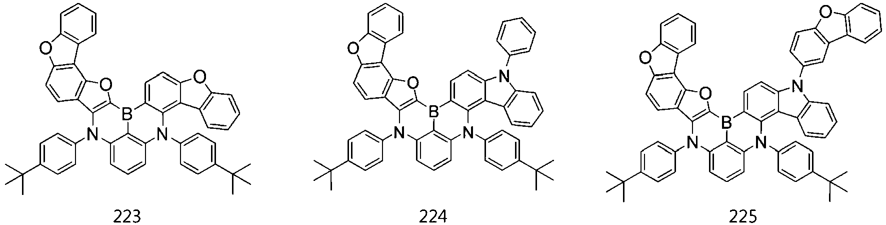

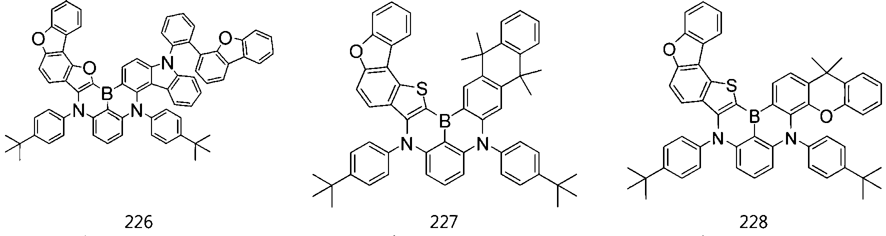

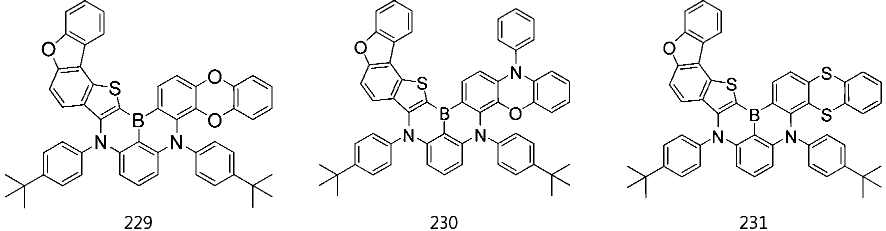

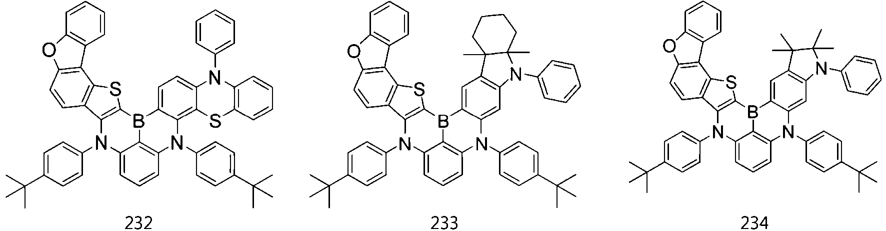

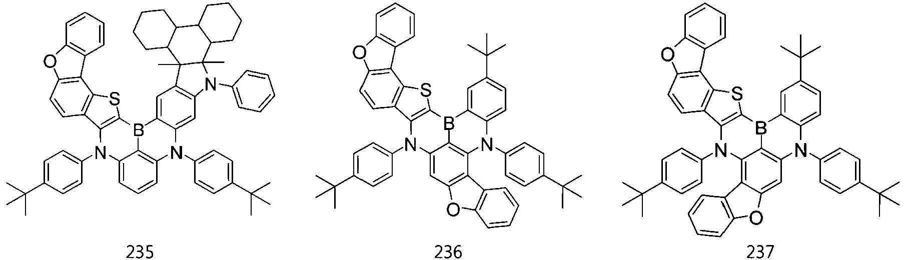

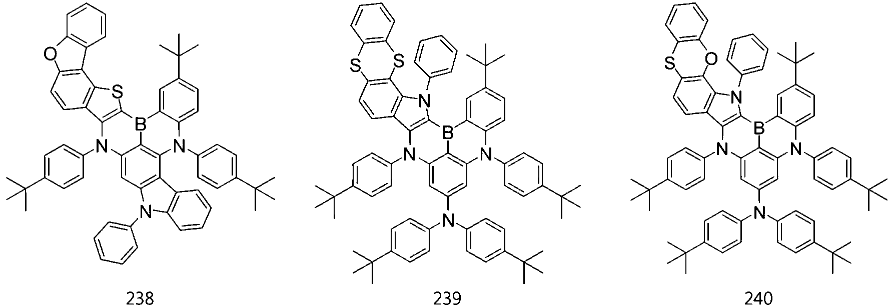

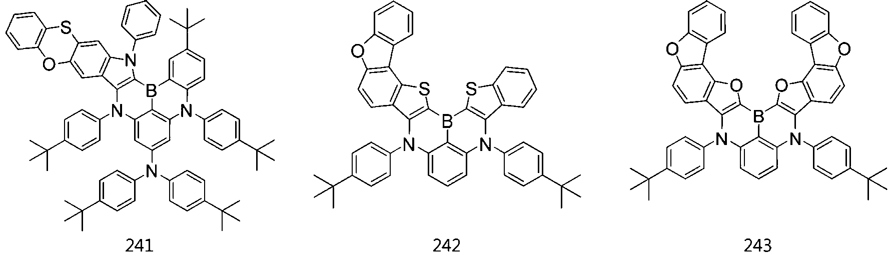

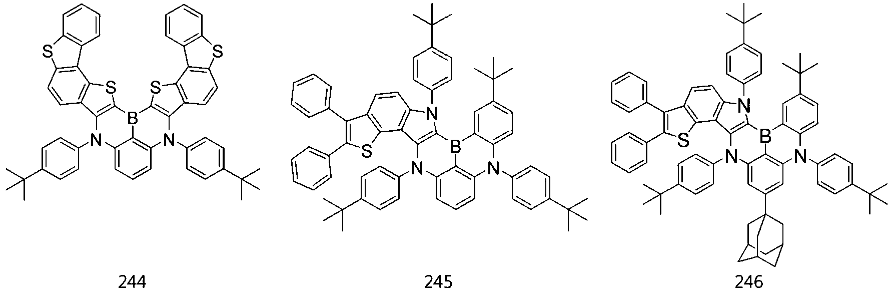

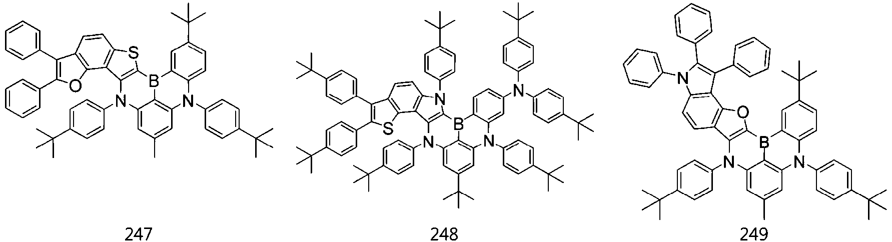

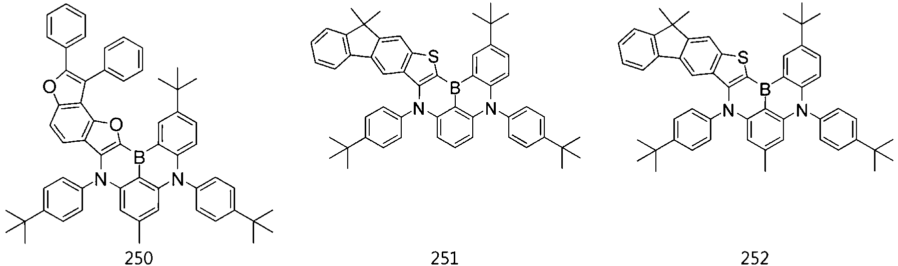

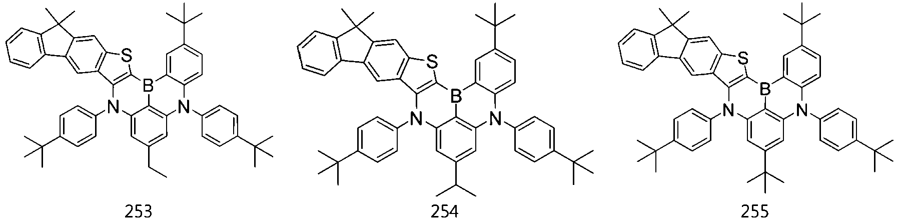

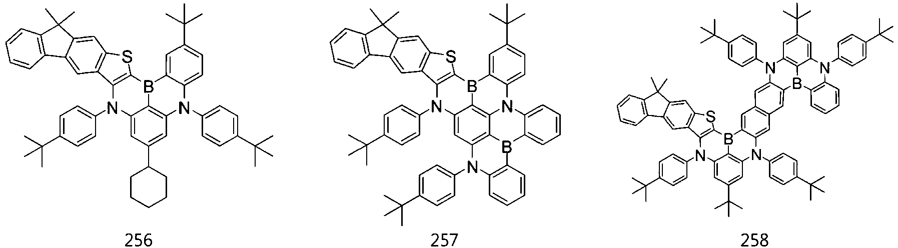

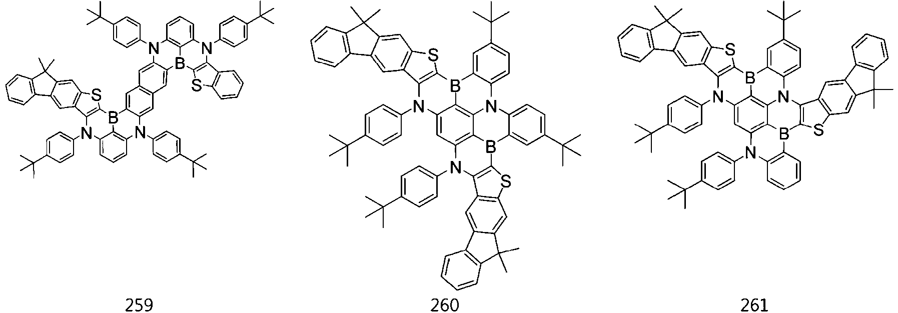

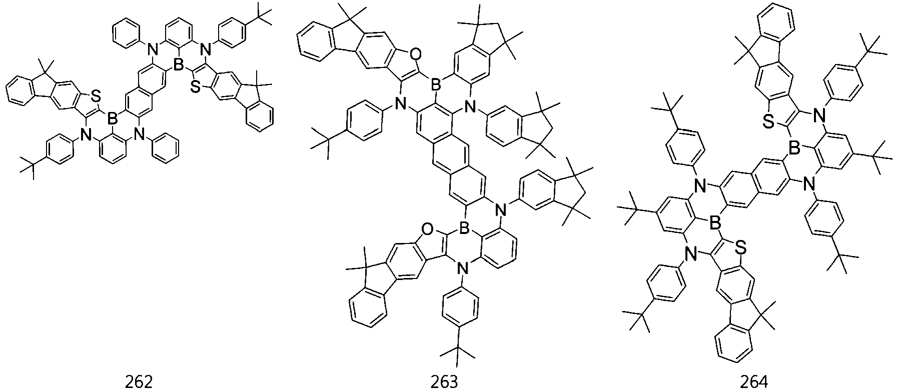

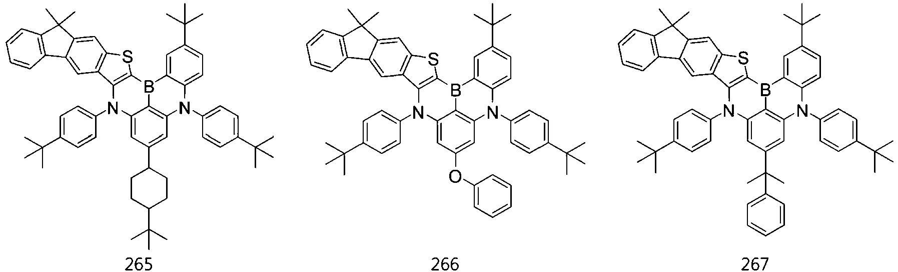

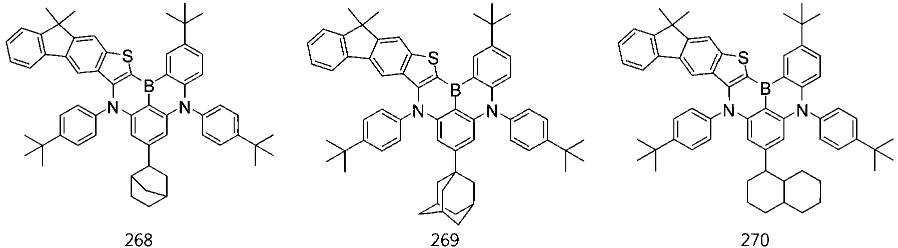

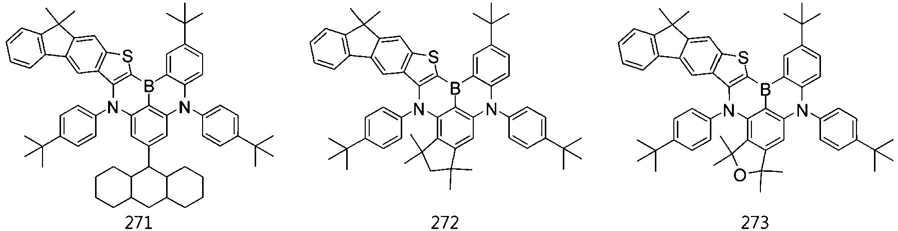

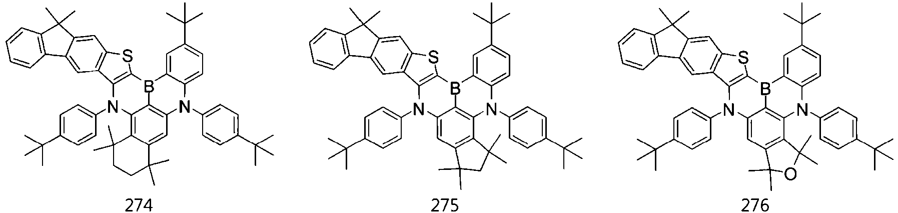

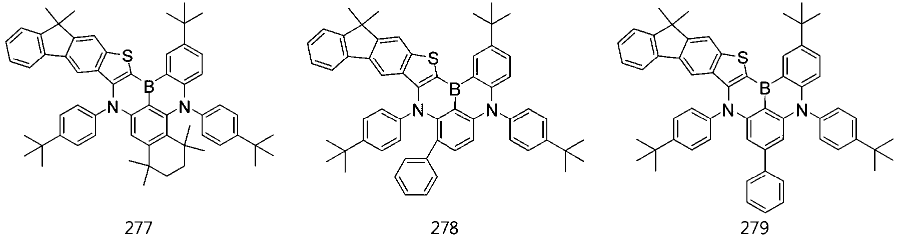

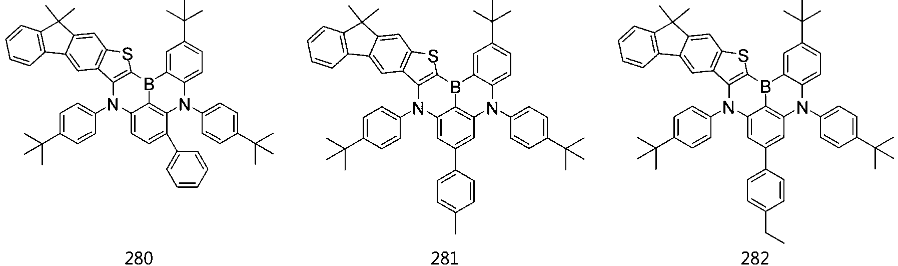

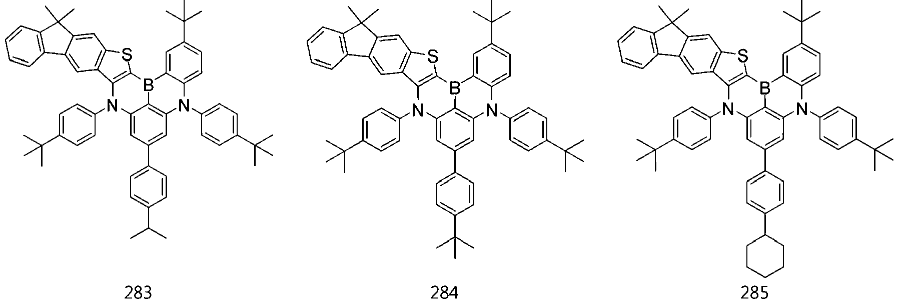

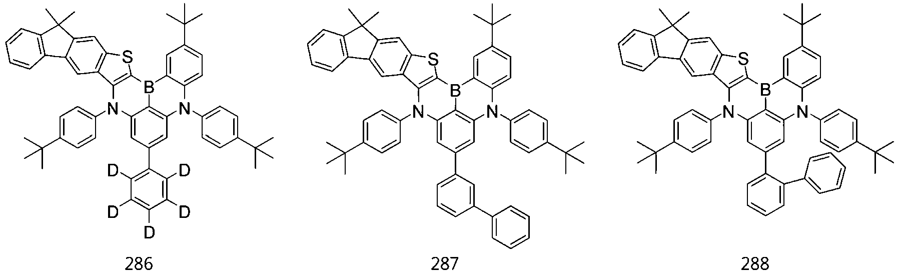

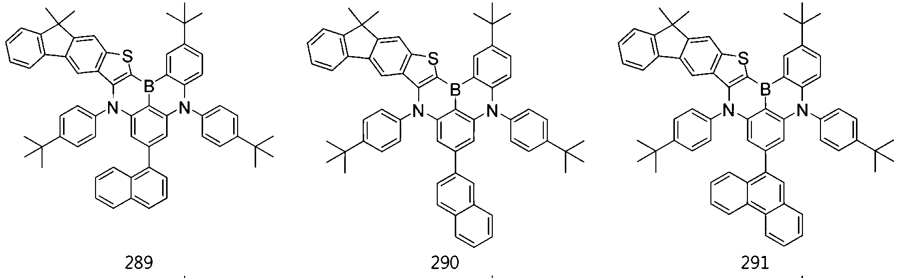

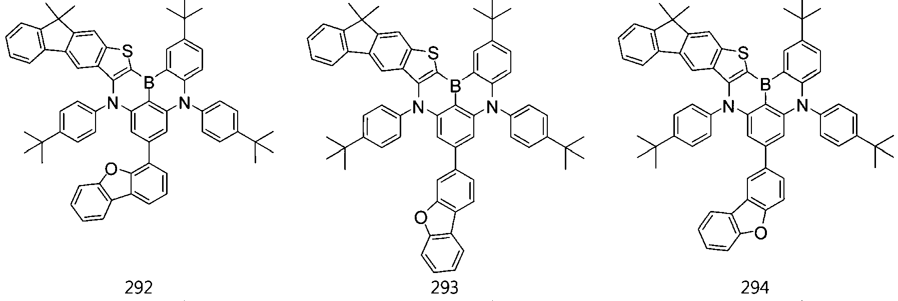

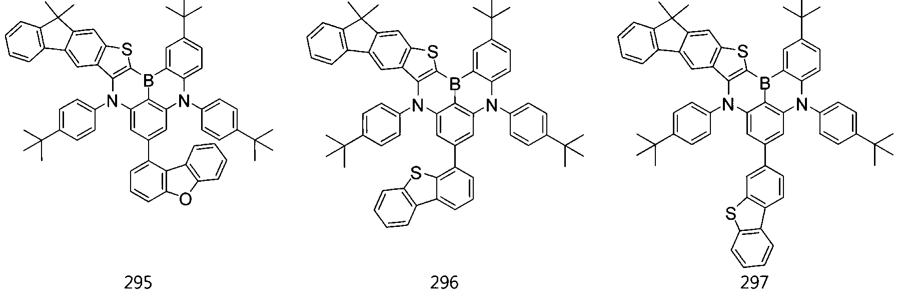

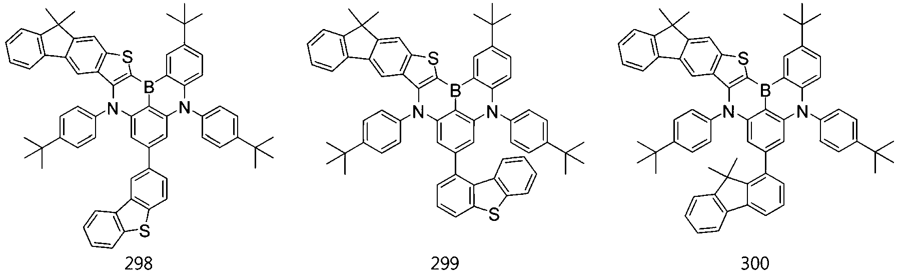

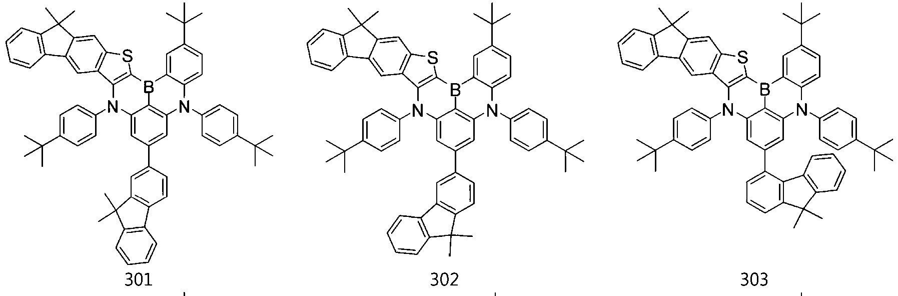

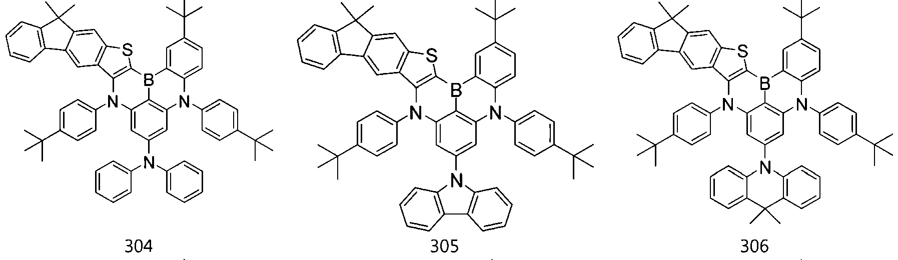

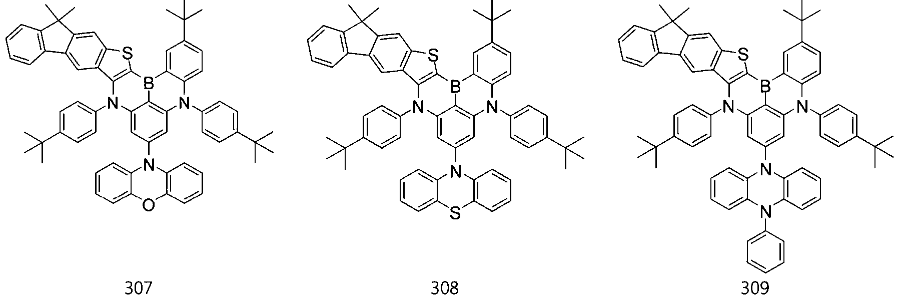

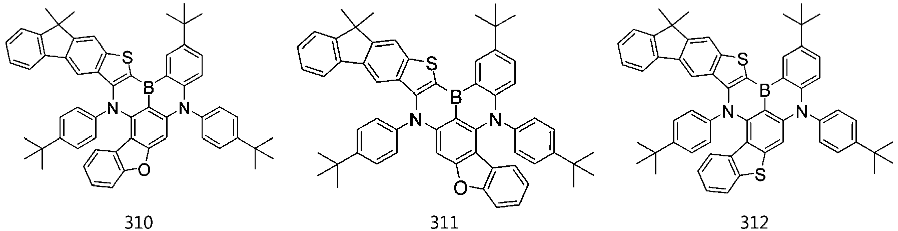

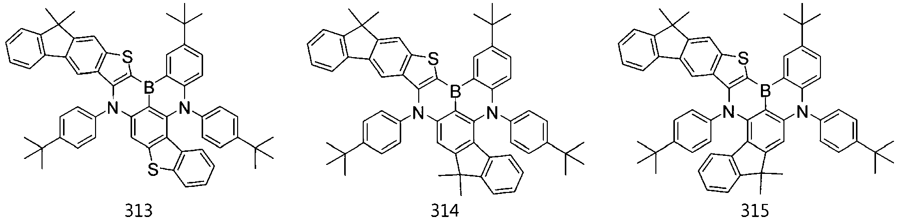

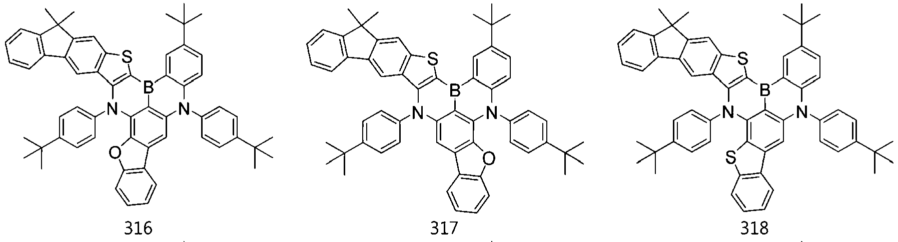

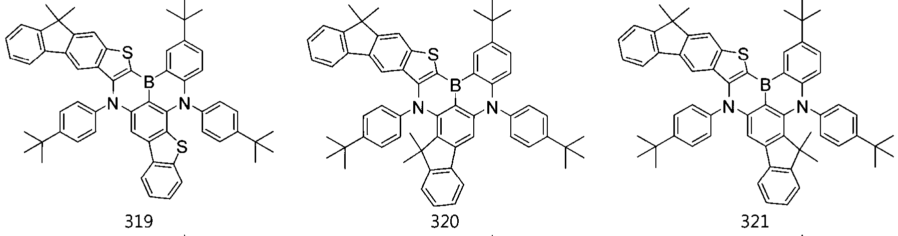

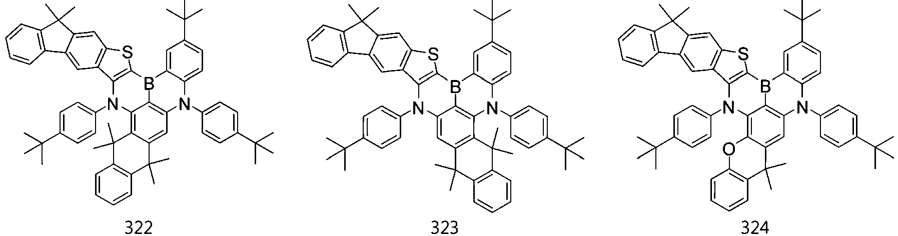

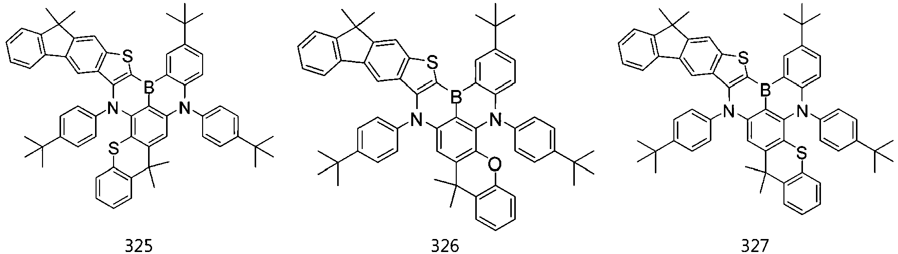

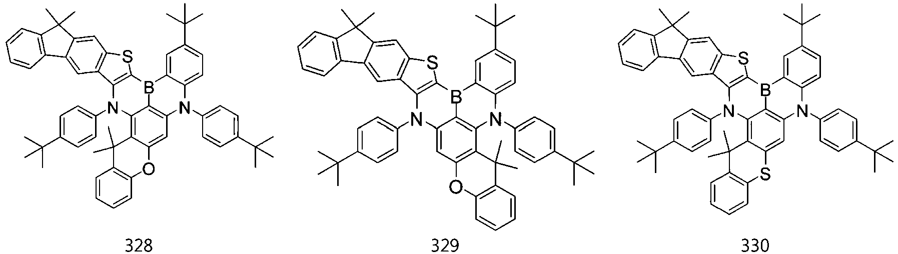

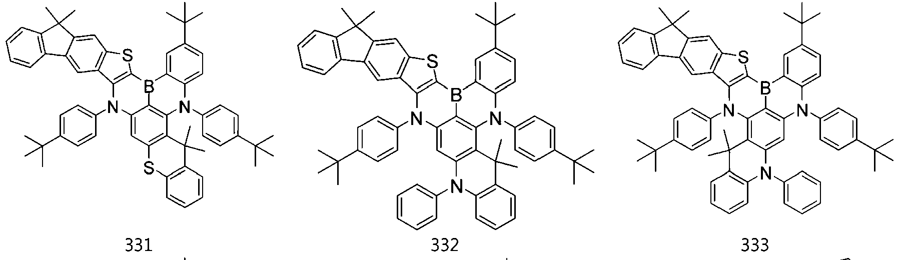

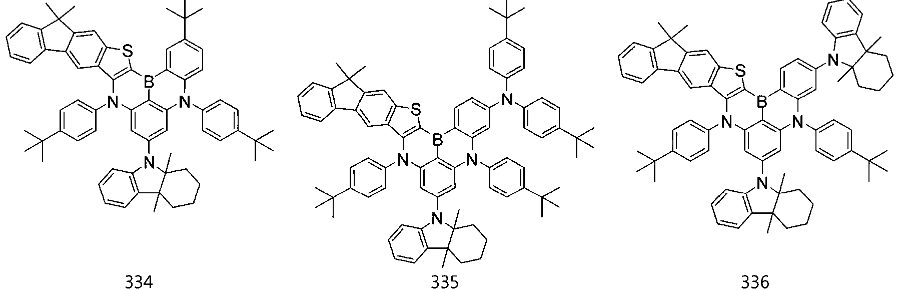

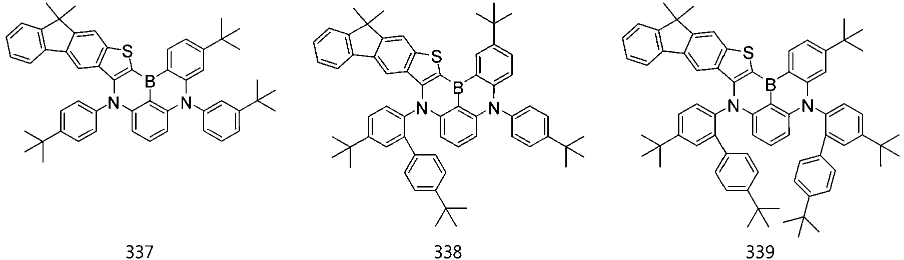

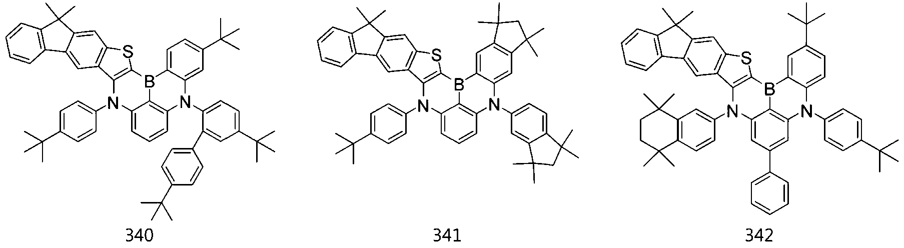

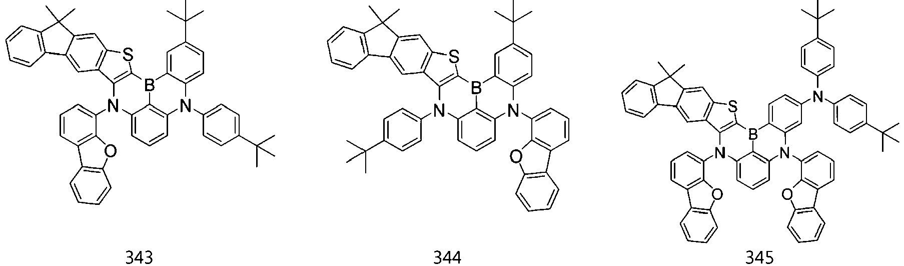

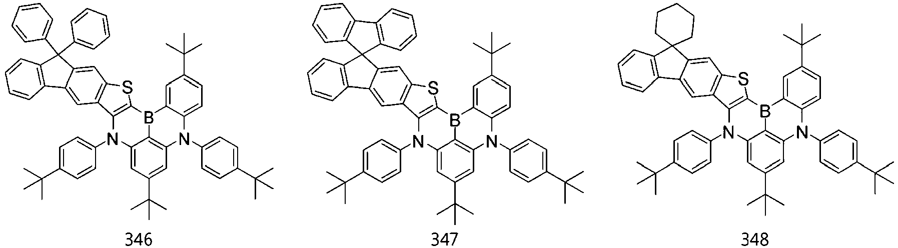

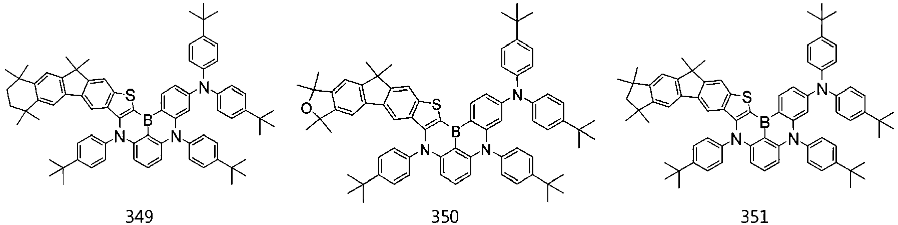

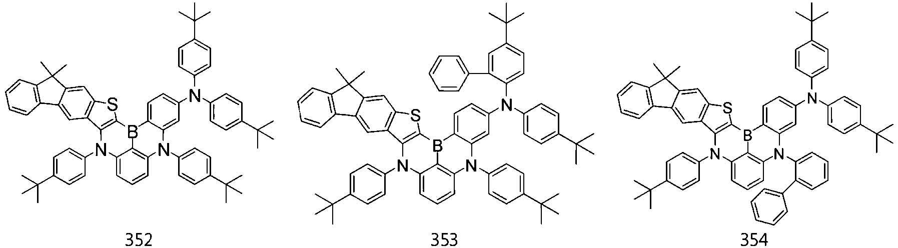

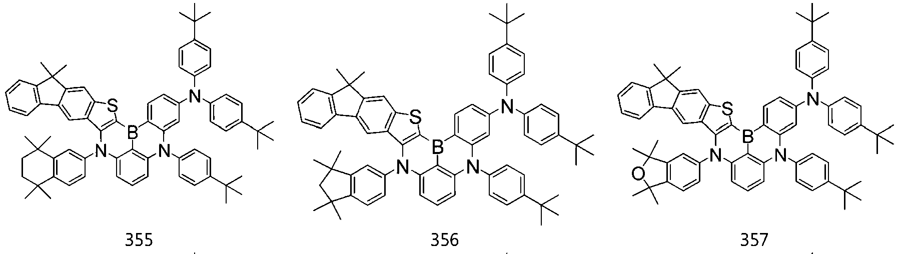

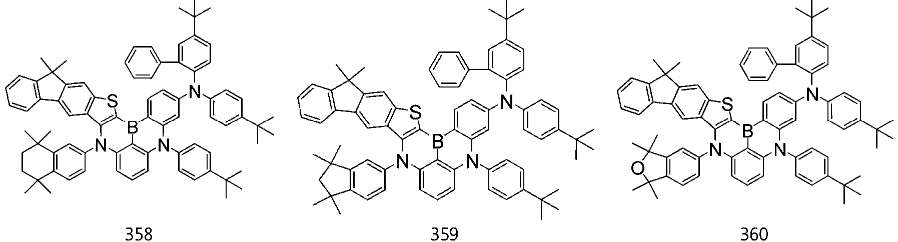

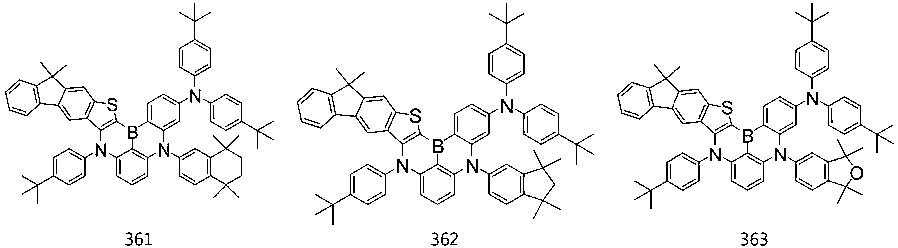

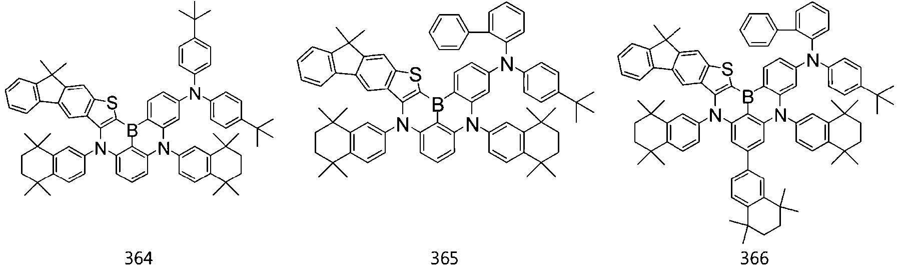

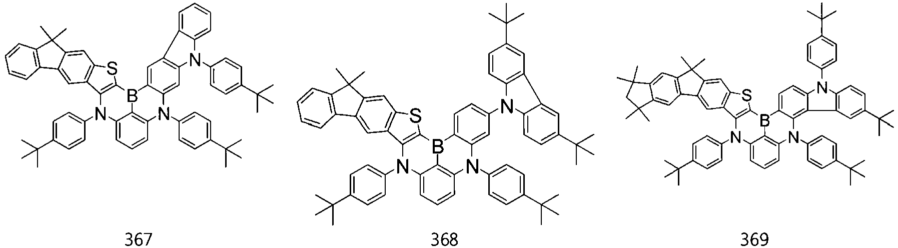

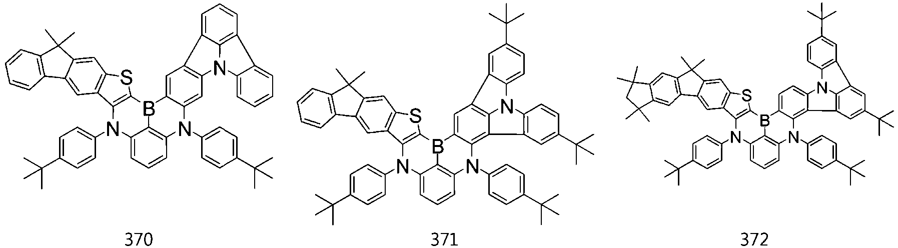

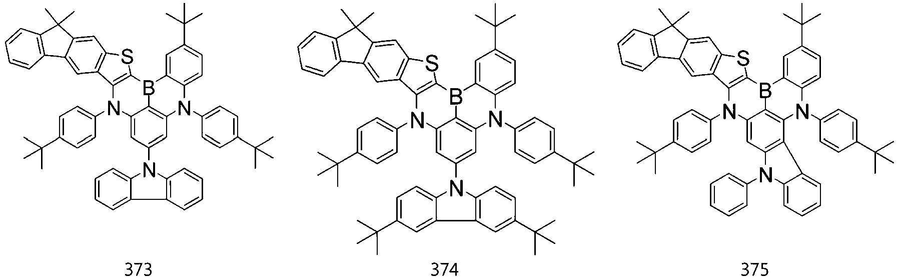

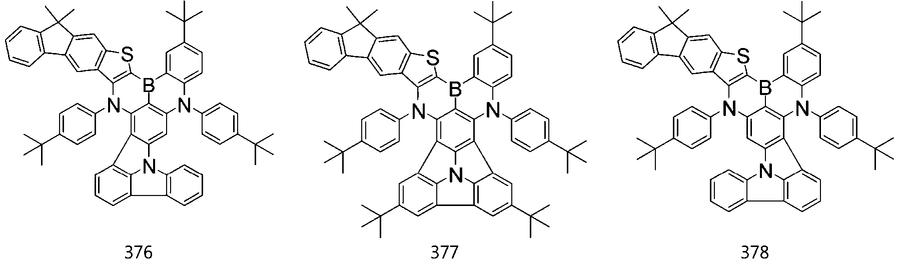

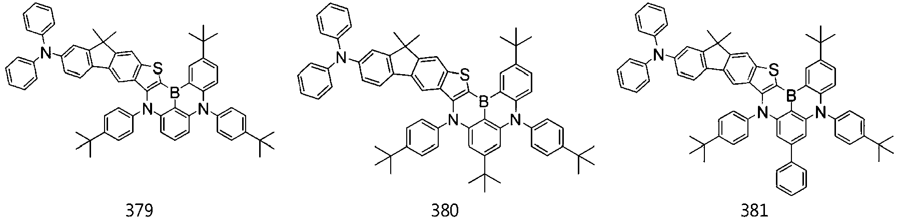

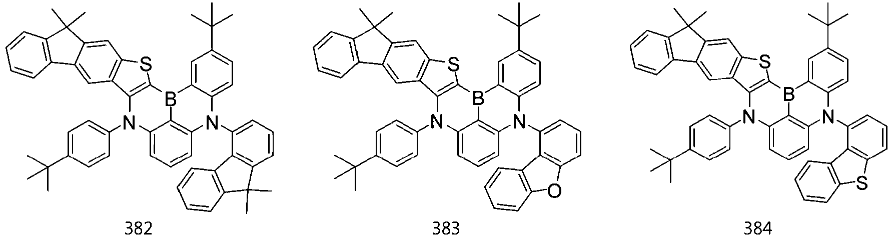

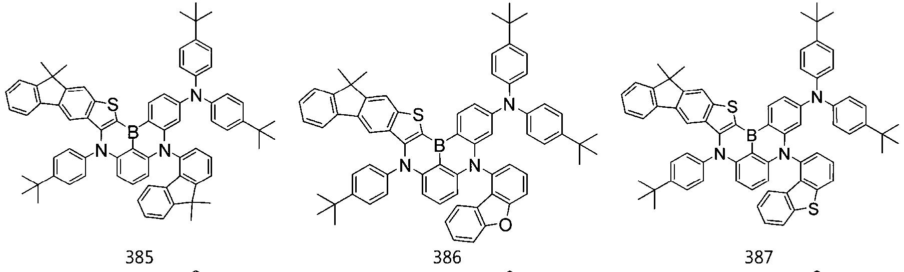

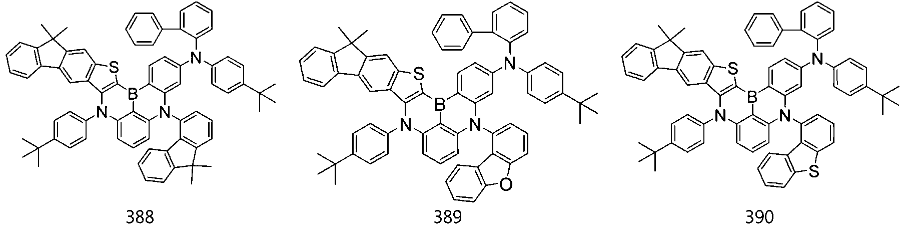

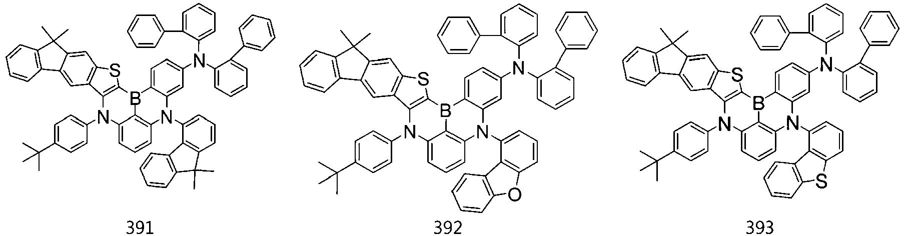

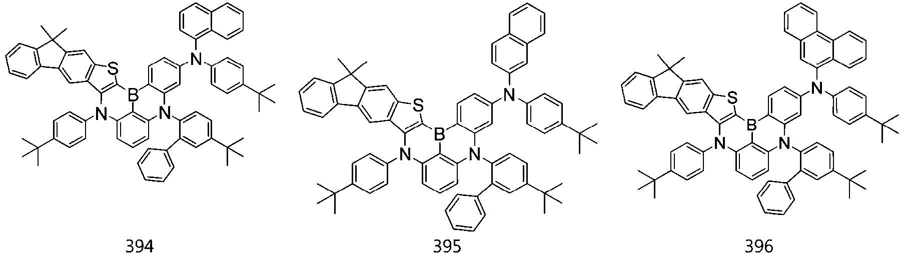

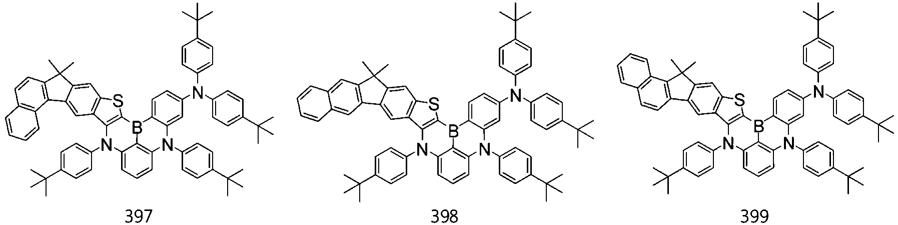

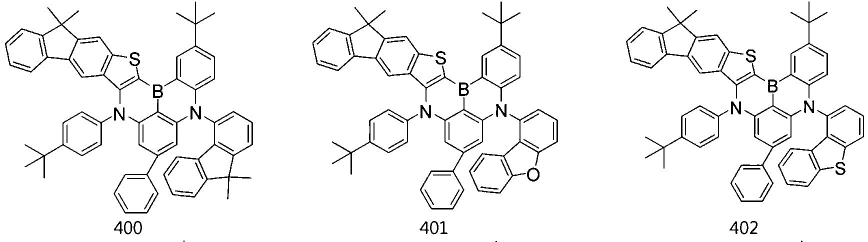

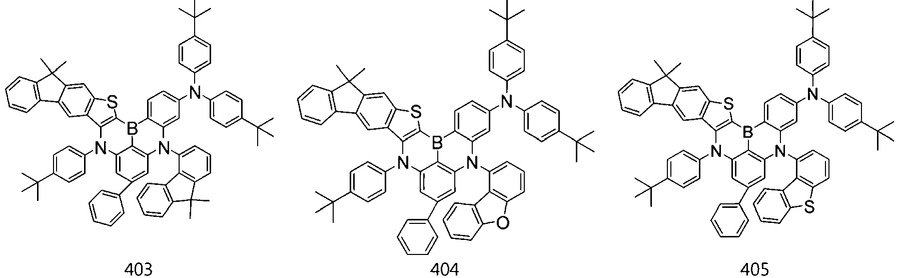

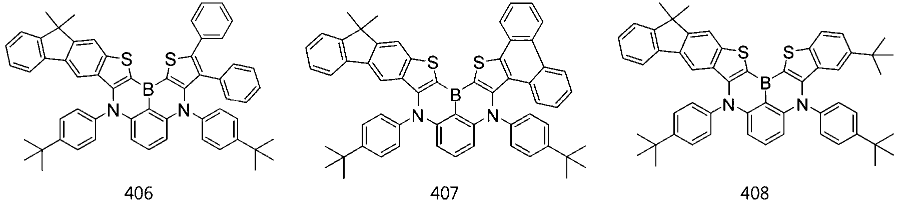

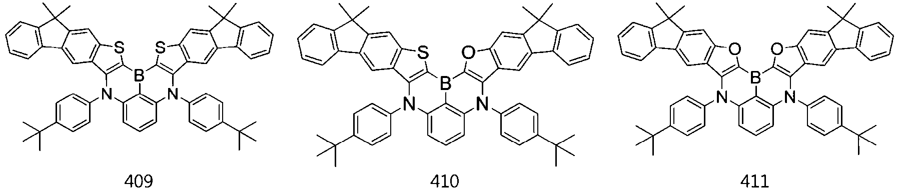

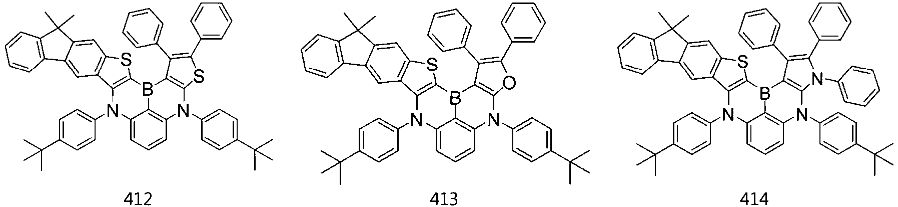

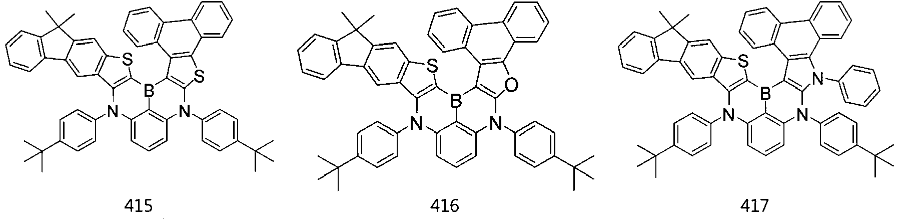

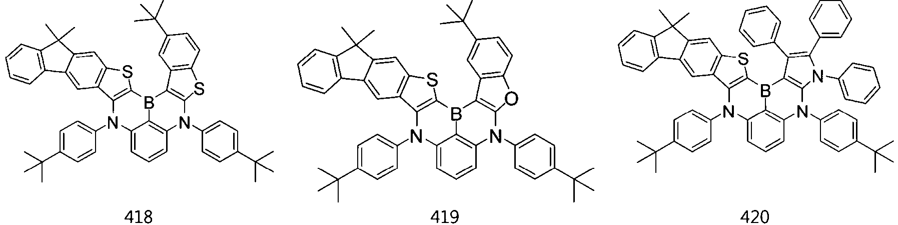

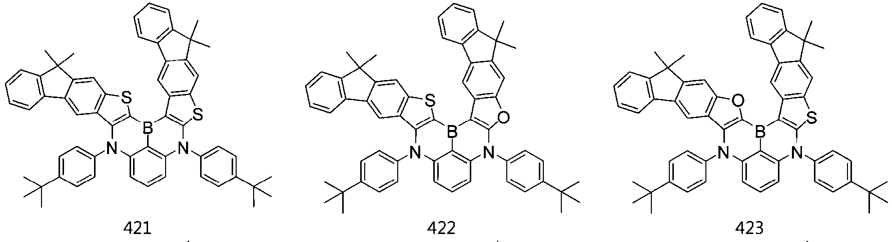

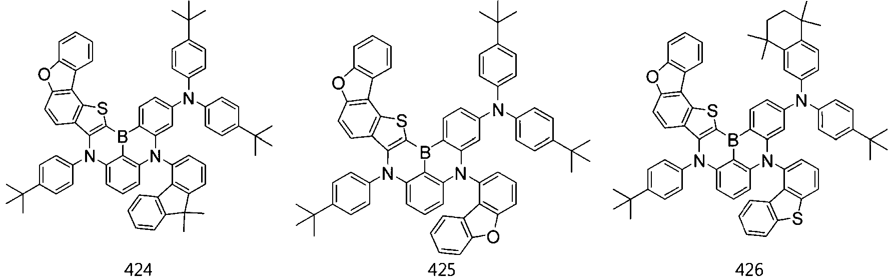

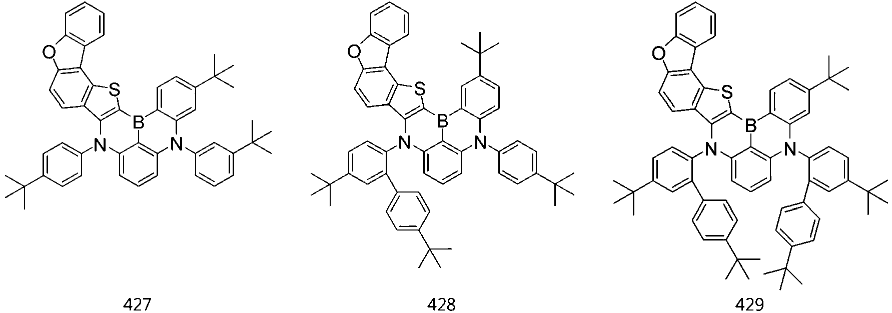

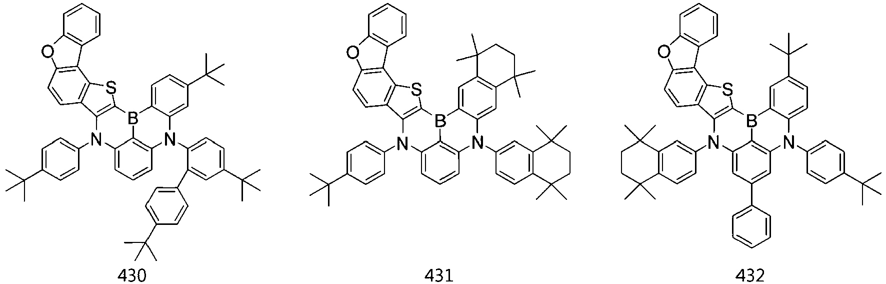

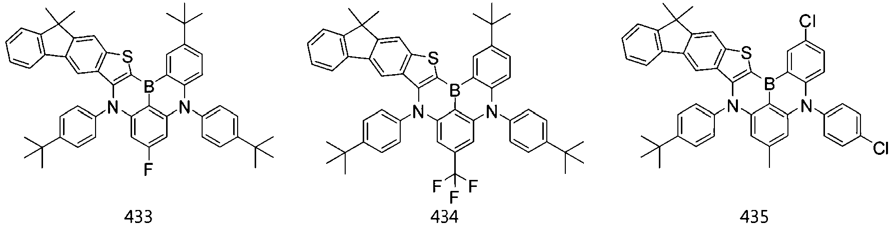

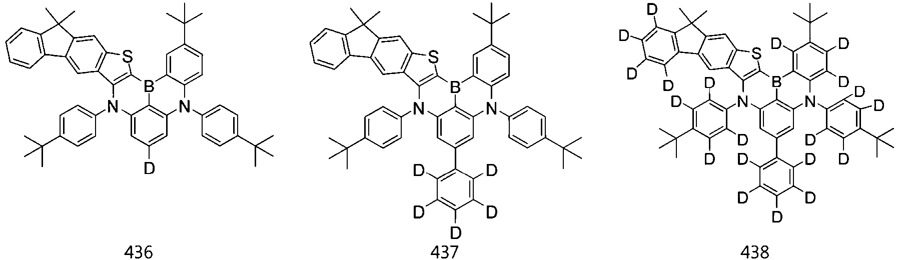

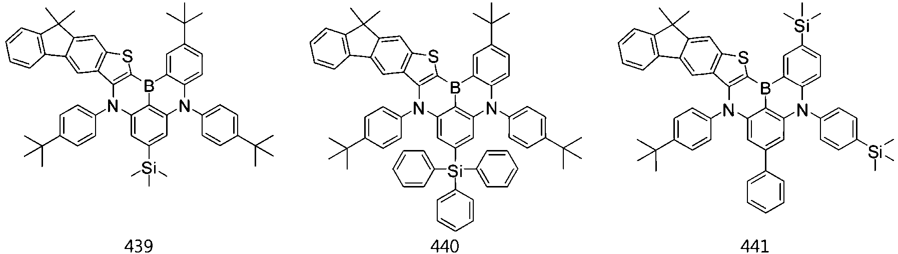

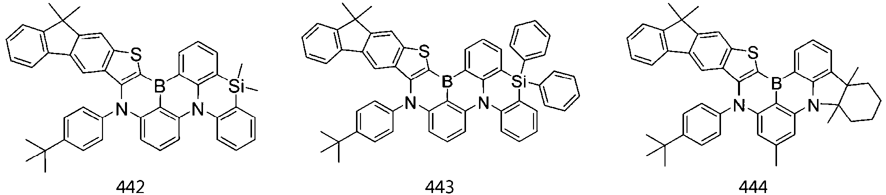

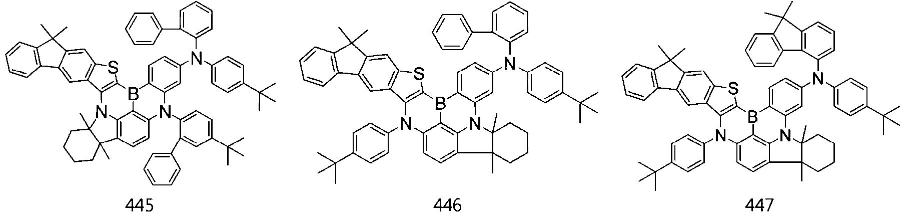

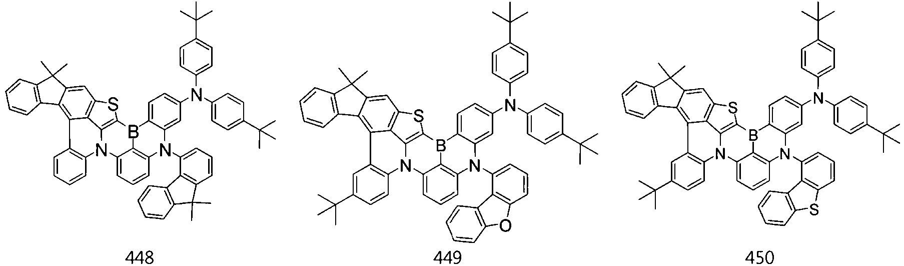

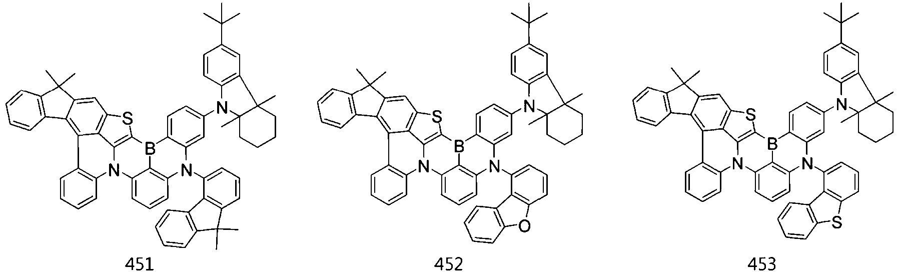

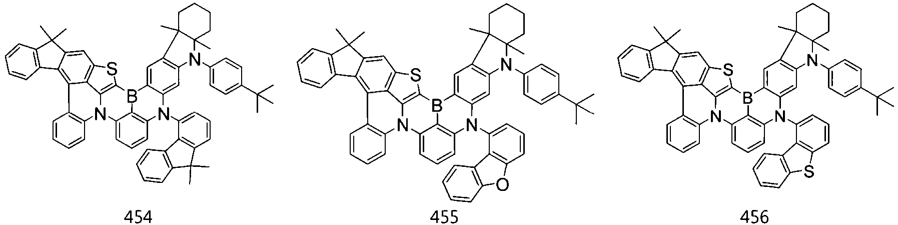

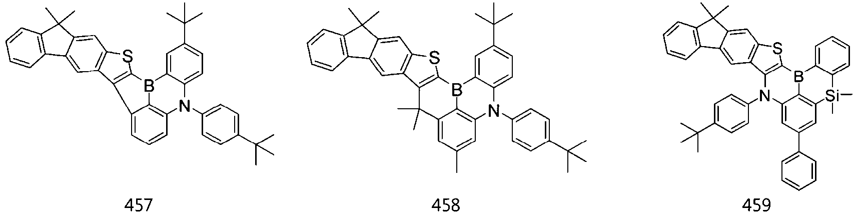

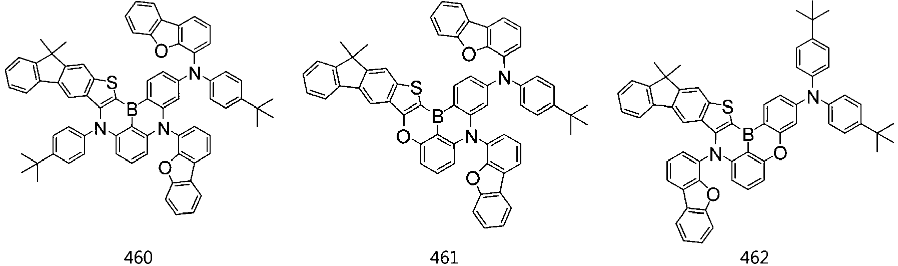

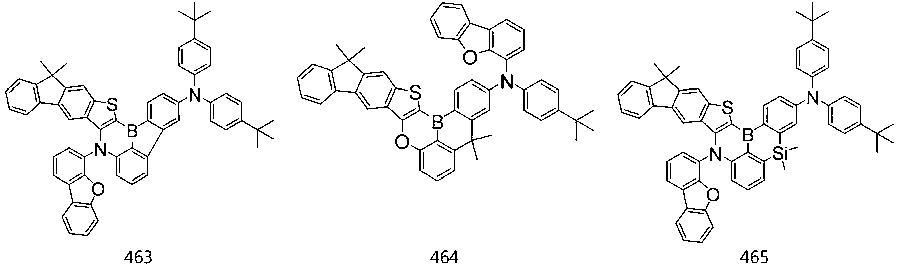

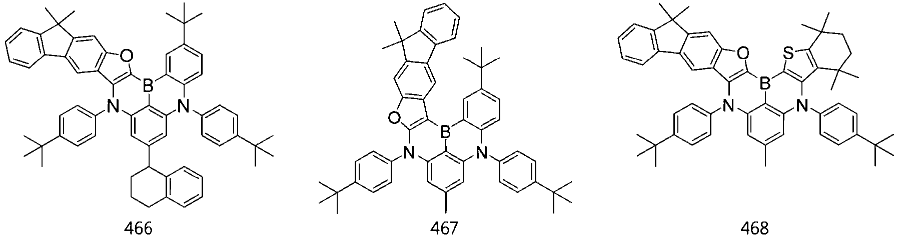

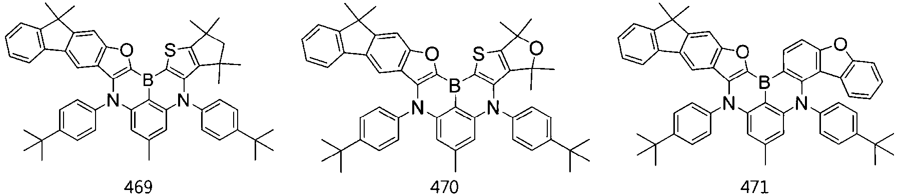

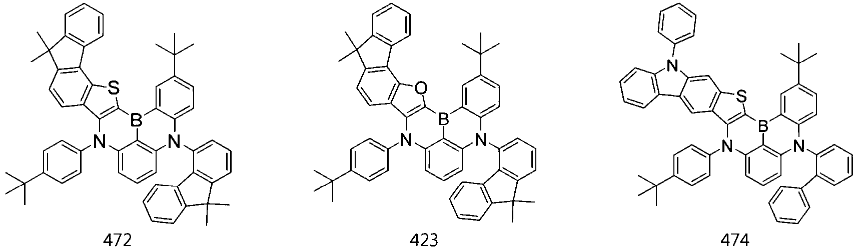

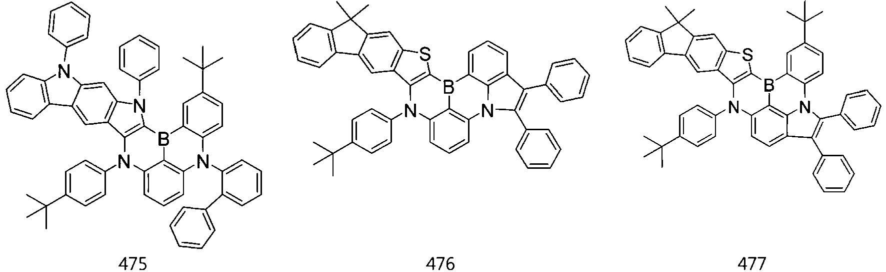

5. An organic light-emitting device comprising:
a first electrode;
a second electrode facing the first electrode; and
an organic layer interposed between the first electrode and the second electrode,
wherein the organic layer comprises at least one of the polycyclic aromatic compound or
fused multimer thereof according to claim 1.

6. The organic light-emitting device according to claim 5, wherein the organic layer comprises at least one of an electron injection layer, an electron transport layer, a hole injection layer, a hole transport layer, an electron blocking layer, a hole blocking layer, and a light-emitting layer,
wherein at least one of the layers comprises the polycyclic aromatic compound or fused multimer thereof.

7. The organic light-emitting device according to claim 6, wherein the light-emitting layer comprises an anthracene derivative represented by the following [Formula C] as a host compound: 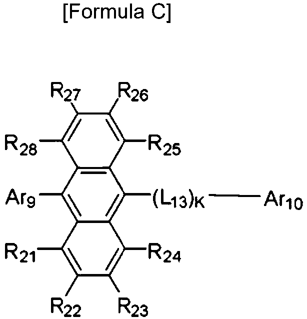 wherein
R₂₁ to R₂₈ are identical to or different from each other, and are the same as defined in R₁ of [Formula A-1] to [Formula A-3],
Ar₉ and Ar₁₀ are identical to or different from each other, and are each independently selected from hydrogen, deuterium, a substituted or unsubstituted C1-C30 alkyl group, a substituted or unsubstituted C6-C50 aryl group, a substituted or unsubstituted C2-C30 alkenyl group, a substituted or unsubstituted C2-C20 alkynyl group, a substituted or unsubstituted C3-C30 cycloalkyl group, a substituted or unsubstituted C5-C30 cycloalkenyl group, a substituted or unsubstituted C2-C50 heteroaryl group, a substituted or unsubstituted C2-C30 heterocycloalkyl group, a substituted or unsubstituted C1-C30 alkoxy group, a substituted or unsubstituted C6-C30 aryloxy group, a substituted or unsubstituted C1-C30 alkylthioxy group, a substituted or unsubstituted C6-C30 arylthioxy group, a substituted or unsubstituted C1-C30 alkylamine group, a substituted or unsubstituted C6-C30 arylamine group, a substituted or unsubstituted C1-C30 alkylsilyl group, and a substituted or unsubstituted C6-C30 arylsilyl group, and
L₁₃ is a single bond, or is selected from a substituted or unsubstituted C6-C20 arylene group, and a substituted or unsubstituted C2-C20 heteroarylene group, and
k is an integer from 1 to 3, provided that, when k is 2 or more, L₁₃'s are identical to or different from each other.

8. The organic light-emitting device according to claim 7, wherein Ar₉ of [Formula C] is a substituent represented by the following [Formula C-1]: 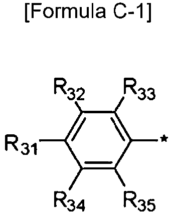 wherein
R₃₁ to R₃₅ are identical to or different from each other, are the same as defined in R₁ of [Formula A-1] or [Formula A-2] in claim 1 and are bonded to an adjacent substituent to form a saturated or unsaturated ring.

9. The organic light-emitting device according to claim 7, wherein Ar₁₀ in [Formula C] is substituted dibenzofuran.

10. The organic light-emitting device according to claim 7, wherein [Formula C] is substituted with at least one deuterium.

11. The organic light-emitting device according to claim 7, wherein 30% or more of [Formula C] is substituted with deuterium.

12. The organic light-emitting device according to claim 7, wherein [Formula C] is selected from [Formula C1] to [Formula C60]:

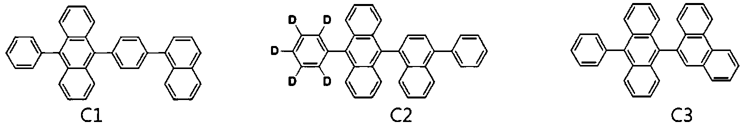

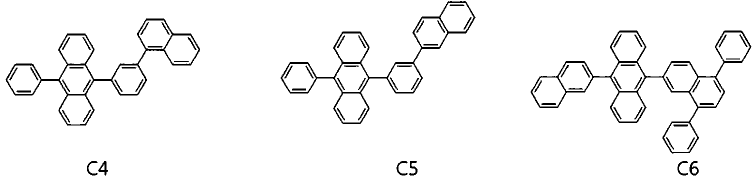

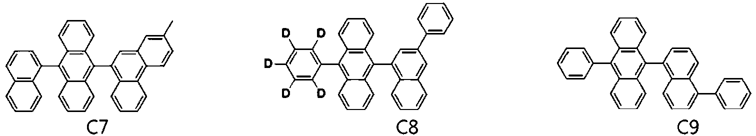

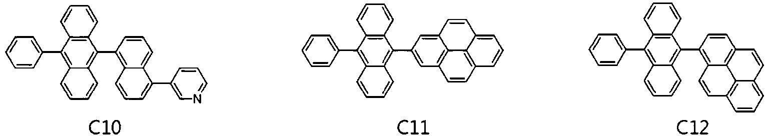

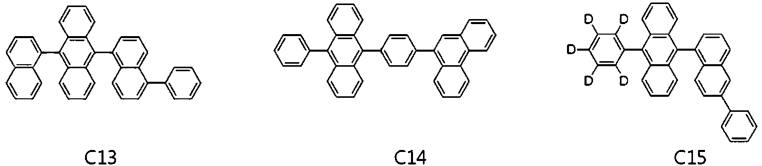

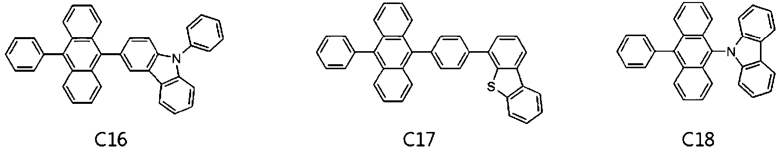

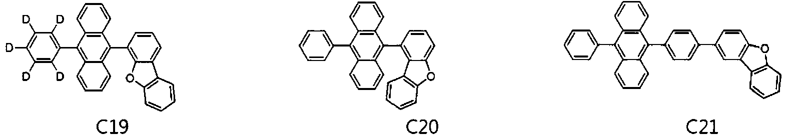

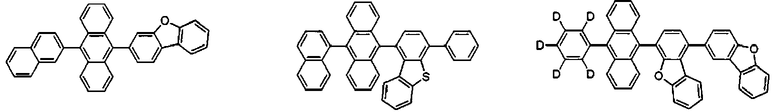

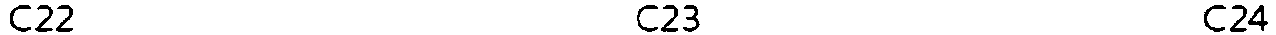

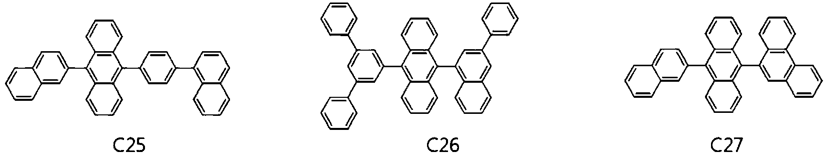

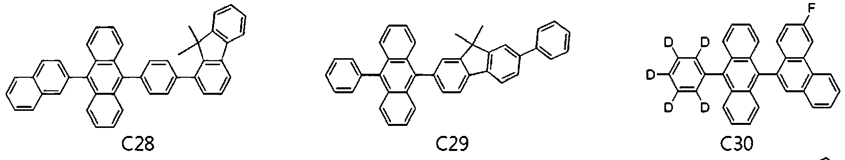

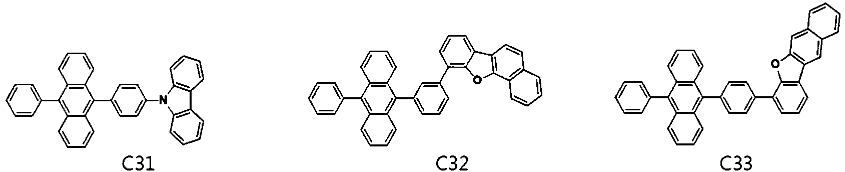

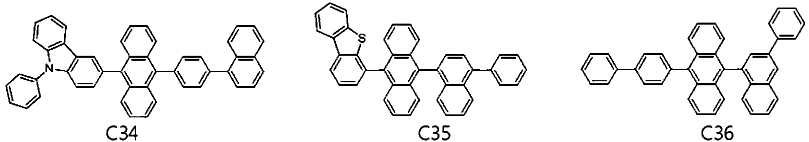

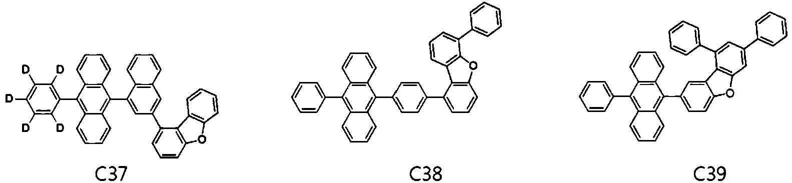

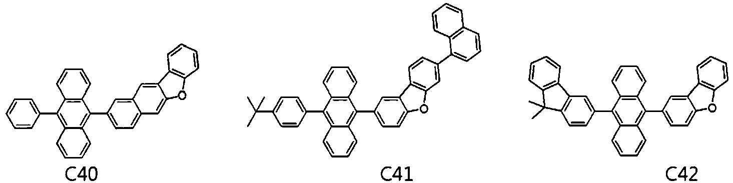

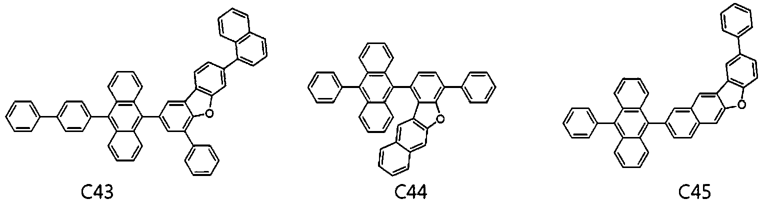

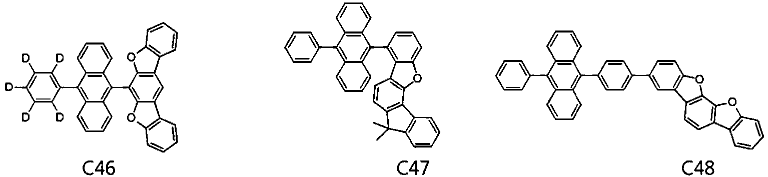

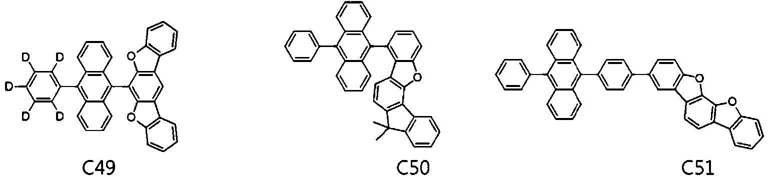

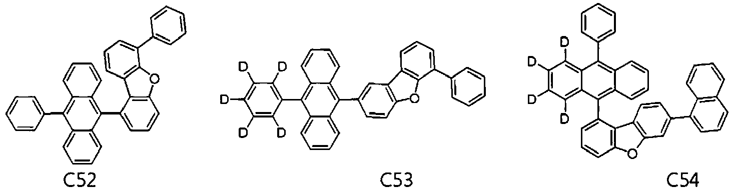

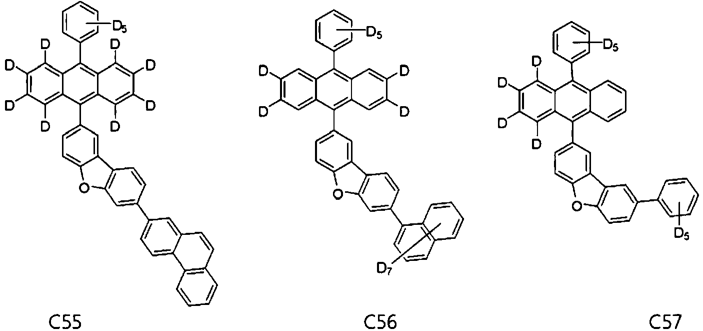

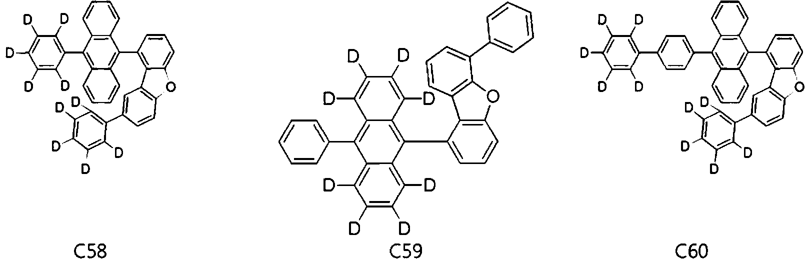

13. The organic light-emitting device according to claim 6, wherein at least one layer selected from the layers is formed by a deposition process or a solution process.

14. The organic light-emitting device according to claim 5, wherein the organic light-emitting device is used for a display or lighting system selected from flat panel displays, flexible displays, monochromatic or white flat panel lighting systems, monochromatic or white flexible lighting systems, vehicle displays, and displays for virtual or augmented reality.
